(19) Europäisches Patentamt
European Patent Office
Office européen des brevets

(11) EP 1 780 599 A1

(12) EUROPEAN PATENT APPLICATION
published in accordance with Art. 158(3) EPC

(43) Date of publication:
02.05.2007 Bulletin 2007/18

(21) Application number: 05765789.2

(22) Date of filing: 14.07.2005

(51) Int Cl.:
G03F 7/028 (2006.01) G03F 7/004 (2006.01)
G03F 7/027 (2006.01) G03F 7/029 (2006.01)
G03F 7/031 (2006.01) H01L 21/027 (2006.01)

(86) International application number:
PCT/JP2005/013048

(87) International publication number:
WO 2006/006671 (19.01.2006 Gazette 2006/03)

(84) Designated Contracting States:
AT BE BG CH CY CZ DE DK EE ES FI FR GB GR HU IE IS IT LI LT LU LV MC NL PL PT RO SE SI SK TR

(30) Priority: 14.07.2004 JP 2004207888
08.11.2004 JP 2004324385

(71) Applicant: FUJIFILM Corporation
Minato-ku
Tokyo 106-8620 (JP)

(72) Inventors:
- TASHIRO, Tomoko, c/o Fujifilm Corp
Fujinomiya-shi, Shizuoka 4188666 (JP)
- SATO, Morimasa, c/oFuji film Corp.
Fujinomiya-shi, Shizuoka 4188666 (JP)
- SASAKI, Yoshiharu, c/o Fujifilm Corp.
Fujinomiya-shi, Shizuoka 4188666 (JP)
- WAKATA, Yuichi, c/o Fujifilm Corp.
Haibara-gun, Shizuoka 421-0396 (JP)
- TAKAYANAGI, Takashi, c/o Fujifilm Corp.
Fujinomiya-shi,Shizuoka 4188666 (JP)

(74) Representative: HOFFMANN EITLE
Patent- und Rechtsanwälte
Arabellastrasse 4
81925 München (DE)

# (54) PHOTOSENSITIVE COMPOSITION, PATTERN FORMING MATERIAL, PHOTOSENSITIVE LAMINATE, PATTERN FORMING APPARATUS AND METHOD OF PATTERN FORMATION

(57) A photosensitive composition having an extremely constant photosensitivity distribution relative to an exposure light having a wavelength of 400 nm to 410 nm, and excelling in pattern reproductivity, suppressing variations in pattern formation; a pattern forming material and a photosensitive laminate with the photosensitive composition laminated thereon; and a pattern forming apparatus and a pattern forming process.

The photosensitive composition contains a binder, a polymerizable compound, and a photopolymerization initiator; the photosensitive composition has a maximum spectral sensitivity in the wavelength range of 380 nm to 420 nm; the minimum exposure_dose $S_{400}$ capable of forming a pattern at a wavelength of 400 nm of the photosensitive composition is 300 mJ/cm$^2$ or less; the minimum exposure dose $S_{410}$ capable of forming a pattern at a wavelength of 410 nm of the photosensitive composition is 300 mJ/cm$^2$ or less; and $S_{400}$ and $S_{410}$ satisfy the relation $0.6 < S_{400}/S_{410} < 1.6$.

FIG. 1

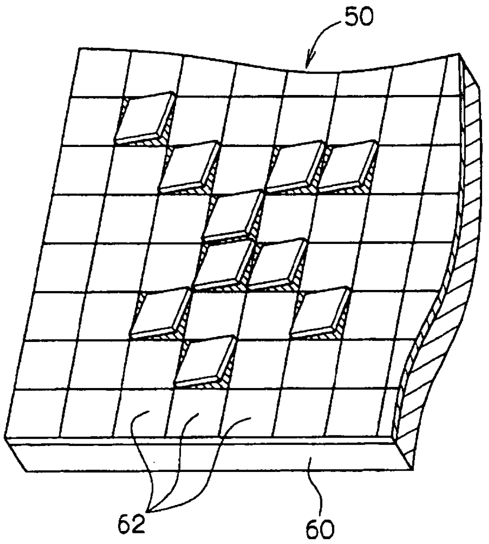


EP 1 780 599 A1

## Description

### Technical Field

The present invention relates to a photosensitive composition preferably used for dry film resist (DFR), solder resist, liquid solder resist, and the like which are capable of forming images by means of UV exposure. In particular, the present invention relates to a pattern forming material and a photosensitive laminate using the photosensitive composition, a pattern forming apparatus provided with the pattern forming material and the photosensitive laminate, a pattern forming process using the pattern forming material and the photosensitive laminate as well as interconnection patterns and permanent patterns such as protective layers, interlayer insulating films, and solder resist patterns.

### Background Art

When producing a printed wiring board, first, a dry film resist (DFR) is used for a copper clad laminate to form a copper interconnection pattern. Further, various parts such as semiconductors, capacitors, and resistors are soldered on the printed wiring board. Generally, permanent patterns corresponding to non-soldered portions are formed in a protective film or an insulating film in order to prevent solder adhesion to unnecessary portions for soldering in soldering processes such as IR reflow. For the permanent patterns of the protective film, pattern forming materials such as solder resists are used. Besides, pattern forming materials such as dry film resists are also used in which no protective layer is left after forming a pattern of a printed wiring board.

Conventionally, such a pattern forming material has been exposed using a mask, however, in recent years, there has been vigorous studies on mask-less exposing units using a laser light through digital micromirror device (DMD).

As developments of lasers which can stably oscillate in the region of short-wavelengths (blue-violet light) expands, the lasers started to be utilized as exposure light sources, however, the power output and the uniformity of the wavelengths are far from satisfactory. In addition, photosensitive materials having high-sensitivity in the above-noted wavelength region are required. However, photosensitive materials which are exposed to visible lights needs to be handled under red light. To solve the problem, a photosensitive image forming material for ultraviolet laser light is proposed, which has a maximum spectral sensitivity in the wavelength region of 350 nm to 385 nm and can be handled under a yellow light (for example, see Patent Literature 1).

In the meanwhile, in an exposing unit in which a plurality of exposure heads are arrayed to expose a photosensitive material, when there are variations in wavelength of an irradiation light attributable to variations of a semiconductor device serving as an irradiation light source, the uniformity of the formed pattern is impaired because the exposed photosensitive material reacts differently and with different sensitivities depending on the spectral sensitivity for every different regions in the photosensitive material which are exposed with different exposure wavelengths.

However, the above-noted proposal does not allow for difference in spectral sensitivity relative to a certain wavelength region centering on the wavelength of an exposure light, and does not disclose a solution to the difference in wavelength depending on an exposure light source, by means of the spectral sensitivity of the photosensitive material. Further, the proposal has a problem that a sufficient sensitivity is not assured when a solid laser having a wavelength of 405 nm, which has been widely used in recent years, is used as an exposure light source.

Accordingly, a pattern forming material which has an extremely constant photosensitivity distribution relative to an exposure light having a wavelength in the region of short-wavelengths (blue-violet light), in particular, having a wavelength of 400 nm to 410 nm and allows for easy handling under bright room environments without being affected by variations in exposure wavelength during exposure with a laser beam has not been provided yet so far. A pattern forming apparatus provided with the pattern forming material and a pattern forming process using the pattern forming material have not also been provided yet, and further improvements and developments are desired in this filed.

Patent Literature 1 Japanese Patent Application Laid-Open (JP-A) No. 2001-194782

### Disclosure of the Invention

The present invention aims to provide a photosensitive composition which has an extremely constant photosensitivity distribution relative to an exposure light having a wavelength in the region of short-wavelengths (blue-violet light), in particular, having a wavelength of 400 nm to 410 nm, is excellent in pattern reproductivity without being affected by variations in exposure wavelength during exposure with a laser beam, and allows substantially preventing variations in form of patterns as well as allows for easy handling under bright room environments. The present invention also aims to provide a pattern forming material and a photosensitive laminate each of which the photosensitive composition is formed in a laminate structure, a pattern forming apparatus, a pattern forming process, and highly fine and precise interconnection patterns and permanent patterns such as protective insulating films, and solder resist patterns.

The means for achieving the objects are as follows:

< 1 > A photosensitive composition containing a binder, a polymerizable compound, and a photopolymerization initiator, wherein the photosensitive composition has a maximum spectral sensitivity in the wavelength range of 380 nm to 420 nm; the minimum exposure dose $S_{400}$ capable of forming a pattern at a wavelength of 400 nm of the photosensitive composition is 300 mJ/$cm^2$ or less; the minimum exposure dose $S_{410}$ capable of forming a pattern at a wavelength of 410 nm of the photosensitive composition is 300 mJ/$cm^2$ or less; and $S_{400}$ and $S_{410}$ satisfy the relation $0.6 < S_{400}/S_{410} < 1.6$.

In the photosensitive composition according to the item < 1 >, the photosensitivity distribution is substantially constant at a wavelength of 400 nm to 410 nm. As the result, in the wavelength range of 400 nm to 410 nm, variations in line width of the developed pattern are extremely suppressed without being affected by variations in exposure wavelength during exposure with a laser beam.

< 2 > The photosensitive composition according to the item < 1 >, wherein the minimum exposure dose $S_{405}$ capable of forming a pattern at a wavelength of 405nm of the photosensitive composition is 300 mJ/$cm^2$ or less.

< 3 > The photosensitive composition according to any one of the items < 1 > to < 2 >, further containing a photosensitizer, wherein the minimum exposure dose $S_{400}$ capable of forming a pattern at a wavelength of 400 nm of the photosensitive composition is 200 mJ/$cm^2$ or less; the minimum exposure dose $S_{410}$ capable of forming a pattern at a wavelength of 410 nm of the photosensitive composition is 200 mJ/$cm^2$ or less; and $S_{400}$ and $S_{410}$ satisfy the relation $0.6 < S_{400}/S_{410} < 1.4$.

< 4 > The photosensitive composition according to any one of the items < 1 > to < 3 >, wherein the photosensitizer has a maximum absorption wavelength of 380 nm to 420 nm.

< 5 > The photosensitive composition according to any one of the items < 1 > to < 4 >, wherein the photosensitizer is a fused-ring compound.

< 6 > The photosensitive composition according to any one of the items < 1 > to < 5 >, wherein the photosensitizer is at least one selected from the group consisting of acridones, acridines, and coumarins.

< 7 > The photosensitive composition according to any one of the items < 1 > to < 6 >, wherein the content of the photosensitizer is 0.1% by mass to 10% by mass relative to the total amount of the photosensitive composition.

< 8 > The photosensitive composition according to any one of the items < 1 > to < 7 >, wherein the binder contains an acidic group.

< 9 > The photosensitive composition according to any one of the items < 1 > to < 8 >, wherein the binder contains a vinyl copolymer.

< 10 > The photosensitive composition according to any one of the items < 1 > to < 9 >, wherein the binder contains at least any one of styrene and a styrene derivative.

< 11 > The photosensitive composition according to any one of the items < 1 > to < 10 >, wherein the binder has an acid value of 70 mgKOH/ g to 250 mgKOH/ g.

< 12 > The photosensitive composition according to any one of the items < 1 > to < 11 >, wherein the polymerizable compound contains a monomer having at least any one of a urethane group and an aryl group.

< 13 > The photosensitive composition according to any one of the items < 1 > to < 12 >, wherein the polymerizable compound has a bisphenol skeleton.

< 14 > The photosensitive composition according to any one of the items < 1 > to < 13 >, wherein the photopolymerization initiator contains at least one selected from the group consisting of halogenated hydrocarbon derivatives, hexaaryl-biimidazoles, oxime derivatives, organic peroxides, thio compounds, ketone compounds, aromatic onium salts, and metallocenes.

< 15 > The photosensitive composition according to any one of the items < 1 > to < 14 >, wherein the photopolymerization initiator contains a 2,4,5-triarylimidazole dimer derivative.

< 16 > The photosensitive composition according to any one of the items < 1 > to < 15 >, further containing a polymerization inhibitor.

< 17 > The photosensitive composition according to the item < 16 >, wherein the polymerization inhibitor contains at least one selected from the group consisting of aromatic rings, heterocyclic rings, imino groups, and phenolic hydroxyl groups.

< 18 > The photosensitive composition according to any one of the items < 16 > to < 17 >, wherein the polymerization inhibitor is at least one selected from the group consisting of catechols, phenothiazines, phenoxazines, hindered amines and derivatives thereof.

< 19 > The photosensitive composition according to any one of the items < 16 > to < 18 >, wherein the content of the polymerization inhibitor is 0.005% by mass to 0.5% by mass relative to the polymerizable compound.

< 20 > The photosensitive composition according to any one of the items < 16 > to < 19 >, wherein the content of the binder is 30% by mass to 90% by mass; the content of the polymerizable compound is 5% by mass to 60% by mass; and the content of the photopolymerization initiator is 0.1% by mass to 30 % by mass.

< 21 > The photosensitive composition according to any one of the items < 1 > to < 2 >, further containing a thermocrosslinker.

< 22 > The photosensitive composition according to any one of the items < 1 > to < 2 > and < 21 >, wherein the binder is an epoxy acrylate compound.

< 23 > The photosensitive composition according to any one of the items < 1 > to < 2 > and < 21 > to < 22 >, wherein the binder is a copolymer which can be obtained by reacting a primary amine compound in an equivalent mass of 0.1 to 1.2 to an anhydride group of a maleic anhydride copolymer.

< 24 > The photosensitive composition according to any one of the items < 1 > to < 2 > and < 21 > to < 23 >, wherein the binder is a copolymer which can be obtained by reacting a primary amine compound in an equivalent mass of 0.1 to 1.0 to an anhydride group of a copolymer which contains (a) an maleic acid anhydride, (b) an aromatic vinyl monomer, and (c) a vinyl monomer of which the glass transition temperature (Tg) of homopolymer of the vinyl monomer is less than 80°C.

< 25 > The photosensitive composition according to any one of the items < 1 > to < 2 > and < 21 > to < 24 >, wherein any one of the photopolymerization initiator and the photopolymerization initiating system contains at least one selected from the group consisting of halogenated hydrocarbon derivatives, phosphine oxides, hexaaryl-biimidazoles, oxime derivatives, organic peroxides, thio compounds, ketone compounds, acylphosphine oxide compounds, aromatic onium salts, and ketoxime ethers.

< 26 > The photosensitive composition according to any one of the items < 1 > to < 2 > and < 21 > to < 25 >, wherein the thermocrosslinker is at least one selected from the compounds which can be obtained by reacting a blocking agent to any one of an epoxy resin compound, an oxetane compound, a polyisocyanate compound, and a polyisocyanate compound, and melamine derivatives.

< 27 > The photosensitive composition according to any one of the items < 1 > to < 2 > and < 21 > to < 26 >, the melamine derivative is an alkylated methylol melamine.

< 28 > A pattern forming material having a photosensitive layer on a support, wherein the photosensitive layer contains a photosensitive composition according to any one of the items < 1 > to < 27 > on a support.

< 29 > The pattern forming material according to the item < 28 >, wherein after a light beam from a light irradiation unit is modulated by a light modulating unit having "n" imaging portions that can receive the laser beam from the light irradiating unit and can output the laser beam, the photosensitive layer is exposed with the light beam through a microlens array having an array of microlenses each having a non-spherical surface capable of compensating the aberration due to distortion at irradiating surface of the imaging portion in the light modulating unit.

< 30 > The pattern forming material according to any one of the items < 28 > to < 29 >, wherein the photosensitive layer has a thickness of 1 μm to 100 μm.

< 31 > The pattern forming material according to any one of the items < 28 > to < 29 >, wherein the support is a transparent synthetic resin.

< 32 > The pattern forming material according to any one of the items < 28 > to < 31 >, wherein the support is formed in an elongated shape.

< 33 > The pattern forming material according to any one of the items < 28 > to < 32 >, wherein the support is rolled.

< 34 > The pattern forming material according to any one of the items < 28 > to < 33 >, wherein the support is formed in an elongated shape and rolled in a roll shape.

< 36 > A photosensitive laminate having a photosensitive layer on a substrate, wherein the photosensitive layer contains a photosensitive composition according to any one of the items < 1 > to < 27 > on a substrate.

< 37 > The photosensitive laminate according to the item < 36 >, wherein after the light beam from a light irradiation unit is modulated by a light modulating unit having "n" imaging portions that can receive the laser beam the light irradiating unit and can output the laser beam, the photosensitive layer is exposed through a microlens array having an array of microlenses each having a non-spherical surface capable of compensating the aberration due to distortion at irradiating surface of the imaging portion in the light modulating unit.

< 38 > The photosensitive laminate according to any one of the items < 36> to < 37 >, wherein the photosensitive layer has a thickness of 1 μm to 100 μm.

< 39 > A pattern forming apparatus provided with at least any one of a pattern forming material according to any one of the items < 28 > to < 35 > and a photosensitive laminate according to any one of the items < 37 > to < 39 >, containing a light irradiation unit configured to irradiate a light beam, and a light modulating unit configured to modulate the light beam applied from the light irradiation unit to expose any one of the photosensitive layer in the pattern forming material and the photosensitive layer in the photosensitive laminate.

In the pattern forming apparatus according to the item < 39 >, the light irradiation unit irradiates a light beam toward the light modulating unit. The light modulating unit modulates the light beam received from the light irradiation unit. The photosensitive layer is exposed with the light beam modulated by the light modulating unit.

< 40 > The pattern forming apparatus according to the item < 39 >, wherein the light modulating unit further contains a pattern signal generating unit configured to generate control signals based on the information of a pattern to be formed, and the light modulating unit is configured to modulate the light beam emitted from the light irradiation unit according to the control signals generated by the pattern signal generating unit. In the pattern forming apparatus

according to the item < 40 >, by providing with the pattern signal generating unit to the light modulating unit, the light beam emitted from the light irradiation unit is modulated according to the control signals generated by the pattern signal generating unit.

< 41 > The pattern forming apparatus according to any one of the items < 39 > to < 40 >, wherein the light modulating unit has "n" imaging portions, and is able to control any imaging portions of less than arbitrarily selected "n" imaging portions disposed successively from among the "n" imaging portions depending on the information of a pattern to be formed.

In the pattern forming apparatus according to the item < 41 >, by controlling any imaging portions of less than arbitrarily selected "n" imaging portions disposed successively from among the "n" imaging portions in the light modulating unit depending on the information of a pattern to be formed, the light beam emitted from the light irradiation unit can be modulated at high speed.

< 42 > The pattern forming apparatus according to any one of the items < 39 > to < 41 >, wherein the light modulating unit is a spatial light modulator.

< 43 > The pattern forming apparatus according to the item < 42 >, wherein the spatial light modulator is a digital micromirror device (DMD).

< 44 > The pattern forming apparatus according to any one of the items < 41 > to < 43 >, wherein the imaging portions are micromirrors.

< 45 > The pattern forming apparatus according to any one of the items < 41 > to < 43 >, wherein the light irradiation unit can combine two or more types of light for irradiation.

In the pattern forming apparatus according to the item < 45 >, the light irradiation unit allowing for combining two or more types of light for irradiation enables exposures with deeper focal depth. As the result, the photosensitive layer can be finely and precisely exposed.

< 46 > The pattern forming apparatus according to any one of the items < 39 > to < 45 >, wherein the light irradiation unit has plural laser irradiating devices, a multimode optical fiber, and a collecting optical system that collects respective laser beams and connect them to the multimode optical fiber.

In the pattern forming apparatus according to the item < 46 >, the light irradiation unit can collect laser beams respectively emitted from the plural lasers by the use of the collecting optical system and connect them to the multimode optical fiber, and thus it enables exposures with deeper focal depth. As the result, the photosensitive layer can be finely and precisely exposed.

< 47 > A pattern forming process including exposing any one of a photosensitive layer in a pattern forming material according to any one of the items < 28 > to < 35 > and a photosensitive layer in a photosensitive laminate according to any one of the items < 36 > to < 38 > with a light beam.

< 48 > The pattern forming process according to the item < 47 >, wherein the pattern forming material is laminated on a substrate while performing at least any one of heating and pressurizing the pattern forming material.

< 49 > A pattern forming process including applying a photosensitive composition according to any one of the items < 1 > to < 27 > over a surface of a substrate, drying the substrate surface to form a photosensitive layer, and exposing and developing the photosensitive layer.

< 50 > The pattern forming process according to any one of the items < 48 > to < 49 >, wherein the substrate is a printed wiring board with an interconnection formed on thereon.

< 51 > The pattern forming process according to any one of the items < 47 > to < 50 >, wherein the photosensitive layer is imagewisely exposed based on the information of a pattern to be formed.

< 52 > The pattern forming process according to any one of the items < 47 > to < 51 >, wherein the photosensitive layer is exposed with a light beam according to control signals which are generated based on the information of a pattern to be formed.

In the pattern forming process according to the item < 52 >, control signals are generated based on the information of a pattern to be formed, and the light beam is modulated depending on the control signals.

< 53 > The pattern forming process according to any one of the items < 47 > to < 52 >, wherein the photosensitive layer is exposed using a light irradiation unit configured to irradiate a light beam and a light modulating unit configured to modulate the light beam emitted from the light irradiation unit based on the information of a pattern to be formed.

< 54 > The pattern forming process according to any one of the items < 47> to < 53 >, wherein after the light beam is modulated by the light modulating unit, the photosensitive layer is exposed through a microlens array having an array of microlenses each having a non-spherical surface capable of compensating the aberration due to distortion at irradiating surface of the imaging portion in the light modulating unit.

In the pattern forming process according to the item < 54 >, the light beam modulated by the light modulating unit passes through the non-spherical surface in the microlens array. With this configuration, the aberration due to distortion at irradiating surface of the imaging portion can be compensated. As the result, distortion of an image to be formed on the pattern forming material is prevented, and the photosensitive layer can be finely and precisely exposed.

< 55 > The pattern forming process according to the item < 54 >, wherein the non-spherical surface is a toric surface.
In the pattern forming process according to the item < 55 >, the non-spherical surface is a toric surface, and thus aberration due to distortion at irradiating surface of the imaging portion can be efficiently compensated, and distortion of an image to be formed on the pattern forming material can be efficiently prevented. As the result, the photosensitive layer can be finely and precisely exposed.
< 56 > The pattern forming process according to any one of the items < 47 > to < 55 >, wherein the photosensitive layer is exposed through an aperture array.
In the pattern forming process according to the item < 56 >, the photosensitive layer is exposed through an aperture array, and thus the extinction ratio is increased. As the result, the photosensitive layer can be finely and precisely exposed.
< 57 > The pattern forming process according to any one of the items < 47 > to < 56 >, wherein the photosensitive layer is exposed while moving relatively the exposing laser and the thermosensitive layer.
In the pattern forming process according to the item < 57 >, by relatively moving the modulated laser beam and the photosensitive layer, the exposure can be carried out at high speed.
< 58 > The pattern forming process according to any one of the items < 47 > to < 57 >, wherein a partial region of the photosensitive layer is exposed.
< 59 > The pattern forming process according to any one of the items < 47 > to < 58 >, wherein the photosensitive layer is exposed with the use of a laser beam having a wavelength of 395 nm to 415 nm.
< 60 > The pattern forming process according to any one of the items < 47 > to < 59 >, wherein after exposing the photosensitive layer with a light beam or a laser beam, the photosensitive layer is subjected to a developing treatment.
< 61 > The pattern forming process according to any one of the items < 47 > to < 60 >, wherein after developing the photosensitive layer, an etching pattern is formed on the photosensitive layer.
< 62 > The pattern forming process according to claim < 61 >, wherein the etching pattern is an interconnection pattern and is formed by use of any one of an etching treatment and a plating treatment.
< 63 > A permanent pattern forming process including subjecting any one of a photosensitive layer in a pattern forming material according to any one of the items < 28 > to < 35 > and a photosensitive layer in a photosensitive laminate according to any one of the items < 36 > to < 38 > to any one of the exposing treatment and the developing treatment according to any one of the items < 51 > to < 60 >, and hardening the photosensitive layer.
< 64 > The permanent pattern forming process according to the item < 63 >, wherein the hardening is any one of an entire surface exposing treatment and an entire surface heating treatment with heating at 120°C to 200°C.
< 65 > The permanent pattern forming process according to any one of the items < 63 > to < 64 >, wherein at least any one of a protective layer, an interlayer insulating film, and a solder resist pattern is formed.
< 66 > A permanent pattern formed by a permanent pattern forming process according to any one of the items < 63 > to < 65 >.
< 67 > The permanent pattern according to the item < 66 >, wherein the permanent pattern is at least any one of a protective layer, an interlayer insulating film, and a solder resist pattern.

The present invention can solve the above-noted conventional problems and can provide a photosensitive composition which has an extremely constant photosensitivity distribution relative to an exposure light having a wavelength in the region of short-wavelengths (blue-violet light), in particular, having a wavelength of 400 nm to 410 nm, is excellent in pattern reproductivity without being affected by variations in exposure wavelength during exposure with a laser beam, and allows substantially preventing variations in form of patterns as well as allows for easy handling under bright room environments. The present invention can also provide a pattern forming material and a photosensitive laminate each of which the photosensitive composition is formed in a laminate structure, a pattern forming apparatus, a pattern forming process, and highly fine and precise interconnection patterns and permanent patterns such as protective insulating films, and solder resist patterns.

Brief Description of Drawings

FIG. 1 is a partially enlarged view that shows exemplarily a construction of a digital micromirror device (DMD).
FIG. 2A is a view that explains exemplarily the motion of the DMD.
FIG. 2B is a view that explains exemplarily the motion of the DMD, similarly as shown in FIG. 2A.
FIG. 3A is an exemplary plan view that shows the exposing beam and the scanning line in the case where the DMD is not inclined, as compared to the exposing beam and the scanning line in the case where the DMD is inclined.
FIG. 3B is an exemplary plan view that shows the exposing beam and the scanning line in the case where a DMD similar to that shown in FIG. 3A is not inclined, as compared to the exposing beam and the scanning line in the case

where the DVD is inclined.

FIG. 4A is an exemplary view that shows an available region of the DMD.

FIG. 4B is an exemplary view that shows another available region of the DMD, which is similar to that shown in FIG. 4A.

FIG. 5 is an exemplary plan view that explains a way to expose a photosensitive layer in one scanning by means of a scanner.

FIG. 6A is an exemplary plan view that explains a way to expose a photosensitive layer in plural scannings by means of a scanner.

FIG. 6B is another exemplary plan view that explains a way to expose a photosensitive layer in plural scannings by means of a scanner, similarly as shown in FIG. 6A.

FIG. 7 is a schematic perspective view that shows exemplarily a pattern forming apparatus.

FIG. 8 is a schematic perspective view that shows exemplarily a scanner construction of a pattern forming apparatus.

FIG. 9A is an exemplary plan view that shows exposed regions formed on a photosensitive layer.

FIG. 9B is an exemplary plan view that shows regions exposed by respective exposing heads.

FIG. 10 is a schematic perspective view that shows exemplarily an exposing head including a light modulating unit.

FIG. 11 is an exemplary cross sectional view that shows the construction of the exposing head shown in FIG. 10 in the sub-scanning direction along the optical axis.

FIG.12 shows an exemplary controller configured to control the DMD based on pattern information.

FIG. 13A is an exemplary cross sectional view that shows a construction of another exposing head in other connecting optical system along the optical axis.

FIG. 13B is an exemplary plan view that shows an optical image projected on an exposed surface when a microlens array is not employed.

FIG. 13C is an exemplary plan view that shows an optical image projected on an exposed surface when a microlens array is employed.

FIG. 14 is an exemplary view that shows distortion of a reflective surface of a micromirror that constitutes a DMD by means of contour lines.

FIG. 15A is an exemplary graph that shows the distortion of the reflective surface of the micromirror along two diagonal lines of the micromirror.

FIG. 15B is an exemplary graph that shows the distortion of the reflective surface of the micromirror as shown in FIG. 15A along two diagonal lines of the micromirror.

FIG. 16A is an exemplary front view that shows a microlens array employed in a pattern forming apparatus in the present invention.

FIG. 16B is an exemplary side view that shows a microlens array employed in a pattern forming apparatus in the present invention.

FIG. 17A is an exemplary front view that shows a microlens constituting a microlens array.

FIG. 17B is an exemplary side view that shows a microlens constituting a microlens array.

FIG. 18A is an exemplary view that schematically shows a laser collecting condition in a cross section of a microlens.

FIG. 18B is an exemplary view that schematically shows a laser collecting condition in another cross section of a microlens.

FIG. 19A is an exemplary view that shows a simulation of beam diameters near the focal point of a microlens in accordance with the present invention.

FIG. 19B is an exemplary view that shows another simulation similar to FIG. 19A in terms of other sites in accordance with the present invention.

FIG. 19C is an exemplary view that shows still another simulation similar to FIG. 19A in terms of other sites in accordance with the present invention.

FIG. 19D is an exemplary view that shows still another simulation similar to FIG. 19A in terms of other sites in accordance with the present invention.

FIG. 20A is an exemplary view that shows a simulation of beam diameters near the focal point of a microlens in a conventional pattern forming process.

FIG. 20B is an exemplary view that shows another simulation similar to FIG. 20A in terms of other sites.

FIG. 20C is an exemplary view that shows still another simulation similar to FIG. 20A in terms of other sites.

FIG. 20D is an exemplary view that shows still another simulation similar to FIG. 20A in terms of other sites.

FIG. 21 is an exemplary plan view that shows another construction of a combined laser source.

FIG. 22A is an exemplary front view that shows a microlens of a microlens array.

FIG. 22B is an exemplary side view that shows a microlens of a microlens array.

FIG. 23A is an exemplary view that schematically shows a laser collecting condition in the cross section of the microlens shown in FIGS. 22A and 22B.

FIG. 23B is an exemplary view that schematically shows a laser collecting condition in another cross section of the microlens shown in FIG. 23A.

FIG. 24A is an exemplary view that explains the concept of compensation by an optical system of optical quantity distribution compensation.

FIG. 24B is another exemplary view that explains the concept of compensation by an optical system of optical quantity distribution compensation.

FIG. 24C is another exemplary view that explains the concept of compensation by an optical system of optical quantity distribution compensation.

FIG. 25 is an exemplary graph that shows an optical quantity distribution of Gaussian distribution without compensation of optical quantity.

FIG. 26 is an exemplary graph that shows a compensated optical quantity distribution by an optical system of optical quantity distribution compensation.

FIG. 27A (A) is an exemplary perspective view that shows a constitution of a fiber array laser source.

FIG. 27A (B) is a partially enlarged view of FIG. 27A (A).

FIG. 27A (C) is an exemplary plan view that shows an arrangement of emitting sites of laser output.

FIG. 27A (D) is an exemplary plan view that shows another arrangement of laser emitting sites.

FIG. 27B is an exemplary front view that shows an arrangement of laser emitting sites in the laser emitting part in a fiber array laser source.

FIG. 28 is an exemplary view that shows a construction of a multimode optical fiber.

FIG. 29 is an exemplary plan view that shows a construction of a combined laser source.

FIG. 30 is an exemplary plan view that shows a construction of a laser module.

FIG. 31 is an exemplary side view that shows a construction of the laser module shown in FIG. 30.

FIG. 32 is a partial side view that shows a construction of the laser module shown in FIG. 30.

FIG. 33 is an exemplary perspective view that shows a construction of a laser array.

FIG. 34A is an exemplary perspective view that shows a construction of a multi cavity laser.

FIG. 34B is an exemplary perspective view that shows a multi cavity laser array in which the multi cavity lasers shown in FIG. 34A are arranged in an array.

FIG. 35 is an exemplary plan view that shows another construction of a combined laser source.

FIG. 36A is an exemplary plan view that shows still another construction of a combined laser source.

FIG. 36B is an exemplary cross sectional view of FIG. 36A along the optical axis.

FIG. 37A is an exemplary cross sectional view of an exposing device that shows focal depth along the optical axis in the pattern forming process of the prior art.

FIG. 37B is an exemplary cross sectional view of an exposing device that shows focal depth along the optical axis in the pattern forming process according to the present invention.

Best Mode for Carrying Out the Invention

The present invention relates to an enhanced photosensitive composition, an enhanced pattern forming material and an enhanced photosensitive laminate each of which the photosensitive composition is formed in a laminate structure, an enhanced pattern forming apparatus, an enhanced pattern forming process, and enhanced permanent patterns. These are hereinafter described in detail.

The photosensitive composition of the present invention includes a photosensitive composition for dry film resist (DFR) and a photosensitive composition for solder resist. The dry film resist (DFR) is a resist of which a photosensitive layer is laminated on a support (film) and the photosensitive layer is stripped off from the support after being used as a resist. The solder resist is a resist of which a photosensitive layer is laminated on a support (film) or a substrate and the photosensitive layer is left for the purpose of protecting a pattern even after being used as a resist.

The pattern forming material and the photosensitive laminate of the present invention are those in which a photosensitive layer containing the photosensitive composition of the present invention is laminated on a support or a substrate.

The pattern forming apparatus relating to the present invention is an apparatus used in common for producing both the pattern forming materials and the photosensitive laminates of the present invention of which any one of the photosensitive composition for dry film resist and the photosensitive composition for solder resist is laminated on a support or a substrate.

The pattern forming process of the present invention includes a pattern forming process for dry film resists and a pattern forming process for solder resists.

- Photosensitive Composition for Dry Film Resist -

The photosensitive composition for dry film resist is not particularly limited and may be suitably selected in accordance with the intended use as long at the photosensitive composition has a maximum peak of spectral sensitivity

in the wavelength region from 380 nm to 420 nm; the minimum exposure dose $S_{400}$ capable of forming a pattern at a wavelength of 400 nm of the photosensitive composition is 200 mJ/cm$^2$ or less; the minimum exposure dose $S_{410}$ capable of forming a pattern at a wavelength of 410 nm of the photosensitive composition is 200 mJ/cm$^2$ or less; and $S_{400}$ and $S_{410}$ satisfy the relation $0.6 < S_{400}/S_{410} < 1.4$. The photosensitive composition for dry film resist contains, for example, a binder, a polymerizable compound, a photopolymerization initiator, a sensitizing agent, and other components suitably selected in accordance with the intended use. The minimum exposure does $S_{405}$ capable of forming a pattern at a wavelength of 405 nm is preferably 200 mJ/cm$^2$ or less.

With respect to the spectral sensitivity of the photosensitive composition, the photosensitive composition which is a photosensitive laminate formed by laminating a pattern forming material on a substrate to be processed is measured using a spectral sensitivity measuring device in accordance with the method described in, for example, "Photopolymer Technology (edited by Ao Yamaoka, issued by Nikkan Kogyo Shimbunsha, p 262 in 1988). Specifically, a pattern forming material on a substrate to be processed is exposed with a spectroscopic light from a light source such as a xenon lamp and a tungsten lamp which is set such that the exposure wavelength can change linearly in the horizontal axis direction and the exposure intensity can change longarithmically in the longitudinal direction, and the exposed surface is subjected to a developing treatment to thereby form a pattern for every sensitivity for each exposure wavelength. The exposure energy with which a pattern can be formed is calculated from the height (thickness) of the obtained pattern. The wavelength is plotted along the abscissa, and the reciprocal number of the exposure energy is plotted along the ordinate to form a spectral sensitivity curve. Then, the maximum peak in the spectral sensitivity curve is regarded as the spectral sensitivity of the photosensitive composition.

The minimum exposure dose with which a pattern can be formed is determined as the exposure energy capable of forming an image that can be calculated from the height (thickness) of the formed pattern in the above-noted spectral sensitivity measurement. The minimum exposure dose with which a pattern can be formed determines the optimum developing conditions by changing the developing conditions such as types of the developing solution, developing temperature, and developing time and means the minimum exposure dose with which a pattern can be formed under the optimum developing conditions.

The optimum developing conditions are not particularly limited and may be suitably selected in accordance with the intended use. For example, conditions under which unhardened regions can be completely removed by spraying a developing solution having a pH value of 8 to 12 on the unhardened regions at 25°C to 40°C and under a pressure of 0.05MPa to 0.5 MPa.

The minimum exposure dose $S_{400}$ capable of forming a pattern at a wavelength of 400 nm is preferably 200mJ/cm$^2$ or less, more preferably 100mJ/cm$^2$, and particularly preferably 50mJ/cm$^2$.

The minimum exposure dose $S_{410}$ capable of forming a pattern at a wavelength of 410 nm is preferably 200mJ/cm$^2$ or less, more preferably 100mJ/cm$^2$, and particularly preferably 50mJ/cm$^2$.

The value of $S_{400}/S_{410}$ is preferably 0.6 to 1.4, more preferably 0.8 to 1.2, and particularly preferably 0.9 to 1.1.

When the value of $S_{400}/S_{410}$ is less than 0.6 or is more than 1.4, a uniform pattern may not be obtained due to sensitivity change attributable to variations in wavelength of the individual semiconductor devices.

The minimum exposure does $S_{405}$ capable of forming a pattern at a wavelength of 405 nm is preferably 200 mJ/cm$^2$ or less, more preferably 100 mJ/cm$^2$, and particularly preferably 50 mJ/cm$^2$.

- Binder for Dry Film Resist -

For the binder, for example, the binder is preferably swellable to alkaline aqueous solutions, and is more preferably soluble in alkaline aqueous solutions.

Preferred examples of the binder that is swellable to or soluble in alkaline aqueous solutions include alkaline aqueous solutions having an acidic group.

The acidic group is not particularly limited and may be suitably selected in accordance with the intended use, and examples thereof include carboxyl groups, sulfonic acid groups, and phosphate groups. Of these, carboxyl groups are preferable.

Examples of the binders that contain a carboxyl group include vinyl copolymers, polyurethane resins, polyamide acid resins, and modified epoxy resins that contain a carboxyl group. Among these, vinyl copolymers containing a carboxyl group are preferable from the perspective of solubility in coating solvents, solubility in alkaline developers, ability to be synthesized, easiness to adjust film properties, and the like.

The vinyl copolymers containing a carboxyl group may be synthesized by copolymerizing at least (i) a vinyl polymer containing a carboxyl group, and (ii) a monomer capable of copolymerizing with the vinyl monomer.

Examples of vinyl polymers containing a carboxyl group include (meth)acrylic acid, vinyl benzoic acid, maleic acid, maleic acid monoalkylester, fumaric acid, itaconic acid, crotonic acid, cinnamic acid, acrylic acid dimer, adducts of a monomer containing a hydroxy group such as 2-hydroxyethyl(meth)acrylate and a cyclic anhydride such as maleic acid anhydride, phthalic acid anhydride, and cyclohexane dicarbonic acid anhydride, and ω-carboxy-polycaprolactone

mono(meth)acrylate. Among these, (meth)acrylic acid is preferable in particular from the perspective of copolymerizing ability, cost, solubility, and the like.

In addition, as for the precursor of carboxyl group, monomers containing anhydride such as maleic acid anhydride, itaconic acid anhydride, and citraconic acid anhydride may be employed.

The monomer capable of copolymerizing may be suitably selected in accordance with the intended use; and examples thereof include (meth)acrylate esters, crotonate esters, vinyl esters, maleic acid diesters, fumaric acid diesters, itaconic acid diesters, (meth)acrylic amides, vinyl ethers, vinyl alcohol esters, styrenes, metacrylonitrile; heterocyclic compounds with a substituted vinyl group such as vinylpyridine, vinylpyrrolidone, and vinylcarbazole; N-vinyl formamide, N-vinyl acetamide, N-vinyl imidazole, vinyl caprolactone, 2-acrylamide-2-methylpropane sulfonic acid, phosphoric acid mono(2-acryloyloxyethylester), phosphoric acid mono(1-methyl-2-acryloyloxyethylester), and vinyl monomers containing a functional group such as a urethane group, urea group, sulfonic amide group, phenol group, and imide group. Of these, styrenes are preferably used.

Examples of (meth)acrylate esters include methyl(meth)acrylate, ethyl(meth)acrylate, n-propyl(meth)acrylate, isopropyl(meth)acrylate, n-butyl(meth)acrylate, isobutyl(meth)acrylate, t-butyl(meth)acrylate, n-hexyl(meth)acrylate, cyclohexyl(meth)acrylate, t-butyl cyclohexyl(meth)acrylate, 2-ethylhexyl(meth)acrylate, t-octyl(meth)acrylate, dodecyl (meth)acrylate, octadecyl(meth)acrylate, acetoxyethyl(meth)acrylate, phenyl(meth)acrylate, 2-hydroxyethyl(meth)acrylate, 2-methoxyethyl(meth)acrylate, 2-ethoxyethyl(meth)acrylate (meth)acrylate, 2-(2-methoxyethoxy)ethyl (meth)acrylate, 3-phenoxy-2-hydroxypropyl(meth)acrylate, benzil(meth)acrylate, diethyleneglycol monomethylether (meth)acrylate, diethyleneglycol monoethylether (meth)acrylate, diethyleneglycol monophenylether (meth)acrylate, triethyleneglycol monomethylether (meth)acrylate, triethyleneglycol monoethylether (meth)acrylate, polyethyleneglycol monomethylether (meth)acrylate, polyethyleneglycol monoethylether (meth)acrylate, β-phenoxyethoxyethyl (meth)acrylate, nonylphenoxy polyethyleneglycol (meth)acrylate, dicyclopentanyl (meth)acrylate, dicyclopentenyl oxyethyl (meth)acrylate, trifluoroethyl (meth)acrylate, octafluoropentyl (meth)acrylate, perfluorooctylethyl (meth)acrylate, tribromophenyl (meth) acrylate, and tribromophenyloxyethyl (meth)acrylate.

Examples of crotonate esters include butyl crotonate, and hexyl crotonate.

Examples of vinyl esters include vinyl acetate, vinyl propionate, vinyl butyrate, vinylmethoxy acetate, and vinyl benzoate.

Examples of maleic acid diesters include dimethyl maleate, diethyl maleate, and dibutyl maleate.

Examples of fumaric acid diesters include dimethyl fumarate, diethyl fumarate, and dibutyl fumarate.

Examples of itaconic acid diesters include dimethyl itaconate, diethyl itaconate, and dibutyl itaconate.

Examples of (meth)acrylic amides include (meth)acrylamide, N-methyl (meth)acrylamide, N-ethyl (meth)acrylamide, N-propyl (meth)acrylamide, N-isopropyl (meth)acrylamide, N-n-butyl (meth)acrylamide, N-t-butyl (meth)acrylamide, N-cyclohexyl (meth)acrylamide, N-(2-methoxyethyl) (meth)acrylamide, N,N-dimethyl (meth)acrylamide, N,N-diethyl (meth)acrylamide, N-phenyl (meth)acrylamide, N-benzil (meth)acrylamide, (meth)acryloyl morpholine, and diacetone acrylamide.

Examples of the styrenes include styrene, methylstyrene, dimethylstyrene, trimethylstyrene, ethylstyrene, isopropylstyrene, butylstyrene, hydroxystyrene, methoxystyrene, butoxystyrene, acetoxystyrene, chlorostyrene, dichlorostyrene, bromostyrene, chloromethylstyrene; hydroxystyrene with a protective group such as t-Boc capable of being deprotected by an acid substance; vinylmethyl benzoate, and α-methylstyrene.

Examples of vinyl ethers include methyl vinylether, butyl vinylether, hexyl vinylether, and methoxyethyl vinylether.

The process to synthesize the vinyl monomer containing a functional group is an addition reaction of an isocyanate group and a hydroxy group or amino group for example; specifically, an addition reaction between a monomer containing an isocyanate group and a compound containing one hydroxyl group or a compound containing one primary or secondary amino group, and an addition reaction between a monomer containing a hydroxy group or a monomer containing a primary or secondary amino group and a mono isocyanate are exemplified.

Examples of the monomers containing an isocyanate group include the compounds expressed by the following formulas (1) to (3).

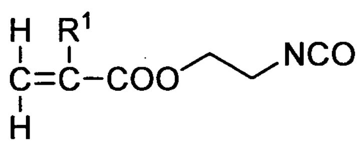

formula (1)

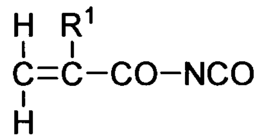

formula (2)

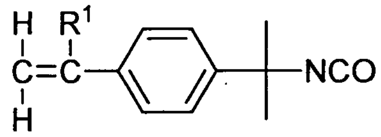

formula (3)

In the above formulas (1) to (3), $R^1$ represents a hydrogen atom or a methyl group.

Examples of mono isocyanates set forth above include cyclohexyl isocyanate, n-butyl isocyanate, toluyl isocyanate, benzyl isocyanate, and phenyl isocyanate.

Examples of the monomers containing a hydroxyl group include the compounds expressed by the following formulas (4) to (12).

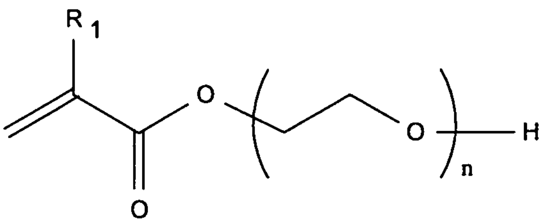

formula (4)

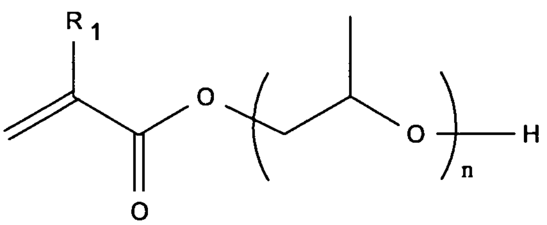

formula (5)

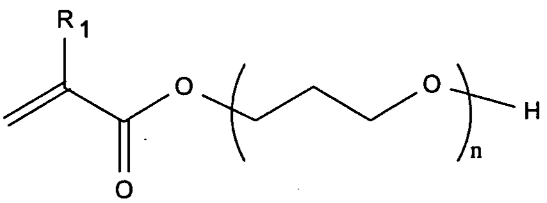

formula (6)

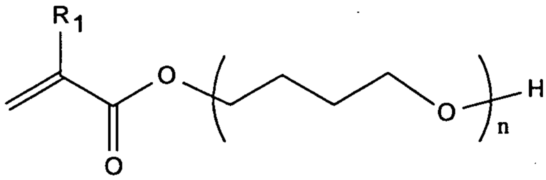

formula (7)

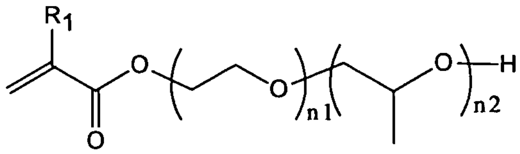

formula (8)

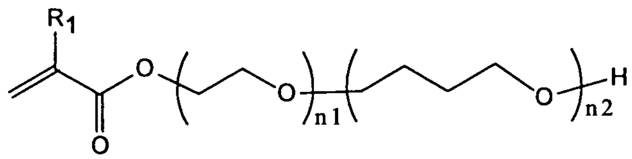

formula (9)

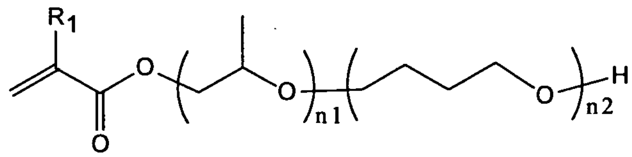

formula (10)

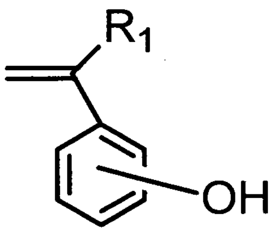

formula (11)

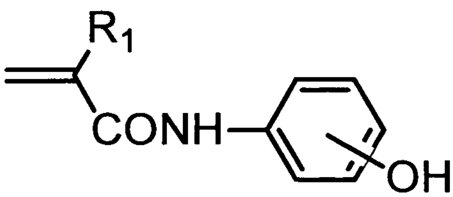

formula (12)

In the above formulas (4) to (12), $R_1$ represents a hydrogen atom or a methyl group, and "n" represents an integer of one or more.

Examples of the compounds containing one hydroxyl group include alcohols such as methanol, ethanol, n-propanol, i-propanol, n-butanol, sec-butanol, t-butanol, n-hexanol, 2-ethylhexanol, n-decanol, n-dodecanol, n-octadecanol, cyclopentanol, cyclohexanol, benzil alcohol, and phenylethyl alcohol; phenols such as phenol, cresol, and naphthol; examples of the compounds containing additionally a substituted group include fluoroethanol, trifluoroethanol, methoxyethanol, phenoxyethanol, chlorophenol, dichlorophenol, methoxyphenol, and acetoxyphenol.

Examples of monomers containing a primary or secondary amino group set forth above include vinylbenzyl amine.

Examples of compounds containing a primary or secondary amino group include alkylamines such as methylamine, ethylamine, n-propylamine, i-propylamine, n-butylamine, sec-butylamine, t-butylamine, hexylamine, 2-ethylhexylamine, decylamine, dodecylamine, octadecylamine, dimethylamine, diethylamine, dibutylamine, and dioctylamine; cyclic alkylamines such as cyclopentylamine and cyclohexylamine; aralkylamines such as benzilamine and phenethylamine; arylamines such as aniline, toluicamine, xylylamine, and naphthylamine; combination thereof such as N-methyl-N-benzilamine; and amines containing a substituted group such as trifluoroethylamine, hexafluoro isopropylamine, methoxyaniline, and methoxy propylamine.

Preferred examples of the copolymerizable monomers other than set forth above include methyl (meth)acrylate, ethyl (meth)acrylate, butyl (meth)acrylate, benzil (meth)acrylate, 2-ethylhexyl (meth)acrylate, styrene, chlorostyrene, bromostyrene, and hydroxystyrene.

The above noted copolymerizable monomers may be used alone or in combination with two or more.

The vinyl copolymers set forth above may be prepared by copolymerizing the appropriate monomers in accordance with conventional processes; for example, such a solution polymerization process is available as dissolving the monomers into an appropriate solvent, adding a radical polymerization initiator, thereby causing a polymerization in the solvent; alternatively such a so-called emulsion polymerization process is available as polymerizing the monomers under the condition that the monomers are dispersed in an aqueous solvent.

The solvent utilized in the solution polymerization process may be properly selected depending on the monomers, solubility of the resultant copolymer and the like; examples of the solvents include methanol, ethanol, propanol, isopropanol, 1-methoxy-2-propanol, acetone, methyl ethyl ketone, methylisobutylketone, methoxypropyl acetate, ethyl lactate, ethyl acetate, acetonitrile, tetrahydrofuran, dimethylformamide, chloroform, and toluene. These solvents may be used alone or in combination with two or more.

The radical polymerization initiator set forth above may be properly selected without particular limitations; examples thereof include azo compounds such as 2,2'-azobis(isobutyronitrile) (AIBN) and 2,2'-azobis-(2,4'-dimethylvaleronitrile); peroxides such as benzoyl peroxide; persulfates such as potassium persulfate and ammonium persulfate.

The content of the polymerizable compound having a carboxyl group in the vinyl copolymers set forth above may be properly selected without particular limitations; preferably, the content is 5 mole % to 50 mole %, more preferably 10 mole % to 40 mole %, and still more preferably 15 mole % to 35 mole %.

When the content is less than 5 mole %, the developing ability in alkaline solution may be insufficient, and when the content is more than 50 mole %, the durability of the hardening portion or imaging portion is insufficient against the developing liquid.

The molecular mass of the binder having a carboxyl group set forth above may be properly selected without particular limitations; preferably the mass average molecular mass is 2,000 to 300,000, more preferably 4,000 to 150,000.

When the mass average molecular mass is less than 2,000, the film strength is likely to be insufficient, and also the production process tends to be unstable, and when the mass average molecular mass is more than 300,000, the developing ability tends to decrease.

The binder having a carboxyl group set forth above may be used alone or in combination with two or more. As for the combination of two or more of the binders, such combination may be exemplified as two or more of binders having different copolymer components, two or more of binders having different mass average molecular mass, and two or more of binders having different dispersion levels.

In the binder having a carboxyl group set forth above, a part or all of the carboxyl groups may be neutralized by a basic substance. Further, the binder may be combined with a resin of different type selected from polyester resins, polyamide resins, polyurethane resins, epoxy resins, polyvinyl alcohols, gelatin, and the like.

In addition, the binder having a carboxyl group set forth above may be a resin soluble in an alkaline aqueous solution as described in Japanese Patent No. 2873889.

The content of the binder in the photosensitive composition set forth above may be properly selected without particular limitations; preferably the content is 10 % by mass to 90 % by mass, more preferably 20 % by mass to 80 % by mass, and still more preferably 40 % by mass to 80 % by mass.

When the content is less than 10 % by mass, the developing ability in alkaline aqueous solutions or the adhesive property with substrates for forming printed wiring boards such as a cupper laminated board tends to decrease, and when the content is more than 90 % by mass, the stability of developing period or the strength of the hardening film or the tenting film may be insufficient. The content of the binder may be considered as the sum of the binder content and the additional polymer binder content combined depending on requirements.

The acid value of the binder may be properly selected depending on the application; preferably the acid value is 70 mgKOH/ g to 250 mgKOH/ g, more preferably 90 mgKOH/ g to 200 mgKOH/ g, still more preferably 100 mgKOH/ g to 180 mgKOH/ g.

When the acid value is less than 70 mgKOH/ g, the developing ability may be insufficient, the resolving property may be poor, or the permanent pattern such as interconnection patterns cannot be formed precisely, and when the acid value is more than 250 mgKOH/ g, the durability of pattern against the developer and/ or adhesive property of pattern tends to degrade, thus the permanent pattern such as interconnection patterns may not be formed highly precisely.

- Polymerizable Compound for Dry Film Resist -

The polymerizable compound may be properly selected without particular limitations; preferably, the polymerizable compound is the monomer or oligomer that contains a urethane group and/ or an aryl group; preferably. In addition, preferable, the polymerizable compound contains two or more types of polymerizable group.

Examples of the polymerizable group include ethylenically unsaturated bonds such as (meth)acryloyl groups, (meth)acrylamide groups, styryl groups, vinyl groups (e.g. of vinyl esters, vinyl ethers), and allyl groups (e.g. of allyl ethers, allyl esters); and polymerizable cyclic ether groups such as epoxy groups and oxetane group. Among these, the ethylenically unsaturated bond is preferable.

- Monomer Containing Urethane Group -

The monomer containing a urethane group set forth above may be properly selected without particular limitations; examples thereof include those described in Japanese Patent Application Publication (JP-B) No. 48-41708, Japanese Patent Application Laid-Open (JP-A) No. 51-37193, JP-B Nos. 5-50737, 7-7208, and JP-A Nos. 2001-154346, 2001-356476; specifically, the adducts may be exemplified between polyisocyanate compounds having two or more isocyanate groups in the molecule and vinyl monomers having a hydroxyl group in the molecule.

Examples of the polyisocyanate compounds having two or more isocyanate groups in the molecule set forth above include diisocyanates such as hexamethylene diisocyanate, trimethyl hexamethylene diisocyanate, isophorone diisocyanate, xylene diisocyanate, toluene diisocyanate, phenylene diisocyanate, norbornene diisocyanate, diphenyl diisocyanate, diphenylmethane diisocyanate, and 3,3'-dimethyl-4,4'-diphenyl diisocyanate; polyaddition products of these diisocyanates and two-functional alcohols wherein each of both ends of the polyaddition product is an isocyanate group; trimers such as buret of the diisocyanates or isocyanurates; adducts obtained from the diisocyanate of diisocyanates and polyfunctional alcohols such as trimethylolpropane, pentaerythritol, and glycerin or polyfunctional alcohols of adducts with ethylene oxide.

Examples of vinyl monomers having a hydroxyl group in the molecule set forth above include 2-hydroxyethyl (meth)acrylate, 2-hydroxypropyl (meth)acrylate, 4-hydroxybutyl (meth)acrylate, diethyleneglycol mono(meth)acrylate, triethyleneglycol mono(meth)acrylate, tetraethyleneglycol mono(meth)acrylate, octaethyleneglycol mono(meth)acrylate, polyethyleneglycol mono(meth)acrylate, dipropyleneglycol mono(meth)acrylate, tripropyleneglycol mono(meth)acrylate, tetrapropyleneglycol mono(meth)acrylate, octapropyleneglycol mono(meth)acrylate, polypropyleneglycol mono(meth) acrylate, dibutyleneglycol mono(meth)acrylate, tributyleneglycol mono(meth)acrylate, tetrabutyleneglycol mono(meth) acrylate, octabutyleneglycol mono(meth)acrylate, polybutyleneglycol mono(meth)acrylate, trimethylolpropane (meth) acrylate, and pentaerythritol (meth)acrylate. Further, such a vinyl monomer may be exemplified which has a (meth) acrylate component at one end of diol molecule having different alkylene oxides such as of random or block copolymer of ethylene oxide and propylene oxide for example.

Examples of the monomers containing a urethane group set forth above include the compounds having an isocyanurate ring such as tri(meth)acryloyloxyethyl isocyanurate, di(meth)acrylated isocyanurate, and tri(meth)acrylate of ethylene oxide modified isocyanuric acid. Among these, the compounds expressed by formula (13) or formula (14) are preferable; at least the compounds expressed by formula (14) are preferably included in particular from the view point of tenting property. These compounds may be used alone or in combination with two or more.

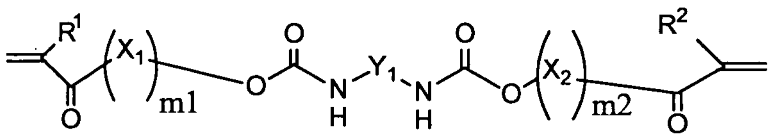

formula (13)

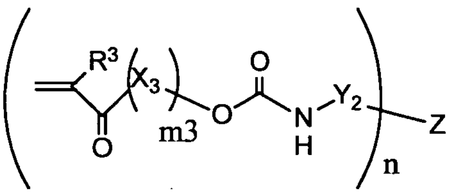

formula (14)

In the formulas (13) and (14), $R^1$ to $R^3$ represent a hydrogen atom or a methyl group respectively; $X_1$ to $X_3$ represent alkylene oxide groups, which may be used alone or in combination with two or more.

Examples of the alkylene oxide group include ethylene oxide group, propylene oxide group, butylene oxide group, pentylene oxide group, hexylene oxide group, and combined groups thereof in random or block. Among these, ethylene oxide group, propylene oxide group, butylene oxide group, and combined groups thereof are preferable; and ethylene oxide group and propylene oxide group are more preferable.

In the formulas (13) and (14), m1 to m3 represent integers of 1 to 60 respectively, preferably 2 to 30, and more preferably 4 to 15.

In the formulas (13) and (14), each of $Y^1$ and $Y^2$ represents a divalent organic group having 2 to 30 carbon atoms such as alkylene group, arylene group, alkenylene group, alkynylene group, carbonyl group (-CO-), oxygen atom, sulfur atom, imino group (-NH-), substituted imino group wherein a hydrogen atom on the imino group is substituted with a monovalent hydrocarbon group, sulfonyl group ($-SO_2-$), and combination thereof; among these, an alkylene group, arylene group, and combination thereof are preferable.

The alkylene group set forth above may be of branched or cyclic structure; and preferred examples of the alkylene group include methylene group, ethylene group, propylene group, isopropylene group, butylene group, isobutylene group, pentylene group, neopentylene group, hexylene group, trimethylhexylene group, cyclohexylene group, heptylene group, octylene group, 2-ethylhexylene group, nonylene group, decylene group, dodecylene group, octadecylene group, and the groups expressed by the following formulas.

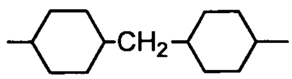
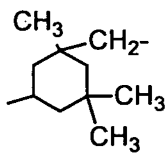
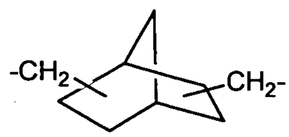

The arylene group may be substituted with a hydrocarbon group; examples of the arylene group include phenylene group, thrylene group, diphenylene group, naphthylele group, and the following group.

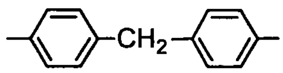

The group of combination thereof set forth above is exemplified by xylylene group.

The alkylene group, arylene group, and combination thereof set forth above may contain a substituted group additionally. Examples of the substituted group include halogen atoms such as fluorine atom, chlorine atom, bromine atom, and iodine atom; aryl groups; alkoxy groups such as methoxy group, ethoxy group, and 2-ethoxyethoxy group; aryloxy groups such as phenoxy group; acyl groups such as acetyl group and propionyl group; acyloxy groups such as acetoxy group and butylyloxy group; alkoxycarbonyl groups such as methoxycarbonyl group and ethoxycarbonyl group; and aryloxycarbonyl groups such as phenoxycarbonyl group.

In the formulas (13) and (14), "n" represents an integer of 3 to 6, preferably, "n" is 3, 4, or 6 from the viewpoint of the available feedstock for synthesizing the polymerizable monomer.

In the formulas (13) and (14), Z represents a connecting group of "n" valences (n = 3 to 6), and examples of Z include the following groups.

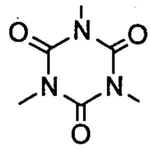 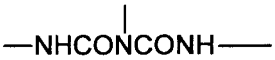 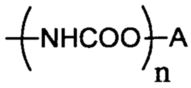 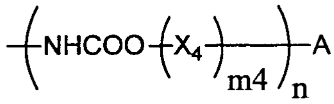

In the above formulas, $X_4$ represents an alkylene oxide; m4 represents an integer of 1 to 20; "n" represents an integer of 3 to 6; and A represents an organic group having "n" valences (n = 3 to 6).

Example of A of the organic group set forth above include n-valence aliphatic groups, n-valence aromatic groups, and combinations of these groups and alkylene groups, arylene groups, alkenylene groups, alkynylene groups, carbonyl group, oxygen atom, sulfur atom, imino group, substituted imino groups wherein a hydrogen atom on the imino group is substituted with a monovalent hydrocarbon group, and sulfonyl group ($-SO_2-$); more preferably are n-valence aliphatic groups, n-valence aromatic groups, and combinations of these groups and alkylene groups, arylene groups, or an oxygen atom; particularly preferable are n-valence aliphatic groups, and combinations of n-valence aliphatic groups and alkylene groups or an oxygen atom.

The number of carbon atoms in the A of the organic group set forth above is preferably 1 to 100, more preferably 1 to 50, and still more preferably 3 to 30.

The n-valence aliphatic group set forth above may be of branched or cyclic structure. The number of carbon atoms in the aliphatic group is preferably 1 to 30, more preferably 1 to 20, and still more preferably 3 to 10.

The number of carbon atoms in the aromatic group set forth above is preferably 6 to 100, more preferably 6 to 50, and still more preferably 6 to 30.

The n-valence aliphatic group and the n-valence aromatic group may contain a substituted group additionally; examples of the substituted group include hydroxyl group, halogen atoms such as fluorine atom, chlorine atom, bromine atom, and iodine atom; aryl groups; alkoxy groups such as methoxy group, ethoxy group, and 2-ethoxyethoxy group; aryloxy groups such as phenoxy group; acyl groups such as acetyl group and propionyl group; acyloxy groups such as acetoxy group and butylyloxy group; alkoxycarbonyl groups such as methoxycarbonyl group and ethoxycarbonyl group; and aryloxycarbonyl groups such as phenoxycarbonyl group.

The alkylene group set forth above may be of branched or cyclic structure. The number of carbon atoms in the alkylene group is preferably 1 to 18, and more preferably 1 to 10.

The arylene group set forth above may be further substituted with a hydrocarbon group. The number of carbon atoms in the arylene group is preferably 6 to 18, and more preferably 6 to 10.

The number of carbon atoms in the hydrocarbon group of the substituted imino group set forth above is preferably 1 to 18, and more preferably 1 to 10.

Preferable examples of A of the organic group set forth above are as follows.

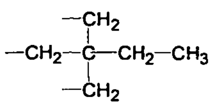 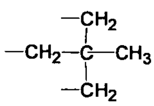 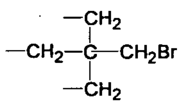 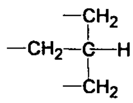 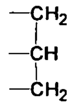

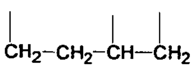 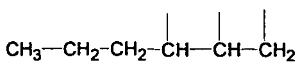 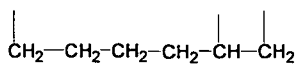

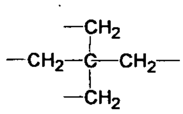 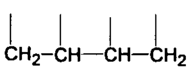 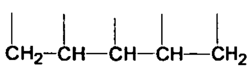 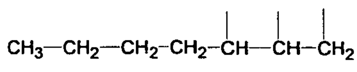

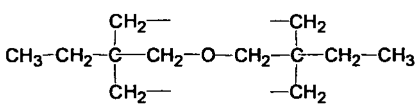
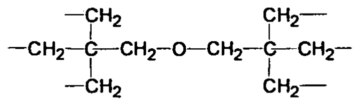

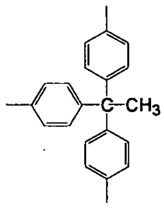
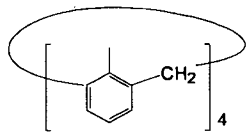
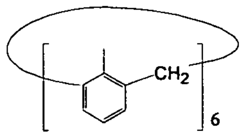
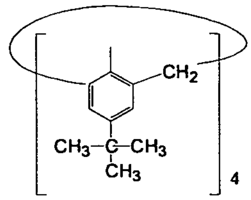
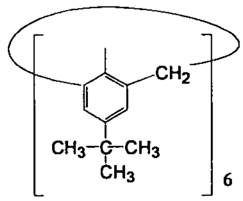

The compounds expressed by the formulas (13) and (14) are exemplified specifically by the following formulas (15) to (37).

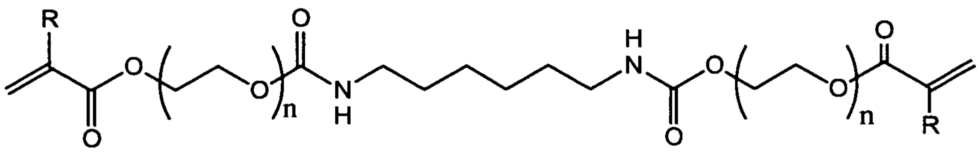

formula (15)

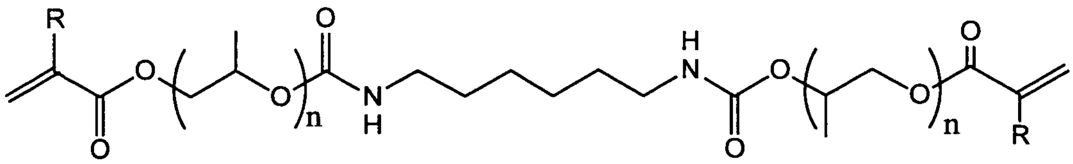

formula (16)

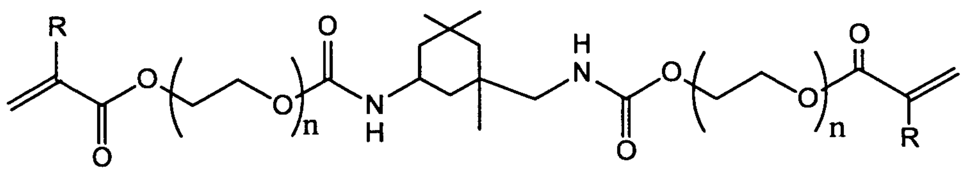

formula (17)

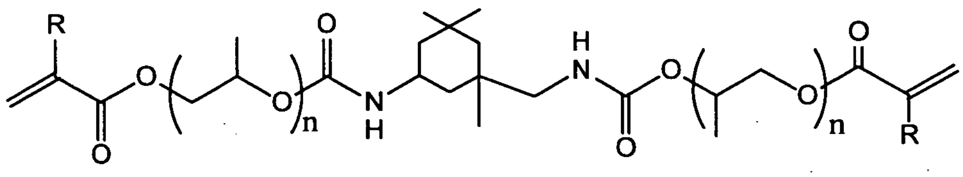

formula (18)

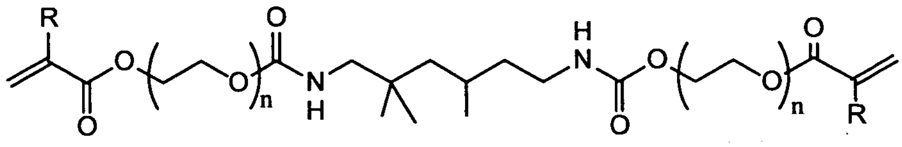

formula (19)

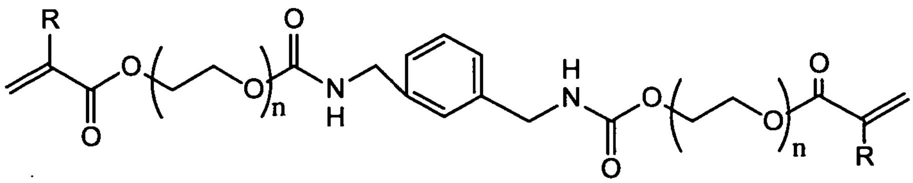

formula (20)

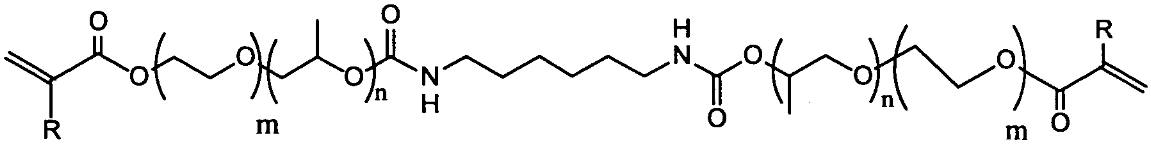

formula (21)

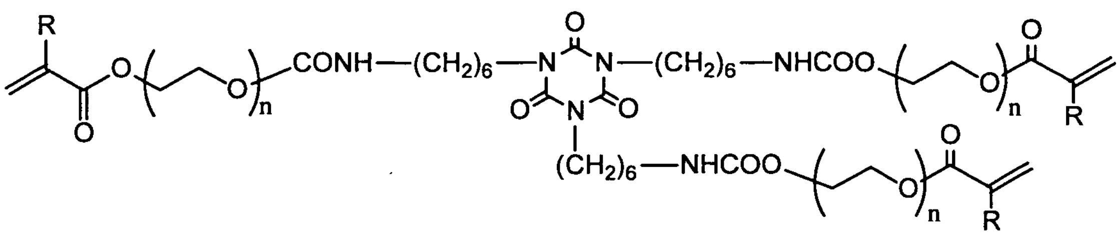

formula (22)

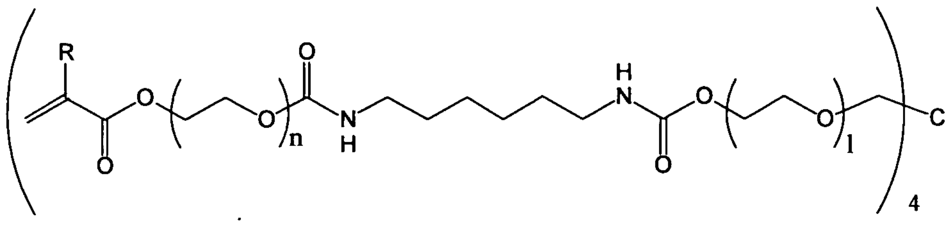

formula (23)

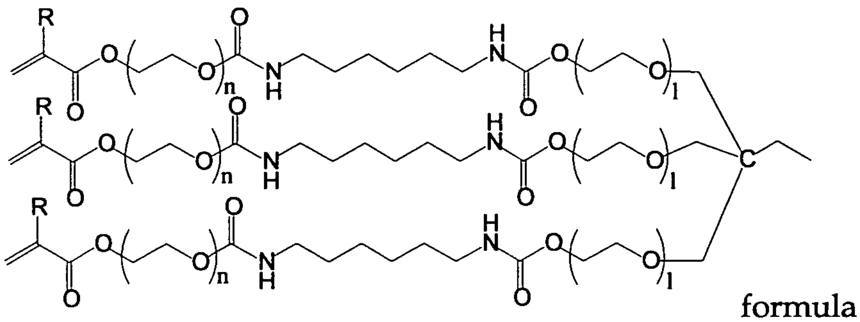

formula (24)

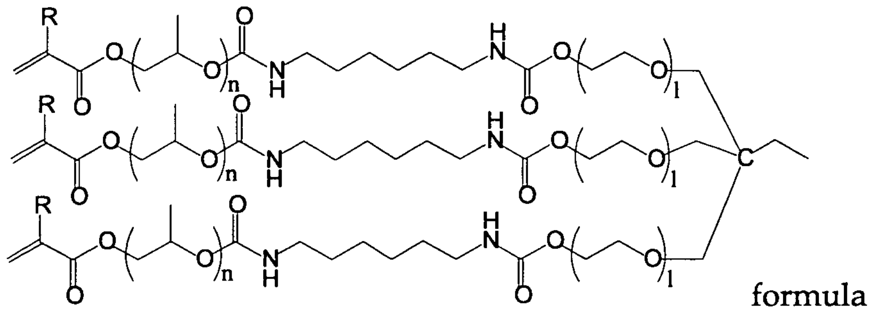

formula (25)

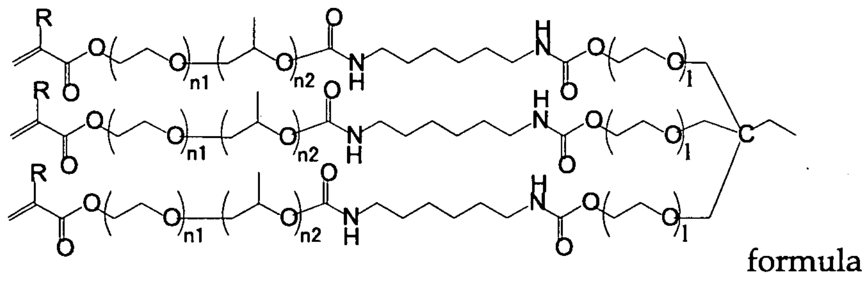

formula (26)

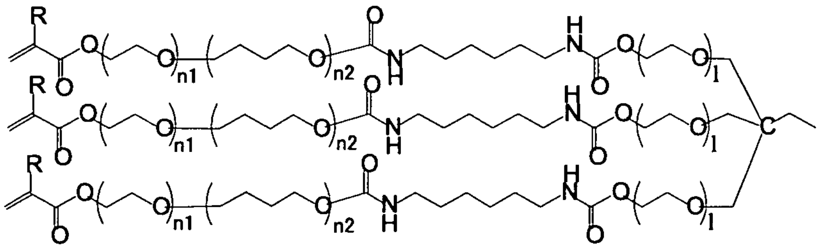

formula (27)

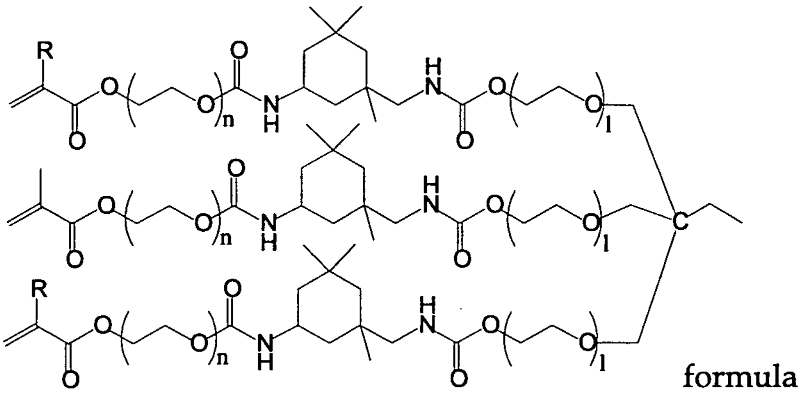

formula (28)

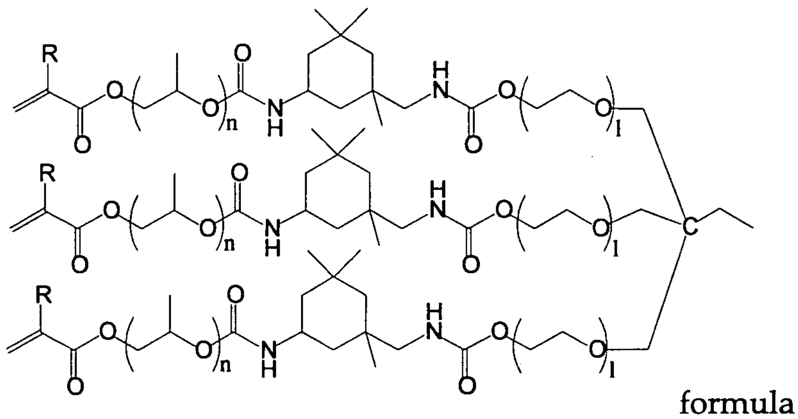

formula (29)

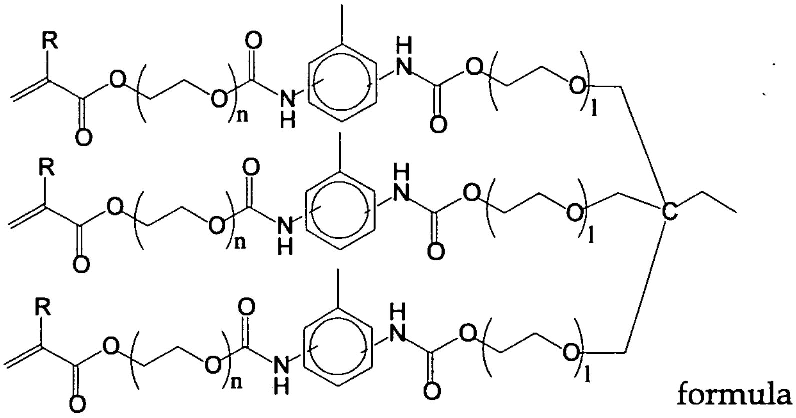

formula (30)

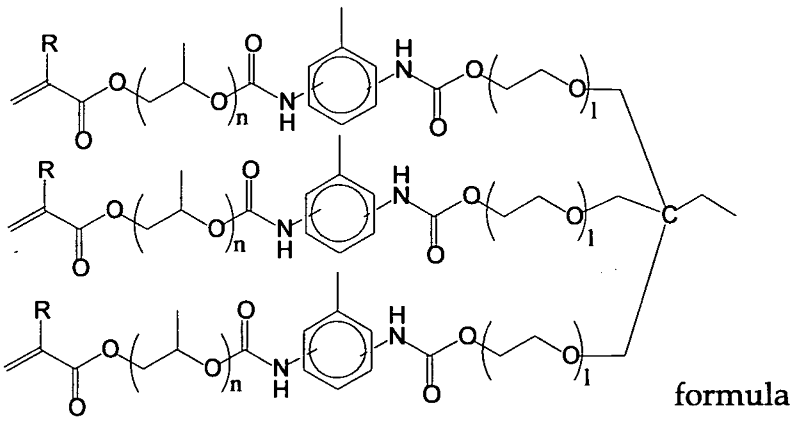

formula (31)

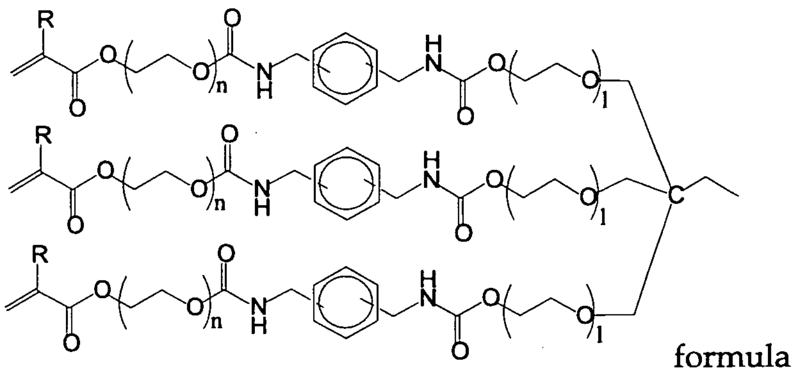

formula (32)

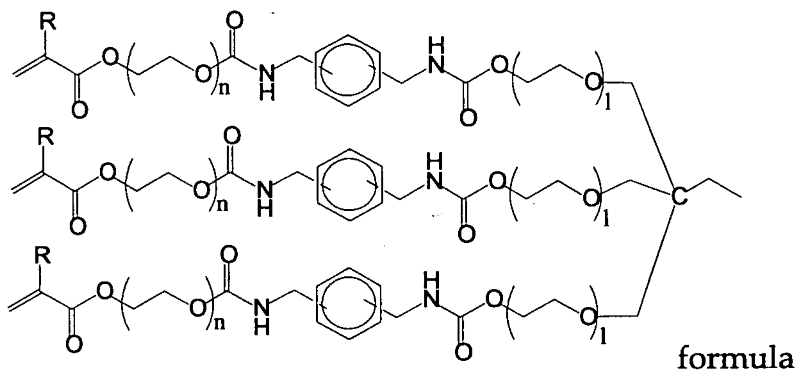

formula (33)

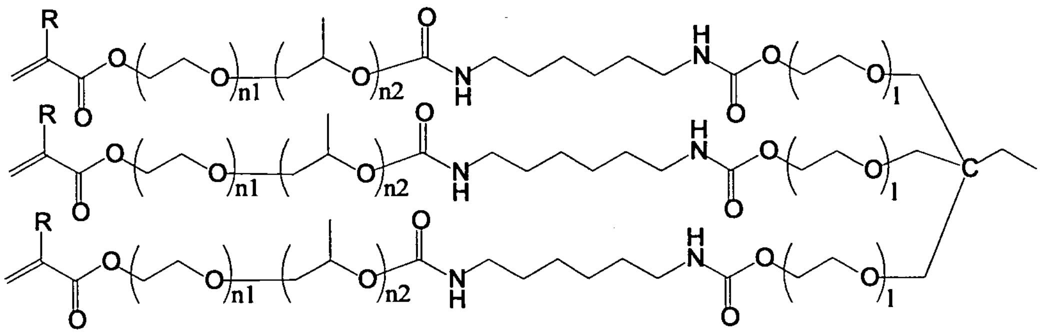

formula (34)

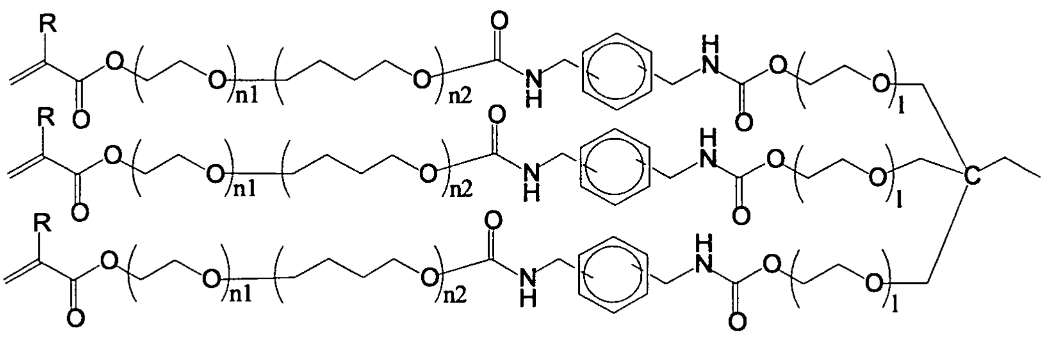

formula (35)

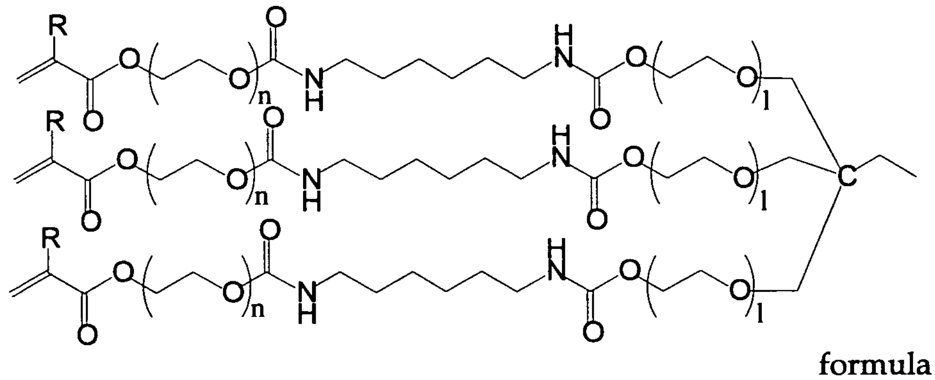

formula (36)

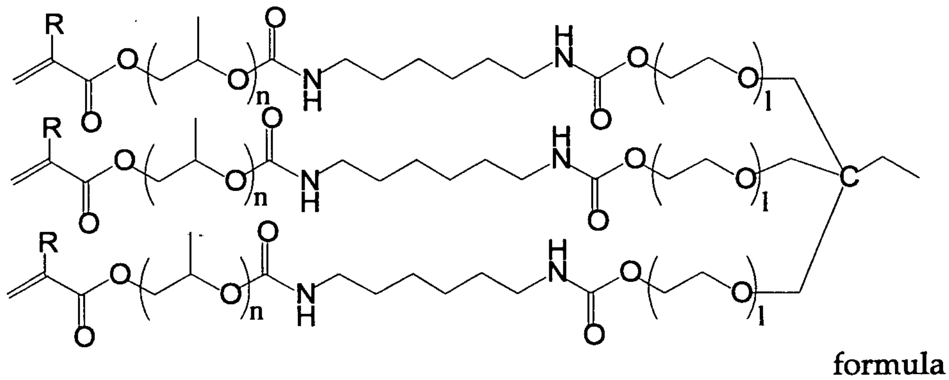

formula (37)

In the above formulas (15) to (37), each of "n", n1, n2, and "m" represents an integer of 1 to 60; "1" represents an integer of 1 to 20; and R represents a hydrogen atom or a methyl group.

- Monomer Containing Aryl Group -

The monomers containing an aryl group set forth above may be properly selected as long as the monomer contains an aryl group; and examples of the monomers containing an aryl group include esters and amides between at least one of polyvalent alcohol compounds, polyvalent amine compounds, and polyvalent amino alcohol compounds containing an aryl group and at least one of unsaturated carboxylic acids.

Examples of the polyvalent alcohol compounds, polyvalent amine compounds, and polyvalent amino alcohol compounds containing an aryl group include polystyrene oxide, xylylenediol, di(β-hydroxyethoxy)benzene, 1,5-dihydroxy-1,2,3,4-tetrahydronaphthalene, 2,2-diphenyl-1,3-propanediol, hydroxybenzyl alcohol, hydroxyethyl resorcinol, 1-phenyl-1,2-ethanediol, 2,3,5,6-tetramethyl-p-xylene-α,α'-diol,1,1,4,4-tetraphenyl-1,4-butanediol, 1,1,4,4-tetraphenyl-2-butine-1,4-diol, 1,1'-bi-2-naphthol, dihydroxynaphthalene, 1,1'-methylene-di-2-naphthol, 1,2,4-benzenetriol, biphenol, 2,2'-bis (4-hydroxyphenyl)butane,1,1-bis(4-hydroxyphenyl)cyclohexane, bis(hydroxyphenyl)methane, catechol, 4-chlororesorcinol, hydroquinone, hydroxybenzyl alcohol, methylhydroquinone, methylene-2,4,6-trihydroxybenzoate, fluoroglucinol, pyrogallol, resorcinol, α-(1-aminoethyl)-p-hydroxybenzyl alcohol, and 3-amino-4-hydroxyphenyl sulfone. In addition, xylylene-bis-(meth)acrylamide; adducts of novolac epoxy resins or glycidyl compounds such as bisphenol A diglycidylether and α,β-unsaturated carboxylic acids; ester compounds from acids such as phthalic acid and trimellitic acids and vinyl monomers containing a hydroxide group; diallyl phthalate, triallyl trimellitate, diallyl benzene sulfonate, cationic polymerizable divinylethers as a polymerizable monomer such as bisphenol A divinylether; epoxy compounds such as novolac epoxy resins and bisphenol A diglycidylethers; vinyl esters such as divinyl phthalate, divinyl terephthalate, and divinylbenzene-1,3-disulfonate; and styrene compounds such as divinyl benzene, p-allyl styrene, and p-isopropene styrene. Among these, the compounds expressed by the following formula (38) are preferable.

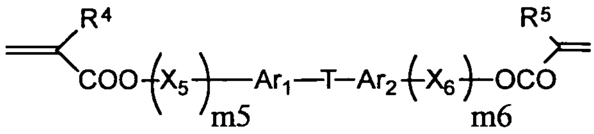

formula (38)

In the above formula (38), $R^4$ and $R^5$ represent respectively a hydrogen atom or an alkyl group.

In the above formula (38), $X_5$ and $X_6$ represent an alkylene oxide group respectively, the alkylene oxide group may be one species or two or more species. Examples of the alkylene oxide group include ethylene oxide group, propylene oxide group, butylene oxide group, pentylene oxide group, hexylene oxide group, and combined groups in random or block thereof. Among these, ethylene oxide group, propylene oxide group, butylene oxide group, and combined groups thereof are preferable; and ethylene oxide group and propylene oxide group are more preferable.

In the formula (38), m5 and m6 represent respectively an integer of 1 to 60, preferably an integer of 2 to 30, and more preferably an integer of 4 to 15.

In the formula (38), T represents a divalent connecting group such as methylene group, ethylene group, MeCMe, $CF_3CCF_3$, CO, and $SO_2$.

In the formula (38), $Ar_1$ and $Ar_2$ represent respectively an aryl group that may contain a substituted group. Examples of $Ar_1$ and $Ar_2$ include phenylene and naphthyene; and examples of the substituted group include alkyl groups, aryl groups, aralkyl groups, halogen groups, alkoxy groups, and combinations thereof.

Specific examples of the monomer containing an aryl group set forth above include 2,2-bis[4-(3-(meth)acryloxy-2-hydroxypropoxy)phenyl]propane, 2,2-bis[4-((meth)acryloxyethoxy)phenyl]propane; 2,2-bis[4-((meth)acryloyloxypolyethoxy)phenyl]propane in which the number of ethoxy groups substituted for one phenolic OH group is 2 to 20 such as 2,2-bis[4-((meth)acryloyloxydiethoxy)phenyl]propane, 2,2-bis[4-((meth)acryloyloxytetraethoxy)phenyl]propane, 2,2-bis [4-((meth)acryloyloxypentaethoxy)phenyl]propane, 2,2-bis[4-((meth)acryloyloxydecaethoxy)phenyl]propane, and 2,2-bis[4-((meth)acryloyloxypentadecaethoxy)phenyl]propane; 2,2-bis[4-((meth)acryloxypropoxy)phenyl]propane, 2,2-bis [4-((meth)acryloyloxypolypropoxy)phenyl]propane in which the number of ethoxy groups substituted for one phenolic OH group is 2 to 20 such as 2,2-bis[4-((meth)acryloyloxydipropoxy)phenyl]propane, 2,2-bis[4-((meth)acryloyloxytetrapropoxy)phenyl]propane, 2,2-bis[4-((meth)acryloyloxypentapropoxy)phenyl]propane, 2,2-bis[4-((meth)acryloyloxydecapropoxy)phenyl]propane, 2,2-bis[4-((meth)acryloyloxypentadecapropoxy)phenyl]propane; compounds having a polyethylene oxide skeleton as well as a polypropylene skeleton in one molecule as the ether site of these compounds such as described in International Publication No. WO 01/98832 and commercial products of BPE-200, BPE-500, and BPE-1000 (by Shin-nakamura Chemical Co.); and polymerizable compounds having a polyethylene oxide skeleton as well as a polypropylene skeleton. In these compounds, the site resultant from bisphenol A may be changed into the site resultant from bisphenol F, bisphenol S, or the like.

Examples of the polymerizable compounds having a polyethylene oxide skeleton as well as a polypropylene skeleton include the adducts of bisphenols and ethylene oxides or propylene oxides, and the compounds having a hydroxyl group at the end wherein the compound is formed as a polyaddition product and the compound has an isocyanate group and a polymerizable group such as 2-isocyanate ethyl(meth)acrylate and $\alpha,\alpha$-dimethylviny benzilisocyanate, and the like.

- Other Polymerizable Monomer -

In the pattern forming process according to the present invention, the polymerizable monomers other than the monomers having a urethane group or an aryl group set forth above may be employed together within a range that the properties of the pattern forming material are not degraded.

Examples of monomers other than the monomers having a urethane group or an aromatic ring include the esters between unsaturated carboxylic acids such as acrylic acid, methacrylic acid, itaconic acid, crotonic acid, and isocrotonic acid and aliphatic polyvalent alcohols, and amides between unsaturated carboxylic acids and polyvalent amines.

Examples of the esters between unsaturated carboxylic acids and aliphatic polyvalent alcohols set forth above include, as (meth)acrylate esters, ethylene glycol di(meth)acrylate, polyethylene glycol di(meth)acrylate having 2 to 18 ethylene groups such as diethylene glycol di(meth)acrylate, triethylene glycol di(meth)acrylate, tetraethylene glycol di (meth)acrylate, nonaethylene glycol di(meth)acrylate, dodecaethylene glycol di(meth)acrylate, and tetradecaethylene glycol di(meth)acrylate; propylene glycol di(meth)acrylate having 2 to 18 propylene groups such as dipropylene glycol di(meth)acrylate, tripropylene glycol di(meth)acrylate, tetrapropylene glycol di(meth)acrylate, and dodecapropylene glycol di(meth)acrylate; neopentyl glycol di(meth)acrylate, ethyleneoxide modified neopentyl glycol di(meth)acrylate, propyleneoxide modified neopentyl glycol di(meth)acrylate, trimethylolpropane tri(meth)acrylate, trimethylolpropane di (meth)acrylate, trimethylolpropane tri(meth)acryloyloxypropyl ether, trimethylolethane tri(meth)acrylate, 1,3-propanediol di(meth)acrylate, 1,3-butanediol di(meth)acrylate, 1,4-butanediol di(meth)acrylate, 1,6-hexanediol di(meth)acrylate, tetramethylene glycol di(meth)acrylate, 1,4-cyclohexanediol di(meth)acrylate, 1,2,4-butanetriol tri(meth)acrylate, 1,5-pentanediol (meth)acrylate, pentaerythritol di(meth)acrylate, pentaerythritol tri(meth)acrylate, pentaerythritol tetra(meth)acrylate, dipentaerythritol penta(meth)acrylate, dipentaerythritol hexa(meth)acrylate, sorbitol tri(meth)acrylate, sorbitol tetra (meth)acrylate, sorbitol penta(meth)acrylate, sorbitol hexa(meth)acrylate, dimethylol dicyclopentane di(meth)acrylate, tricyclodecan di(meth)acrylate, neopentylglycol modified trimethylolpropane di(meth)acrylate; di(meth)acrylates of alkyleneglycol chains having at least each one of ethyleneglycol chain and propyleneglycol chain such as those compounds described in International Publication No. WO 01/98832; tri(meth)acrylate of trimethylolpropane added by at least one of ethylene oxide and propylene oxide; polybutylene glycol di(meth)acrylate, glycerin di(meth)acrylate, glycerin tri(meth)acrylate, and xylenol di(meth)acrylate.

Among the (meth)acrylates set forth above, preferable ones in light of easy availability are ethylene glycol di (meth)acrylate, polyethylene glycol di(meth)acrylate, propylene glycol di(meth)acrylate, polypropylene glycol di(meth) acrylate, di(meth)acrylates of alkyleneglycol chains having at least each one of ethyleneglycol chain and propyleneglycol chain, trimethylolpropane tri(meth)acrylate, pentaerythritol tetra(meth)acrylate, pentaerythritol triacrylate, pentaerythritol di(meth)acrylate, dipentaerythritol penta(meth)acrylate, dipentaerythritol hexa(meth)acrylate, glycerin tri(meth)acrylate, glycerin di(meth)acrylate, 1,3-propanediol di(meth)acrylate, 1,2,4-butanetriol tri(meth)acrylate, 1,4-cyclohexanediol di (meth)acrylate, 1,5-pentanediol (meth)acrylate, neopentyl glycol di(meth)acrylate, and tri(meth)acrylate of trimethylolpropane added by ethylene oxide.

Examples of the esters between the itaconic acid and the aliphatic polyvalent alcohol compounds i.e. itaconate set forth above include ethylene glycol diitaconate, propylene glycol diitaconate, 1,3-butanediol diitaconate, 1,4-butanediol diitaconate, tetramethylene glycol diitaconate, pentaerythritol diitaconate, and sorbitol tetraitaconate.

Examples of the esters between the crotonic acid and the aliphatic polyvalent alcohol compounds i.e. crotonate set forth above include ethylene glycol dicrotonate, tetramethylene glycol dicrotonate, pentaerythritol dicrotonate, and sorbitol tetradicrotonate.

Examples of the esters between the isocrotonic acid and the aliphatic polyvalent alcohol compounds i.e. isocrotonate set forth above include ethylene glycol diisocrotonate, pentaerythritol diisocrotonate, and sorbitol tetraisocrotonate.

Examples of the esters between the maleic acid and the aliphatic polyvalent alcohol compounds i.e. maleate set forth above include ethylene glycol dimaleate, triethylene glycol dimaleate, pentaerythritol dimaleate, and sorbitol tetramaleate.

Examples of the amides derived from the polyvalent amine compounds and the unsaturated carboxylic acids set forth above include methylenebis(meth)acrylamide, ethylenebis(meth)acrylamide, 1,6-hexamethylenebis(meth)acrylamide, octamethylenebis(meth)acrylamide, diethylenetriamine tris(meth)acrylamide, and diethylenetriamine bis(meth) acrylamide.

As for the polymerizable monomers set forth above, the following compounds may be exemplified additionally: compounds that are obtained by adding $\alpha,\beta$-unsaturated carboxylic acids to compounds containing a glycidyl group such as butanediol-1,4-diglycidylether, cyclohexane dimethanol glycidylether, ethyleneglycol diglycidylether, diethyleneglycol diglycidylether, dipropyleneglycol diglycidylether, hexanediol diglycidylether, trimethylolpropane triglycidylether, pentaerythritol tetraglycidylether, and glycerin triglycidylether; polyester acrylates and polyester (meth)acrylate oligomers described in JP-A No. 48-64183, and JP-B Nos. 49-43191 and 52-30490; multifunctional acrylate or methacrylate such as epoxy acrylates obtained from the reaction between methacrylic acid epoxy compounds such as butanediol-1,4-diglycidylether, cyclohexane dimethanol glycidylether, diethyleneglycol diglycidylether, dipropyleneglycol diglycidylether, hexanediol diglycidylether, trimethylolpropane triglycidylether, pentaerythritol tetraglycidylether, and glycerin triglycidylether; photocurable monomers and oligomers described in Journal of Adhesion Society of Japan, Vol. 20, No. 7, pp. 300-308 (1984); allyl esters such as diallyl phthalate, diallyl adipate, and diallyl malonate; diallyl amides such as diallyl acetamide; cationic polymerizable divinylethers such as butanediol-1,4-divinylether, cyclohexane dimethanol divinylether, ethyleneglycol divinylether, diethyleneglycol divinylether, dipropyleneglycol divinylether, hexanediol divinylether, trimethylolpropane trivinylether, pentaerythritol tetravinylether, and glycerin vinylether; epoxy compounds such as butanediol-1,4-diglycidylether, cyclohexane dimethanol glycidylether, ethyleneglycol diglycidylether, diethyleneglycol diglycidylether, dipropyleneglycol diglycidylether, hexanediol diglycidylether, trimethylolpropane triglycidylether, pentaerythritol tetraglycidylether, and glycerin triglycidylether; oxetanes such as 1,4-bis[(3-ethyl-3-oxetanylmethoxy)methyl] benzene and those described in International Publication No. WO 01/22165; compounds having two or more of ethylenically unsaturated double bonds of different types such as N-$\beta$-hydroxyethyl-$\beta$-methacrylamide ethylacrylate, N,N-bis ($\beta$-methacryloxyethyl)acrylamide, acrylmetahcrylate.

Examples of vinyl esters set forth above include divinyl succinate and divinyl adipate.

These polyfunctional monomers or oligomers may be used alone or in combination with two or more.

The polymerizable monomers set forth above may be combined with a polymerizable compound having one polymerizable group in the molecule, i.e. monofunctional monomer.

Examples of the mono functional monomers include the compounds exemplified as the raw materials for the binder set forth above, dibasic monofunctional monomer such as mono-(meth)acryloyloxyalkylester, mono-hydroxyalkylester, and γ-chloro-β-hydroxypropyl-β'-methacryloyloxyethyl-o-phthalate, and the compounds described in JP-A No. 06-236031, JP-B Nos. 2744643 and 2548016, and International Publication No. WO 00/52529.

Preferably, the content of the polymerizable compound in the photosensitive composition is 5 % by mass to 60 % by mass, more preferably 15 % by mass to 60 % by mass, and still more preferably 20 % by mass to 50 % by mass.

When the content is less than 5 % by mass, the strength of the tent film may be lower, and when the content is more than 90 % by mass, the edge fusion during storage period is insufficient and bleeding trouble may be induced.

The content of the polyfunctional monomer having two or more polymerizable groups set forth above in the molecule is preferably 5 % by mass to 100 % by mass, more preferably 20% by mass to 100 % by mass, and still more preferably 40 % by mass to 100 % by mass.

-- Photopolymerization Initiator for Dry Film Resist -

The photopolymerization initiator may be properly selected from conventional ones without particular limitations as long as it has the property to initiate polymerization. And It is preferably the initiator that exhibits photosensitivity to light ranging from ultraviolet rays to visual lights. The initiator may be an active substance that generates a radical due to an effect with a photo-exited photosensitizer, or a substance that initiates cation polymerization depending on the monomer species.

Preferably, the photopolymerization initiator contains at least one component that has a molecular extinction coefficient of about 50 $M^{-1}cm^{-1}$ in a range of about 300 nm to 800 nm, more preferably about 330 nm to 500 nm.

Examples of the photopolymerization initiator include halogenated hydrocarbon derivatives such as having a triazine skeleton or an oxadiazole skeleton, hexaaryl-biimidazoles, oxime derivatives, organic peroxides, thio compounds, ketone compounds, aromatic onium salts, and metallocenes. Among these compounds, halogenated hydrocarbon compounds having a triazine skeleton, oxime derivatives, ketone compounds, and hexaaryl-biimidazol compounds are preferable from the perspective of sensitivity of the photosensitive composition, self stability, adhesive ability between the photosensitive layers, which will be described below, and substrates for printed wiring boards.

Examples of the hexaaryl-biimidazol compounds include 2,2'-bis(2-chlorophenyl)-4,4',5,5'-tetraphenyl-biimidazole, 2,2'-bis(o-fluorophenyl)-4,4',5,5'-tetraphenyl-biimidazole, 2,2'-bis(o-bromophenyl)-4,4',5,5'-tetraphenyl-biimidazole, 2,2'-bis(2,4-dichlorophenyl)-4,4',5,5'-tetraphenyl-biimidazole, 2,2'-bis(2-chlorophenyl)-4,4',5,5'-tetra(3-methoxyphenyl)biimida zole, 2,2'-bis(2-chlorophenyl)-4,4',5,5'-tetra(4-methoxyphenyl)biimida zole, 2,2'-bis(4-emthoxyphenyl)-4,4',5,5'-tetraphenyl-biimidazole, 2,2'-bis(2,4-dichlorophenyl)-4,4',5,5'-tetraphenyl-biimidazole, 2,2'-bis(2-nitrophenyl)-4,4',5,5'-tetraphenyl-biimidazole, 2,2'-bis(2-methylphenyl)-4,4',5,5'-tetraphenyl-biimidazole, 2,2'-bis(2-trifluoromethylphenyl)-4,4',5,5'-tetraphenyl-biimidazo le, and the compounds described in International Publication No. WO 00/52529.

The biimidazoles set forth above can be easily prepared by the methods described, for example, in Bulletin of the Chemical Society of Japan, 33, 565 (1960) and Journal of Organic Chemistry, 36, [16], 2262 (1971).

Examples of the halogenated hydrocarbon compounds having a triazine skeleton include the compounds described in Bulletin of the Chemical Society of Japan, by Wakabayasi, 42, 2924 (1969); GB Pat. No.1388492; JP-A No. 53-133428; DE Pat. No. 3337024; Journal of Organic Chemistry, by F.C. Schaefer et. al. 29,1527 (1964); JP-A Nos. 62-58241, 5-281728, and 5-34920; and US Pat. No. 4212976.

Examples of the compounds described in Bulletin of the Chemical Society of Japan, by Wakabayasi, 42, 2924 (1969) set forth above include 2-phenyl-4,6-bis(trichloromethyl)-1,3,5-triazine, 2-(4-chlorophenyl)-4,6-bis(trichloromethyl)-1,3,5-triazine, 2-(4-tolyl)-4,6-bis(trichloromethyl)-1,3,5-triazine, 2-(4-methoxyphenyl)-4,6-bis(trichloromethyl)-1,3,5-triazine, 2-(2,4-dichlorophenyl)-4,6-bis(trichloromethyl)-1,3,5-triazine, 2,4,6-tris(trichloromethyl)-1,3,5-triazine, 2-methyl-4,6-bis(trichloromethyl)-1,3,5-triazine, 2-n-nonyl-4,6-bis(trichloromethyl)-1,3,5-triazine, and 2-(α,α,β-trichloroethyl)-4,6-bis(trichloromethyl)-1,3,5-triazine.

Examples of the compounds described in GB Pat. No.1388492 set forth above include 2-styryl-4,6-bis(trichloromethyl)-1,3,5-triazine, 2-(4-methylstyryl)-4,6-bis(trichloromethyl)-1,3,5-triazine, 2-(4-methoxystyryl)-4,6-bis(trichloromethyl)-1,3,5-triazine, and 2-(4-methoxystyryl)-4-amino-6-trichloromethyl-1,3,5-triazine.

Examples of the compounds described in JP-A No. 53-133428 set forth above include 2-(4-methoxynaphtho-1-yl)-4,6-bistrichloromethyl-1,3,5-triazine, 2-(4-ethoxynaphtho-1-yl)-4,6-bistrichloromethyl-1,3,5-triazine, 2-[4-(2-ethoxyethyl)-naphtho-1-yl]-4,6-bistrichloromethyl-1,3,5-triazine, 2-(4,7-dimethoxynaptho-1-yl)-4,6-bistrichloromethyl-1,3,5-triazine, and 2-(acenaphtho-5-yl)-4,6-bistrichloromethyl-1,3,5-triazine.

Examples of the compounds described in DE Pat. No. 3337024 set forth above include 2-(4-styrylphenyl)-4,6-bis(trichloromethyl)-1,3,5-triazine, 2-(4-(4-methoxystyryl)phenyl)-4,6-bis(trichloromethyl)-1,3,5-triazine, 2-(1-naphthylvinylenephenyl)-4,6-bis(trichloromethyl)-1,3,5-triazine, 2-chlorostyrylphenyl-4,6-bis(trichloromethyl)-1,3,5-triazine,

2-(4-thiophene-2-vinylenephenyl)-4,6-bis(trichloromethyl)-1,3,5-triazine, 2-(4-thiophene-3-vinylenephenyl)-4,6-bis(trichloromethyl)-1,3,5-triazine, 2-(4-furan-2-vinylenephenyl)-4,6-bis(trichloromethyl)-1,3,5-triazine, and 2-(4-benzofuran-2-vinylenephenyl)-4,6-bis(trichloromethyl)-1,3,5-triazine.

Examples of the compounds described in Journal of Organic Chemistry, by F.C. Schaefer et. al. 29, 1527 (1964) set forth above include 2-methyl-4,6-bis(tribromomethyl)-1,3,5-triazine, 2,4,6-tris(tribromomethyl)-1,3,5-triazine, 2,4,6-tris(dibromomethyl)-1,3,5-triazine, 2-amino-4-methyl-6-tribromomethyl-1,3,5-triazine and 2-methoxy-4-methyl-6-trichloromethyl-1,3,5-triazine.

Examples of the compounds described in JP-A No. 62-58241 set forth above include 2-(4-phenylethylphenyl)-4,6-bis(trichloromethyl)-1,3,5-triazine, 2-(4-naphthyl-1-ethynylphenyl)-4,6-bis(trichloromethyl)-1,3,5-triazine, 2-(4-(4-triethynyl)phenyl)-4,6-bis(trichloromethyl)-1,3,5-triazine, 2-(4-(4-methoxyphenyl)ethynylphenyl)-4,6-bis(trichloromethyl)-1,3,5-triazine, 2-(4-(4-isopropylphenylethynyl)phenyl)-4,6-bis(trichloromethyl)-1,3,5-triazine, and 2-(4-(4-ethylphenylethynyl)phenyl)-4,6-bis(trichloromethyl)-1,3,5-triazine.

Examples of the compounds described in JP-A No. 05-281728 set forth above include 2-(4-trifluoromethylphenyl)-4,6-bis(trichloromethyl)-1,3,5-triazine, 2-(2,6-difluorophenyl)-4,6-bis(trichloromethyl)-1,3,5-triazine, 2-(2,6-dichlorophenyl)-4,6-bis(trichloromethyl)-1,3,5-triazine, and 2-(2,6-dibromophenyl)-4,6-bis(trichloromethyl)-1,3,5-triazine.

Examples of the compounds described in JP-A No. 5-34920 set forth above include 2,4-bis(trichloromethyl)-6-[4-(N,N-diethoxycarbonylmethylamino)-3-bromophenyl]-1,3,5-triazine, trihalomethyl-s-triazine compounds described in US Pat. No. 4239850, and also 2,4,6-tris(trichloromethyl)-s-triazine, and 2-(4-chlorophenyl)-4,6-bis(tribromomethyl)-s-triazine.

Examples of the compounds described in US Pat. No. 4212976 set forth above include the compounds having an oxadiazole skeleton such as 2-trichloromethyl-5-phenyl-1,3,4-oxadiazole, 2-trichloromethyl-5-(4-chlorophenyl)-1,3,4-oxadiazole, 2-trichloromethyl-5-(1-naphthyl)-1,3,4-oxadiazole, 2-trichloromethyl-5-(2-naphthyl)-1,3,4-oxadiazole, 2-tribromomethyl-5-phenyl-1,3,4-oxadiazole, 2-tribromomethyl-5-(2-naphthyl)-1,3,4-oxadiazole, 2-trichloromethyl-5-styryl-1,3,4-oxadiazole, 2-trichloromethyl-5-(4-chlorostyryl)-1,3,4-oxadiazole, 2-trichloromethyl-5-(4-methoxystyryl)-1,3,4-oxadiazole, 2-trichloromethyl-5-(1-naphthyl)-1,3,4-oxadiazole, 2-trichloromethyl-5-(4-n-butoxystyryl)-1,3,4-oxadiazole, and 2-tribromomethyl-5-styryl-1,3,4-oxadiazole.

Examples of the oxime derivatives set forth above include the compounds expressed by the following formulas (39) to (72).

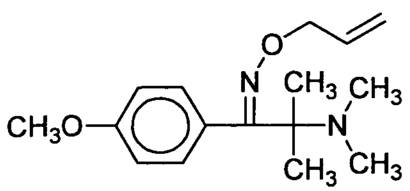

formula (39)

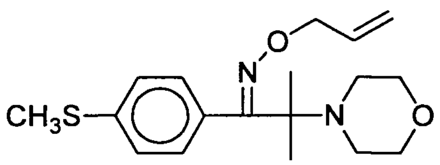

formula (40)

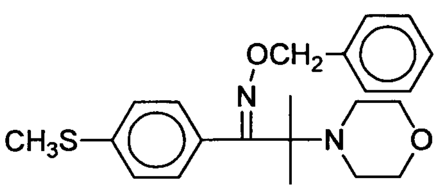

formula (41)

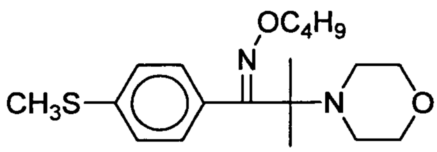

formula (42)

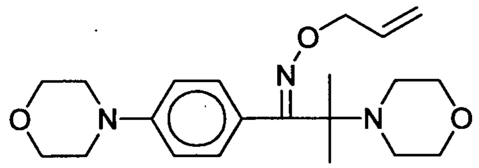

formula (43)

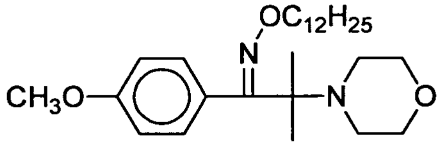

formula (44)

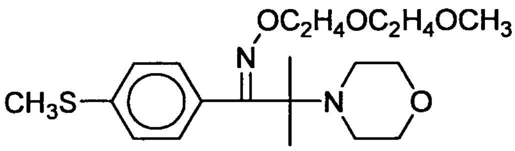

formula (45)

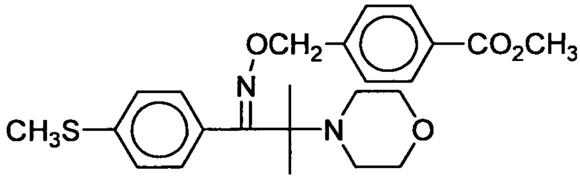

formula (46)

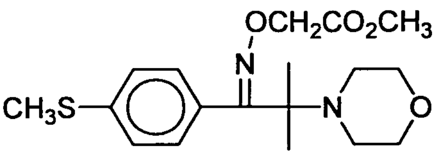

formula (47)

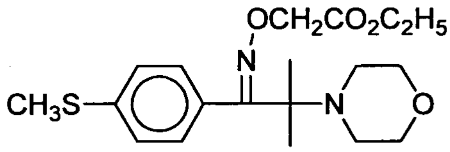

formula (48)

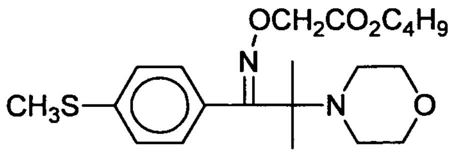

formula (49)

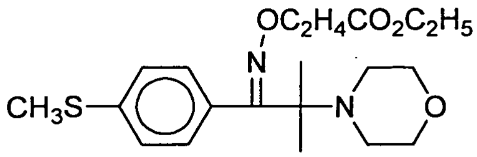

formula (50)

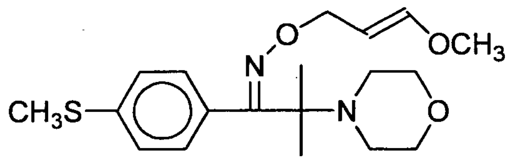

formula (51)

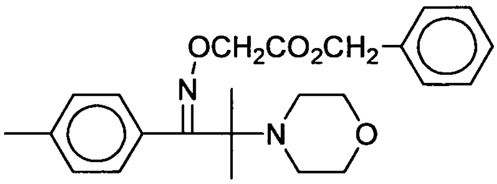

formula (52)

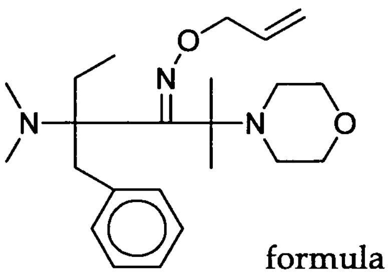

formula (53)

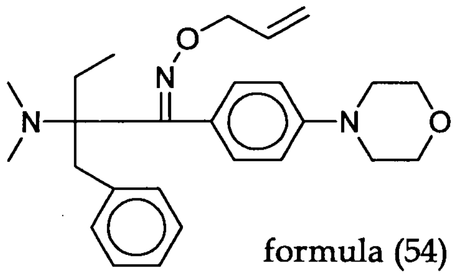

formula (54)

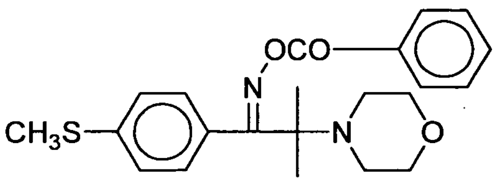

formula (55)

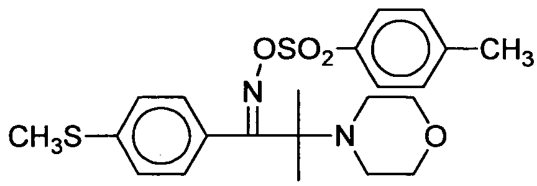

formula (56)

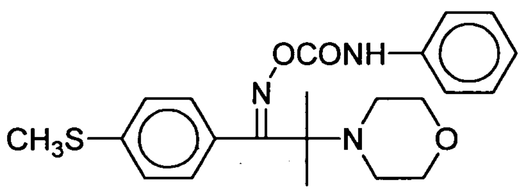

formula (57)

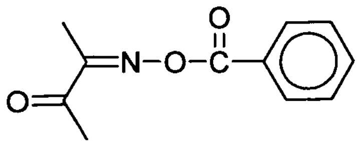

formula (58)

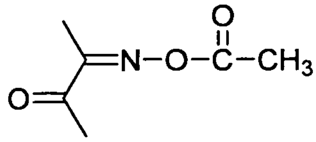

formula (59)

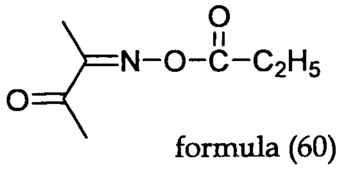

formula (60)

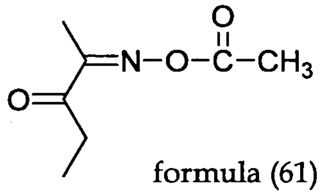

formula (61)

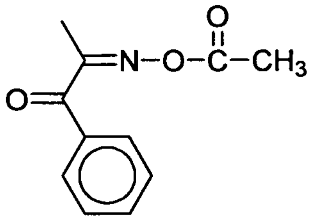

formula (62)

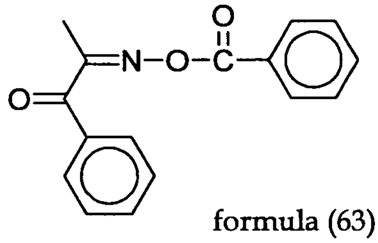

formula (63)

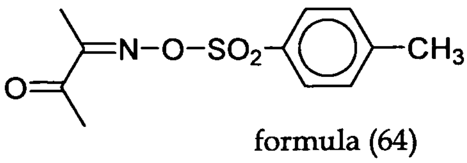

formula (64)

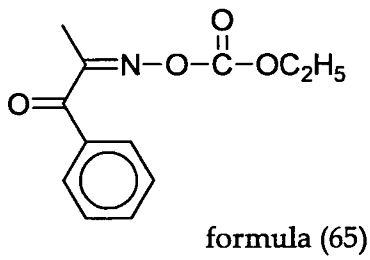

formula (65)

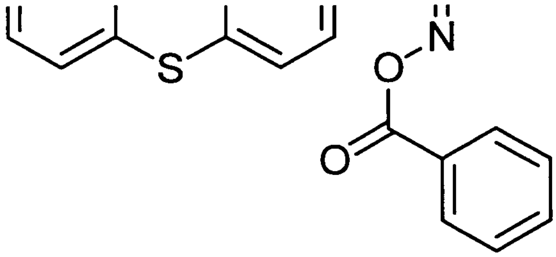

formula (66)

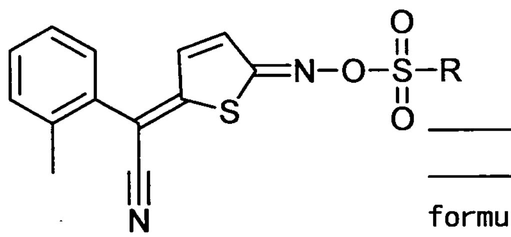

| R | |
|---|---|
| formula (67) | $n\text{-}C_3H_7$ |
| formula (68) | $n\text{-}C_8H_{17}$ |
| formula (69) | camphor |
| formula (70) | $p\text{-}CH_3C_6H_4$ |

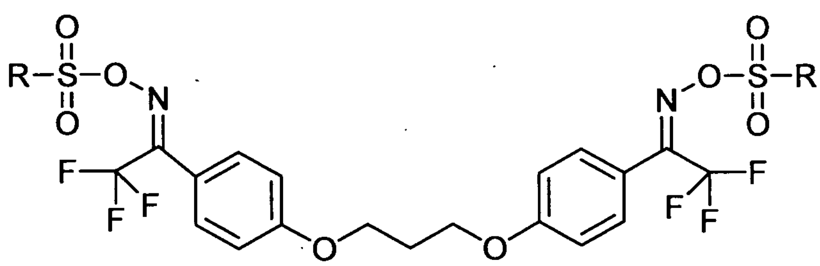

| R | |
|---|---|
| formula (71) | $n\text{-}C_3H_7$ |
| formula (72) | $p\text{-}CH_3C_6H_4$ |

Examples of the ketone compounds set forth above include benzophenone, 2-methylbenzophenone, 3-methylbenzophenone, 4-methylbenzophenone, 4-methoxybenzophenone, 2-chlorobenzophenone, 4-chlorobenzophenone, 4-bromobenzophenone, 2-carboxybenzophenone, 2-ethoxycarbonylbenzophenone, benzophenone-tetracarboxylic acid and its tetramethyl ester; 4,4'-bis(dialkylamino)benzophenones such as 4,4'-bis(dimethylamino)benzophenone, 4,4'-bis(dicyclohexylamino)benzophenone, 4,4'-bis(diethylamino)benzophenone, 4,4'-bis(dihydroxyethylamino)benzophenone, 4-methoxy-4'-dimethylaminobenzophenone, 4,4'-dimethoxybenzophenone, and 4-dimethylaminobenzophenone; 4-dimethylaminoacetophenone, benzyl, anthraquinone, 2-tert-butylanthraquinone, 2-methylanthraquinone, phenanthraquinone, xanthone, thioxanthone, 2-chlorothioxanthone, 2,4-diethylthioxanthone, fluorene, 2-benzyl-dimethylamino-1-(4-morpholinophenyl)-1-butanone, 2-methyl-1-[4-(methylthio)phenyl]-2-morpholino-1-propanone, 2-hydroxy-2-methyl-[4-(1-methylvinyl)phenyl]propanol oligomer, benzoin; benzoin ethers such as benzoin methylether, benzoin ethylether, benzoin propylether, benzoin isopropylether, benzoin phenylether, and benzyl dimethyl ketal; acridone, chloroacridone, N-methylacridone, N-butylacridone, and N-butyl-chloroacridone.

Examples of the metallocenes include bis(η5-2,4-cyclopentadiene-1-yl)-bis(2,6-difluoro-3-(1H-pyrrole-1-yl)-phenyl)titanium, η5-cyclopentadienyl-η6-cumenyl-iron(1+)-hexafluorophosphate(1-), and the compounds described in JP-A No. 53-133428, JP-B Nos. 57-1819 and 57-6096, and US Pat. No. 3615455.

As for photopolymerization initiators other than set forth above, the following substances are further exemplified: acridine derivatives such as 9-phenyl acridine and 1,7-bis(9,9'-acridinyl)heptane, and N-phenylglycine; polyhalogenated compounds such as carbon tetrabromide, phenyltribromosulfone, and phenyltrichloromethylketone; coumarins such as 3-(2-benzofuroyl)-7-diethylaminocoumarin, 3-(2-benzofuroyl)-7-(1-pyrrolidinyl)coumarin, 3-benzoyl-7-diethylaminocoumarin, 3-(2-methoxybenzoyl)-7-diethylaminocoumarin, 3-(4-dimethylaminobenzoyl)-7-diethylaminocoumarin, 3,3'-carbonylbis(5,7-di-n-propoxycoumarin), 3,3'-carbonylbis(7-diethylaminocoumarin), 3-benzoyl-7-methoxycoumarin, 3-(2-furoyl)-7-diethylaminocoumarin, 3-(4-diethylaminocinnamoyl)-7-diethylaminocoumarin, 7-methoxy-3-(3-pyridylcarbonyl)coumarin, 3-benzoyl-5,7-dipropoxycoumarin, and 7-benzotriazol-2-ylcoumarin, and also the coumarin compounds

described in JP-A Nos. 5-19475, 7-271028, 2002-363206, 2002-363207, 2002-363208, and 2002-363209; amines such as ethyl 4-dimethylaminobenzoate, n-butyl 4-dimethylaminobenzoate, phenethyl 4-dimethylaminobenzoate, 2-phthalimide 4-dimethylaminobenzoate, 2-methacryloyloxyethyl 4-dimethylaminobenzoate, pentamethylene-bis(4-dimethylaminobenzoate), phenethyl 3-dimethylaminobenzoate, pentamethylene esters, 4-dimethylamino benzaldehyde, 2-chloro-4-dimethylamino benzaldehyde, 4-dimethylaminobenzyl alcohol, ethyl(4-dimethylaminobenzoyl)acetate, 4-piperidine acetophenone, 4-dimethyamino benzoin, N,N-dimethyl-4-toluidine, N,N-diethyl-3-phenetidine, tribenzylamine, dibenzylphenylamine, N-methyl-N-phenylbenzylamine, 4-bromo-N,N-diethylaniline, and tridodecyl amine; amino fluorans such as ODB and ODBII; crystal violet lactone such as leucocrystal violet; acylphosphine oxides such as bis(2,4,6-trimethylbenzoyl)phenylphosphine oxide, bis(2,6-dimethylbenzoyl)-2,4,4-trimethyl-pentylphenylphosphine oxide, and Lucirin TPO.

In addition, as for still other photopolymerization initiators, the following substances are exemplified: vicinal polyketaldonyl compounds as described in US Pat. No. 2367660; acyloin ether compounds as described in US Pat. No. 2448828; aromatic acyloin compounds substituted with an $\alpha$-hydrocarbon as described in US Pat. No. 2722512; polynucleic quinone compounds as described in US Pat. Nos. 3046127 and 2951758; various substances described in JP-A No. 2002-229194 such as organic boron compounds, radical generators, triarylsulfonium salts e.g. salts with hexafluoroantimony or hexafluorophosphate, phosphonium salts e.g. (phenylthiophenyl)diphenylsulfonium salt (effective as cation polymerization initiator), and onium salt compounds described in International Publication No. WO 01/71428.

These photopolymerization initiators may be used alone or in combination with two or more. The combination of two or more photopolymerization initiators may be for example the combination of hexaaryl-biimidazol compounds and 4-amino ketones described in US Pat. No. 3549367; combination of benzothiazole compounds and trihalomethyl-s-triazine compounds as described in JP-B No. 51-48516; combination of aromatic ketone compounds such as thioxanthone and hydrogen donating substance such as dialkylamino-containing compounds or phenol compounds; combination of hexaaryl-biimidazol compounds and titanocens; and combination of coumarins, titanocens, and phenyl glycines.

The content of the photopolymerization initiator in the photosensitive composition is preferably 0.1 % by mass to 30 % by mass, more preferably 0.5 % by mass to 20 % by mass, and still more preferably 0.5 % by mass to 15 % by mass.

- Photosensitizer for Dry Film Resist -

The photosensitizer may be excited by active energy ray, and may generate a radical, an available acidic group and the like through interaction with other substances such as radical generators and acid generators by transferring energy or electrons. The photosensitizer is preferably used in combination with the components set forth above in that the value of $S_{410}/S_{400}$ can be easily adjusted to 0.6 to 1.4.

The maximum absorption wavelength in the photosensitizer is not particularly limited and may be suitably selected in accordance with the intended use. For example, the maximum absorption wavelength is preferably 380 nm to 420 nm, more preferably 390 nm to 415 nm, and still more preferably 395 to 415.

The photosensitizer having an absorption wavelength of 380 nm to 420 nm is not particularly limited and can be suitably selected from among photosensitizers known in the art. Examples thereof include conventional polynucleic aromatic series such as pyrene, perylene, and triphenylene; xanthenes such as fluorescein, eosine, erythrosine, Rhodamine B, rose bengal; cyanines such as indocarbocyanine, thiacarbocyanine, and oxacarbocyanine); merocyanines such as merocyanine, and carbomerocyanine; thiazines such as thionine, methylene blue, Toluidine blue; acridines such as acridine orange, chloroflavin, and acryflavin; anthraquinones such as anthraquinon; squaryliums such as squarylium, acridones such as acridone, chloroacridone, N-methylacridone, N-butylacridone, N-butyl-chloroacridone, 2-chloro-10-butylacridone, and 10-N-butyl-2-chloroacridone); coumarins such as 3-(2-benzofuroyl)-7-diethylaminocoumarin, 3-(4-dimethylaminobenzoyl)-7-diethylaminocoumarin, 3-(4-dimethylaminobenzoyl)-7-diethylaminocoumarin, 3,3'-carbonylbis(5,7-di-n-propoxycoumarin), 3,3'-carbonylbis (7-diethylaminocoumarin), 3-benzoyl-7-methoxycoumarin, 3-(2-furoyl)-7-diethylaminocoumarin, 3-(4-diethylaminocinnamoyl)-7-diethylaminocoumarin, 7-methoxy-3-(3-pyridylcarbonyl) coumarin, 3-benzoyl-5,7-dipropoxycoumarin, and coumarin compounds described in Japanese Patent Application Laid-Open (JP-A) Nos. 05-19475, 07-271028, 2002-363206, 2002-363207, 2002-363208, and 2002-263209.

As for the combination of the photopolymerization initiator and the photosensitizer, the initiating mechanism that involves electron transfer may be exemplified such as combinations of (1) an electron donating initiator and a photosensitizer dye, (2) an electron accepting initiator and a photosensitizer dye, and (3) an electron donating initiator, a photosensitizer dye, and an electron accepting initiator (ternary initiating mechanism) as described in JP-A No. 2001-305734.

- Other Components for Dry Film Resist -

As for the other components, polymerization inhibitor, surfactant, plasticizer, coloring agent, and colorant are exemplified; in addition, adhesion promoter for substrate surface and the other auxiliaries such as pigment, conductive

particles, filler, defoamer, fire retardant, leveling agent, peeling promoter, antioxidant, perfume, thermocrosslinker, adjustor of surface tension, chain transfer agent may be utilized together with the photopolymerization initiators set forth above.

-- Polymerization Inhibitor --

The polymerization inhibitor is not particularly limited and may be suitably selected in accordance with the intended use. Examples of the polymerization inhibitor include 4-methoxyphenol, hydroquinone, alkyl or aryl group-substituted hydroquinone, t-butyl catechol, pyrogallol, 2-hydroxybenzophenone, 4-methoxy-2-hydroxybenzophenone, cuprous chloride, phenothiazine, chloranil, naphthylamine, β-naphthol, 2,6-di-t-butyl-4-cresol, 2,2'-methylenbis (4-methyl-6-t-butylphenol), pyridine, nitrobenzene, dinitrobenzene, picric acid, 4-toluidine, methylene blue, reactants between copper and organic chelate agent, methyl salicylate, phenothiazine, nitroso compounds, and chelates between nitroso compound and Al.

Typically, the polymerization initiators may degrade the sensitivity of the photosensitive composition when contained in the photosensitive composition, however, it is preferred that they have at least any one of aromatic rings, heterocyclic rings, imino groups, and phenolic hydroxyl groups in that degradation of the sensitivity can be restrained, and the resolution can be improved. Among them, the compounds represented by the following formula (73) are more preferable.

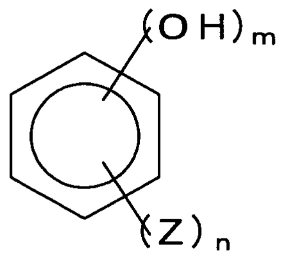

formula (73)

In the formula (73), "Z" represents a halogen atom, a hydrogen atom or a group selected from alkyl groups having 1 to 20 carbon atoms, cycloalkyl groups having 3 to 10 carbon atoms, amino groups, phenyl groups that may be substituted with alkyl groups having 1 to 20 carbon atoms, aryl groups such as naphthyl group, amino group, mercapto group, alkyl mercapto groups having 1 to 10 carbon atoms, carboxy alkyl groups having 1 to 10 carbon atoms at the alkyl group, and alkoxy groups having 1 to 20 carbon atoms, or groups having heterocyclic rings. Among them, alkyl groups are preferable; "m" represents an integer of 2 or more; and "n" represents an integer of zero or more. The integers for "m" and "n" are preferably selected so as to satisfy the equation, $m + n = 6$. When "n" is an integer of 2 or more, the alkylene oxide groups "X" may be identical to or different from each other. When the integer "m" is less than 2, the resolution may degrade.

Examples of the halogen atom include fluorine, chlorine, bromine, iodine, and astatine.

Examples of the alkyl groups having 1 to 20 carbon atoms include methyl groups, ethyl groups, propyl groups, isopropyl groups, butyl groups, sec-butyl groups, tert-butyl groups, pentyl groups, hexyl groups, heptyl groups, octyl groups, nonyl groups, decyl groups, undecyl groups, tridecyl groups, tetradecyl groups, pentadecyl groups, octadecyl groups, nonadecyl groups, and icosyl groups.

Examples of the cycloalkyl groups having 3 to 10 carbon atoms include cyclo propyl group, cyclo butyl group, cyclo pentyl group, cyclo hexyl group, and cyclo octyl group.

Examples of the aryl groups that may be substituted with alkyl groups having 1 to 20 include methylphenyl groups, ethylphenyl groups, and propylphenyl groups.

Examples of the alkyl mercapto groups having 1 to 10 carbon atoms include methyl mercapto groups, ethyl mercapto groups, and propyl mercapto groups.

Examples of the carboxy alkyl groups having 1 to 10 carbon atoms at the alkyl group include carboxy methyl group, carboxy ethyl group, carboxy propyl group, and carboxy butyl group.

Examples of the alkoxy groups having 1 to 20 carbon atoms include methoxy group, ethoxy group, propoxy group, and butoxy group.

Examples of the groups having heterocyclic rings include ethylene oxide group, furan group, thiophene group, pyrrole group, thiazole group, indole group, and quinoline group.

Examples of the compounds represented by the formula (73) include alkyl catechol (such as catechol, resorcinol,

1,4-hydroquinone, 2-methyl catechol, 3-methyl catechol, 4-methyl catechol, 2-ethyl catechol, 3-ethyl catechol, 4-ethyl catechol, 2-propyl catechol, 3-propyl catechol, 4-propyl catechol, 2-n-butyl catechol, 3-n-butyl catechol, 4-n-butyl catechol, 2-tert-butyl catechol, 3-tert-butyl catechol, 4-tert-butyl catechol, and 3,5-di-tert-butyl catechol); alkyl resorcinol (such as 2-methyl resorcinol, 4-methyl resorcinol, 2-ethyl resorcinol, 4-ethyl resorcinol, 2-propyl resorcinol, 4-propyl resorcinol, 2-n-butyl resorcinol, 4-n-butyl resorcinol, 2-tert-butyl resorcinol, and 4-tert-butyl resorcinol), alkyl hydroquinone (such as methyl hydroquinone, ethyl hydroquinone, propyl hydroquinone, tert-butyl hydroquinone, and 2,5-di-tert-butyl hydroquinone), pyrogallol, and phloroglucin.

The content of the photopolymerization initiator relative to the polymerizable compound in the photosensitive composition is preferably 0.005% by mass to 0.5% by mass, more preferably 0.01% by mass to 0.2% by mass, and still more preferably 0.02% by mass to 0.1% by mass.

When the content is less than 0.005% by mass, the stability during storage period may degrade. When the content is more than 0.5% by mass, the sensitivity to active energy ray may decrease.

-- Plasticizer --

The plasticizer set forth above may be incorporated into in order to adjust the film property i.e. flexibility of the photosensitive layer, which will be described below.

Examples of the plasticizer include phthalic acid esters such as dimethylphthalate, dibutylphthalate, diisobutylphthalate, diheptylphthalate, dioctylphthalate, dicyclohexylphthalate, ditridecylphthalate, butylbenzylphthalate, diisodecylphthalate, diphenylphthalate, diallylphthalate, and octylcaprylphthalate; glycol esters such as triethyleneglycol diacetate, tetraethyleneglycol diacetate, dimethylglycose phthalate, ethylphthalyl ethylglycolate, methylphthalyl ethylglycolate, buthylphthalyl buthylglycolate, triethylene glycol dicaprylate; phosphoric acid esters such as tricresylphosphate and triphenylphosphate; amides such as 4-toluenesulfone amide, benzenesulfone amide, N-n-butylsulfone amide, and N-n-aceto amide; aliphatic dibasic acid esters such as diisobutyl adipate, dioctyl adipate, dimethyl sebacate, dibutyl sebacate, dioctyl sebacate, and dibutyl maleate; triethyl citrate, tributyl citrate, glycerin triacetyl ester, butyl laurate, 4,5-diepoxy-cyclohexane-1,2-dicarboxylic acid dioctyl; and glycols such as polyethylene glycol and polypropylene glycol.

The content of the plasticizer relative to the total components of the photosensitive composition is preferably 0.1 % by mass to 50 % by mass, more preferably 0.5 to 40 % by mass, and still more preferably 1 % by mass to 30 % by mass.

- Coloring Agent --

The coloring agent may be utilized to provide visible images or to impart developing property to the photosensitive layer to be hereinafter descrived, after exposure.

Examples of the coloring agent include aminotriarylmethanes such as tris(4-dimethylaminophenyl)methane (leucocrystal violet), tris(4-diethylaminophenyl)methane, tris(4-dimethylamino-2-methylphenyl)methane, tris(4-diethylamino-2-methylphenyl)methane, bis(4-dibutylaminophenyl)-[4-(2-cyanoethyl)methylaminophenyl]methane, bis(4-dimethylaminophenyl)-2-quinolylmethane, and tris(4-dipropylaminophenyl)methane; aminoxanthenes such as 3,6-bis(diethylamino)-9-phenylxanthene and 3-amino-6-dimethylamino-2-methyl-9-(o-chlorophenyl)xanthene; aminothioxanthenes such as 3,6-bis(diethylamino)-9-(2-ethoxycarbonylphenyl)thioxanthene and 3,6-bis(dimethylamino)thioxanthene; amino-9,10-dihydroacridines such as 3,6-bis(diethylamino)-9,10-dihydro-9-phenylacridine and 3,6-bis(benzylamino)-9,10-dihydro-9-methylacridine; aminophenoxazines such as 3,7-bis(diethylamino)phenoxazines; aminophenothiazines such as 3,7-bis(ethylamino)phenothiazine; aminodihydrophenazines such as 3,7-bis(diethylamino)-5-hexyl-5,10-dihydrophenazine; aminophenylmethanes such as bis(4-dimethylaminophenyl)anilinomethane; aminohydrocinnamic acids such as 4-amino-4'-dimethylaminodiphenylamine and 4-amino-$\alpha$,$\beta$-dicyanohydrocinnamate methyl ester; hydrazines such as 1-(2-naphthyl)2-phenylhydrazine; amino-2,3-dihydroanthraquinones such as 1,4-bis(ethylamino)-2,3-dihydroanthraquinone; phenethylanilines such as N,N-diethyl-p-phenethylaniline; acyl derivatives of leuco dyes containing a basic NH group such as 10-acetyl-3,7-bis(dimethylamino)phenothiazine; leuco-like compounds with no oxidizable hydrogen and capable of being oxidized into colored compounds such as tris(4-diethylamino-2-tolyl)ethoxycarbonylmethane; leucoindigoid dyes; organic amines capable of being oxidized to colored forms as described in US Pat. Nos. 3042515 and 3042517 such as 4,4'-ethylenediamine, diphenylamine, N,N-dimethylaniline, 4,4'-methylenediamintriphenylamine, and N-vinylcarbazole. Among these coloring agents, triarylmethane compounds such as leucocrystal violet are preferable in particular.

In addition, it is known that the coloring agents set forth above may be combined with halogenated compounds in order to develop a color from the leuco compounds.

Examples of the halogenated compounds include halogenated hydrocarbons such as tetrabromocarbon, iodoform, ethylene bromide, methylene bromide, amyl bromide, isoamyl bromide, amyl iodide, isobutylene bromide, butyl iodide, diphenylmethyl bromide, hexachloromethane, 1,2-dibromoethane, 1,1,2,2-tetrabromoethane, 1,2-dibromo-1,1,2-trichloroethane, 1,2,3-tribromopropane, 1-bromo-4-chlorobutane, 1,2,3,4-tetrabromobutane, tetrachlorocyclopropene, hexachlorocyclopentadiene, dibromocyclohexane, and 1,1,1-trichloro-2,2-bis(4-chlorophenyl)ethane; halogenated alcohol compounds such as 2,2,2,-trichloroethanol, tribromoethanol, 1,3-dichloro-2-propanol, 1,1,1-trichloro-2-propanol, di(iodohexamethylene)aminoisopropanol, tribromo-tert-butyl alcohol, and 2,2,3-trichlorobutane-1,4-diol; halogenated carbonyl compounds such as 1,1-dichloroacetone, 1,3-dichloroacetone, hexachloroacetone, hexabromoacetone, 1,1,3,3-tetrachloroacetone, 1,1,1-trichloroacetone, 3,4-dibromo-2-butanone, and 1,4-dichloro-2-butanone-dibromocyclohexanone; halogenated ether compounds such as 2-bromoethyl methylether, 2-bromoethyl ethylether, di(2-bromoethyl) ether, and 1,2-dichloroethyl ethylether; halogenated ester compounds such as bromoethyl acetate, ethyl trichloroacetate, trichloroethyl trichloroacetate, homo-and co-polymers of 2,3-dibromopropyl acrylate, trichloroethyl dibromopropionate, and ethyl $\alpha,\beta$-dichloroacrylate; halogenated amide compounds such as chloroacetamide, bromoacetamide, dichloroacetamide, trichloroacetamide, tribromoacetamide, trichloroethyltrichloroacetamide, 2-bromoisopropionamide, 2,2,2-trichloropropionamide, N-chlorosuccinimide, and N-bromosuccinimide; compounds containing a sulfur and/ or phosphorus atom such as tribromomethyl phenylsulfone, 4-nitrophenyltribromo methylsulfone, 4-chlorophenyltribromo methylsulfone, tris(2,3-dibromopropyl)phosphate, and 2,4-bis(trichloromethyl)-6-phenyltriazole.

In the organic halogenated compounds, preferably are those containing two or more halogen atoms that are attached to one carbon atom, more preferably are those containing three halogen atoms that are attached to one carbon atom. The organic halogenated compounds may be used alone or in combination. Among these halogenated compounds, tribromomethyl phenylsulfone and 2,4-bis(trichloromethyl)-6-phenyltriazole are preferable.

The content of the coloring agent is preferably 0.01% by mass to 20 % by mass relative to the total components of the photosensitive layer, more preferably 0.05% by mass to 10 % by mass, and still more preferably 0.1% by mass to 5 % by mass. The content of the halogenated compound is preferably 0.001% by mass to 5 % by mass relative to the total components of the photosensitive layer, and more preferably 0.005% by mass to 1 % by mass.

-- Colorant --

The colorant is not particularly limited and may be suitably selected in accordance with the intended use, and examples thereof include pigments or dyes known in the art such as red colors, green colors, blue colors, yellow colors, violet colors, magenta colors, cyan colors and black. Specific examples of the colorants include Victoria Pure Blue BO (C.I. 42595), auramine (C.I. 41000), Fat Black HB (C.I. 26150), Monolight Yellow GT (C.I. Pigment Yellow 12), Permanent Yellow GR (C.I. Pigment Yellow 17), Permanent Yellow HR (C.I. Pigment Yellow 83), Permanent Carmine FBB (C.I. Pigment Red 146), Hoster Balm Red ESB (C.I. Pigment Violet 19), Permanent Ruby FBH (C.I. Pigment Red 11), Fastel Pink B Spura (C.I. Pigment Red 81), Monastral Fast Blue (C.I. Pigment Blue 15), Monolight Fast Black B (C.I. Pigment Black 1), and carbon black.

Examples of the colorants suitably used for preparing color filters include C.I. Pigment Red 97, C.I. Pigment Red 122, C.I. Pigment Red 149, C.I. Pigment Red 168, C.I. Pigment Red 177, C.I. Pigment Red 180, C.I. Pigment Red 192, C.I. Pigment Red 215, C.I. Pigment Green 7, C.I. Pigment Green 36, C.I. Pigment Blue 15:1, C.I. Pigment Blue 15:4, C.I. Pigment Blue 15:6, C.I. Pigment Blue 22, C.I. Pigment Blue 60, C.I. Pigment Blue 64, C.I. Pigment Yellow 139, C.I. Pigment Yellow 83, C.I. Pigment Violet 23, and the colorants described in [0138] to [0141] in Japanese Patent Application Laid-Open (JP-A) No. 2002-16275. The average particle diameter of the colorant particles is not particularly limited and may be suitably selected in accordance with the intended use. For example, the average particle diameter is preferably 5 $\mu$m or less, and more preferably 1 $\mu$m or less. When a color filter is prepared, the average particle diameter of the colorant particles is preferably 0.5 $\mu$m or less.

- -Dye --

Into the photosensitive layer set forth above, a dye may be incorporated in order to add a color to the photosensitive layer to be hereinafter described so as to make easy the handling or to enhance the storage stability.

Examples of the dye include Brilliant Green, eosin, Ethyl Violet, Erythrosine B, Methyl Green, Crystal Violet, Basic Fuchsine, phenolphthalein, 1,3-diphenyltriazine, Alizarin Red S, Thymolphthalein, Methyl Violet 2B, Quinaldine Red, Rose Bengale, Metanil-Yellow, Thymolsulfophthalein, Xylenol Blue, Methyl Orange, Orange IV, diphenyl thiocarbazone, 2,7-dichlorofluorescein, Para Methyl Red, Congo Red, Benzopurpurine 4B, $\alpha$-Naphthyl Red, Nile Blue 2B, Nile Blue A, phenacetarin, Methyl Violet, Malachite Green, Para Fuchsine, Oil Blue #603 (produced by Orient Chemical Industry Co., Ltd.), Rhodamine B, Rhodamine 6G, and Victoria Pure Blue BOH. Among these dyes, preferably are cation dyes such as oxalate of Malachite Green and sulfate of Malachite Green. The pair anion of the cation dyes may be residues of organic acid or inorganic acid such as bromic acid, iodic acid, sulfuric acid, phosphoric acid, oxalic acid, methane sulfonic acid, and toluene sulfonic acid.

The content of the dye is preferably 0.001 % by mass to 10 % by mass relative to the total components of the photosensitive composition, more preferably 0.01 % by mass to 5 % by mass, and still more preferably 0.1 % by mass

to 2 % by mass.

- Adhesion Promoter -

In order to enhance the adhesion between layers or between the pattern forming material and the substrate, a so-called adhesion promoter may be employed therebetween.

Examples of the adhesion promoters set forth above include those described in JP-A Nos. 5-11439, 5-341532, and 6-43638; specific examples of adhesion promoters include benzimidazole, benzoxazole, benzthiazole, 2-mercaptobenzimidazole, 2-mercaptobenzoxazole, 2-mercaptobenzthiazole, 3-morpholinomethyl-1-phenyl-triazole-2-thion, 3-morpholinomethyl-5-phenyl-oxadiazole-2-thion, 5-amino-3-morpholinomethyl-thiadiazole-2-thion, 2-mercapto-5-methylthio-thiadiazole, triazole, tetrazole, benzotriazole, carboxybenzotriazole, benzotriazole containing an amino group, and silane coupling agents.

The content of the adhesion promoter is preferably 0.001 % by mass to 20 % by mass relative to the total components of the photosensitive layer, more preferably 0.01% by mass to 10 % by mass, and still more preferably 0.1% by mass to 5 % by mass.

The photosensitive composition may contain, as described in "Light Sensitive Systems, chapter 5th, by J. Curser", organic sulfur compounds, peroxides, redox compounds, azo or diazo compounds, photoreductive dyes, or organic halogen compounds.

Examples of the organic sulfur compounds include di-n-butyldisulfide, dibenzyldisulfide, 2-mercaptobenzthiazole, 2-mercaptobenzoxazole, thiophenol, ethyl trichloromethane sulfonate, and 2-mercaptobenzimidazole.

Examples of the peroxides include di-t-butyl peroxide, benzoyl peroxide, and methyethylketone peroxide.

The redox compounds set forth above are a combination of a peroxide and a reducer such as persulfate ion and ferrous ion, peroxide and ferric ion.

Examples of azo or diazo compound set forth above include diazoniums such as α,α'-azobis-isobutylonitrile, 2-azobis-2-methylbutylonitrile, and 4-aminodiphenylamine.

Examples of the photoreductive dye set forth above include Rose Bengale, Erythrosine, Eosine, acriflavine, riboflavin, and thionine.

- Surfactant -

In order to further prevent surface nonuniformity generated in producing the pattern forming material of the present invention, conventional surfactants may be employed.

The surfactant may be properly selected from anionic surfactants, cationic surfactants, nonionic surfactants, ampholytic surfactants, and fluorine-containing surfactant.

The content of the surfactant is preferably 0.001 % by mass to 10 % by mass relative to the solid content of the photosensitive resin composition.

When the content is less than 0.001 % by mass, the effect to improve the nonuniformity may be insufficient, and when the content is more than 10 % by mass, the adhesion ability may be degraded.

In addition, besides the surfactants set forth above, such polymer surfactants containing fluorine may be preferably exemplified as containing 40 % by mass or more of fluorine atoms, having a carbon chain of 3 to 20 carbon atoms, and having a copolymerized component of acrylate or methacrylate containing an aliphatic group of which the hydrogen atoms bonded on the terminal carbon atom to the third of the carbon atom are substituted with fluorine atoms.

- Photosensitive Composition for Solder Resist -

The photosensitive composition for dry film resist is not particularly limited and may be suitably selected in accordance with the intended use as long at the photosensitive composition has a maximum peak of spectral sensitivity in the wavelength region from 380 nm to 420 nm; the minimum exposure dose $S_{400}$ capable of forming a pattern at a wavelength of 400 nm of the photosensitive composition is 200 mJ/cm$^2$ or less; the minimum exposure dose $S_{410}$ capable of forming a pattern at a wavelength of 410 nm of the photosensitive composition is 200 mJ/cm$^2$ or less; and $S_{400}$ and $S_{410}$ satisfy the relation $0.6 < S_{400}/ S_{410} < 1.4$. The photosensitive composition for dry film resist contains, for example, a binder, a polymerizable compound, a photopolymerization initiator, a sensitizing agent, and other components suitably selected in accordance with the intended use. The minimum exposure does $S_{405}$ capable of forming a pattern at a wavelength of 405 nm is preferably 200 mJ/cm$^2$ or less.

With respect to the spectral sensitivity of the photosensitive composition, the photosensitive composition which is a photosensitive laminate formed by laminating a pattern forming material on a substrate to be processed is measured using a spectral sensitivity measuring device in accordance with the method described in, for example, "Photopolymer Technology (edited by Ao Yamaoka, issued by Nikkan Kogyo Shimbunsha, p 262 in 1988). Specifically, a pattern forming

material on a substrate to be processed is exposed with a spectroscopic light from a light source such as a xenon lamp and a tungsten lamp which is set such that the exposure wavelength can change linearly in the horizontal axis direction and the exposure intensity can change longarithmically in the longitudinal direction, and the exposed surface is subjected to a developing treatment to thereby form a pattern for every sensitivity for each exposure wavelength. The exposure energy with which a pattern can be formed is calculated from the height (thickness) of the obtained pattern. The wavelength is plotted along the abscissa, and the reciprocal number of the exposure energy is plotted along the ordinate to form a spectral sensitivity curve. Then, the maximum peak in the spectral sensitivity curve is regarded as the spectral sensitivity of the photosensitive composition.

The minimum exposure dose with which a pattern can be formed is determined as the exposure energy capable of forming an image that can be calculated from the height (thickness) of the formed pattern in the above-noted spectral sensitivity measurement. The minimum exposure dose with which a pattern can be formed determines the optimum developing conditions by changing the developing conditions such as type of the developing solution, developing temperature, and developing time and means the minimum exposure dose with which a pattern can be formed under the optimum developing conditions.

The optimum developing conditions are not particularly limited and may be suitably selected in accordance with the intended use. For example, conditions under which unhardened regions can be completely removed by spraying a developing solution having a pH value of 8 to 12 on the unhardened regions at 25°C to 40°C and under a pressure of 0.05MPa to 0.5 MPa.

The minimum exposure dose $S_{400}$ capable of forming a pattern at a wavelength of 400 nm is preferably 200mJ/cm$^2$ or less, more preferably 100mJ/cm$^2$, and particularly preferably 50mJ/cm$^2$.

The minimum exposure dose $S_{410}$ capable of forming a pattern at a wavelength of 410 nm is preferably 200mJ/cm$^2$ or less, more preferably 100mJ/cm$^2$, and particularly preferably 50mJ/cm$^2$.

The value of $S_{400}/S_{410}$ is preferably 0.6 to 1.4, more preferably 0.8 to 1.2, and particularly preferably 0.9 to 1.1.

When the value of $S_{400}/S_{410}$ is less than 0.6 or is more than 1.4, a uniform pattern may not be obtained due to sensitivity change attributable to variations in wavelength of the individual semiconductor devices.

The minimum exposure does $S_{405}$ capable of forming a pattern at a wavelength of 405 nm is preferably 200 mJ/cm$^2$ or less, more preferably 100 mJ/cm$^2$, and particularly preferably 50 mJ/cm$^2$.

- Binder for Solder Resist -

For the binder, for example, the binder is preferably swellable to alkaline aqueous solutions, and is more preferably soluble in alkaline aqueous solutions.

Preferred examples of the binder that is swellable to or soluble in alkaline aqueous solutions include alkaline aqueous solutions having an acidic group.

The binder is not particularly limited and may be suitably selected in accordance with the intended use, and examples thereof include epoxy acrylate compounds having an acidic group described, for example, in Japanese Application Laid-Open (JP-A) Nos. 51-131706, 52-94388, 64-62375, 2-97513, 3-289656, 61-243869, and 2002-296776. Specific examples of the binder are phenol novolac epoxy acrylate or cresol novolac epoxy acrylate, and bisphenol A epoxy acrylate. For example, the binder may be the one that can be prepared by reacting a monomer containing a carboxyl group such as (meth)acrylate with an epoxy resin or a polyfunctional epoxy compound and by adding a dibasic acid anhydride such as phthalic anhydride, tetrahydro phthalic anhydride, and succinic anhydride.

The molecular mass of the epoxy acrylate compound is preferably 1,000 to 200,000, and more preferably 2,000 to 100,000. When the molecular mass is less than 1,000, tucking property of the surface of the photosensitive layer, which will be described hereinafter, may be strengthened, and the film quality of the hardened photosensitive layer may be brittle, or the surface hardness may degrade. When the molecular mass is more than 200,000, the developing property of the photosensitive layer may degrade.

Further, an acrylic resin having an acidic group described in Japanese Patent Application Laid-Open (JP-A) No. 6-295060 and at least one polymerizable group such as double bond can also be used. Specifically, in a molecule, at least one polymerizable double bond can be used, for example, from various polymerizable double bonds like acrylic group such as (meth)acrylate group or (meth)acryladmide; and vinyl esters of carboxylic acid, vinyl ethers of carboxylic acid, and aryl ethers of carboxylic acid. Further specifically, such compounds are exemplified which can be obtained by adding a glycydyl ester of unsaturated fatty acid such as glycydyl acrylate, glycydyl methacrylate, and cinnamic acid or a polymerizable compound containing an epoxy group like compounds having an epoxy group such as cyclohexane oxide, and a (meth)acryloyl group in one molecule to an acrylic resin containing a carboxyl group as an acidic group. In addition, such compounds are also exemplified which can be obtained by adding a polymerizable compound containing an isocyanate group such as isocyanato ethyl(meth)acrylate to an acrylic resin containing an acidic group and a hydroxyl group, and such compounds that can be obtained by adding a polymerizable compound containing a hydroxyl group such as hydroxyalkyl (meth)acrylate to an acrylic resin containing an anhydride group. As commercially available products

of these compounds, "KANEKA RESIN AXE manufactured by Kaneka Corporation", "CYCLOMER A-200 manufactured by DAICEL CHEMICAL INDUSTRIES, LTD.", and "CYCLOMER manufactured by DAICEL CHEMICAL INDUSTRIES, LTD." can be used, for example.

Further, as the binder, it is also possible to use reaction products between hydroxyalkyl acrylate or hydroxylalkyl methacrylate described in Japanese Patent Application Laid-Open (JP-A) No. 50-59315 and any one of a polycarboxylic acid anhydride and epihalohydrin.

Furthermore, such compounds that can be obtained by adding an acid anhydride to an epoxy acrylate having a fluorene skeleton described in Japanese Patent Application Laid-Open (JP-A) No. 5-70528; polyamide (imide) resins described in Japanese Patent Application Laid-Open (JP-A) No. 11-288087, and polyimide precursors described in Japanese Patent Application Laid-Open (JP-A) Nos. 2-097502 and 11-282155 can be used as the binder. Each of these compounds may be used alone or in combination with two or more.

For the binder, such copolymers can also be utilized that can be obtained by reacting one or more primary amine compounds with an anhydride group of a maleic anhydride copolymer. It is preferred that the copolymer is represented by the following formula (74) and is maleamide acid copolymer which contains at least a maleamide acid unit B having a structure of maleic acid half amide and a unit A having no structure of the maleic acid half amide.

The unit A may be used alone or in combination with two or more. For example, when one type of the unit B is used, and one type of the unit A is used, the maleamide acid copolymer is of a binary copolymer. When one type of the unit B is used, and two types of the unit A are used, the maleamide acid copolymer is of a ternary copolymer.

Preferred examples of the unit A include a combination between an aryl group which may have a substituted group, and a vinyl monomer (c) which will be described hereinafter and of which the glass transition temperature (Tg) of homopolymer of the vinyl monomer is less than 80°C.

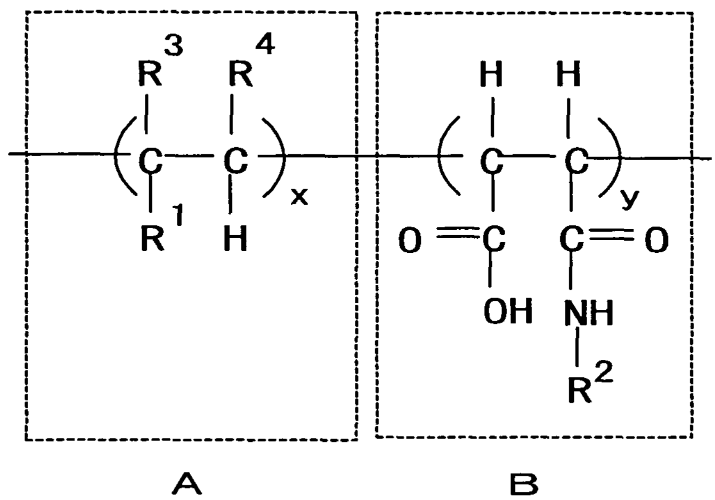

formula (74)

In the formula (74), $R^3$ and $R^4$ respectively represent any one of a hydrogen atom and a lower alkyl group; "x" and "y" respectively represent a molar fraction of recurring unit, for example, when one type of the unit A is used, the unit A contains "x" from 85 mol% to 50 mol% and "y" from 15 mol% to 50 mol%.

In the formula (74), examples of $R^1$ include substituted groups such as (-COOR$^{10}$), (-CONR$^{11}$R$^{12}$), aryl groups which may have a substituted group, (-OCOR$^{13}$), (-OR$^{14}$), and (-COR$^{15}$). Here, the $R^{10}$ to $R^{15}$ may respectively have a hydrogen atom (-H), and any one of an alkyl group or aryl group or an aralkyl group which may have a substituted group. The alkyl group, the aryl group, and the aralkyl group may respectively have a ring structure or a branched structure.

Examples of the $R^{10}$ to $R^{15}$ include methyl, ethyl, n-propyl, i-propyl, n-butyl, i-butyl, sec-butyl, t-butyl, pentyl, allyl, n-hexyl, cyclohexyl, 2-ethylhexyl, dodecyl, methoxymethyl, phenyl, methylphenyl, methoxyphenyl, benzyl, phenethyl, naphthyl, and chlorophenyl.

Specific examples of the $R^1$ include benzene derivatives such as phenyl, α-methylphenyl, 2-methylphenyl, 3-methylphenyl, 4-methylphenyl, 2,4-dimethylphenyl; n-propyloxycarbonyl, n-butyloxycarbonyl, pentyloxycarbonyl, hexyloxycarbonyl, n-butyloxycarbonyl, n-hexyloxycarbonyl, 2-ethylhexyloxycarbonyl, and methyloxycarbonyl.

Examples of the $R^2$ include alkyl groups, aryl groups, or aralkyl groups which may have a substituted group. These groups may have a ring structure or a branched structure. Specific examples of the $R^2$ include benzyl, phenethyl, 3-phenyl-1-propyl, 4-phenyl-1-butyl, 5-phenyl-1-pentyl, 6-phenyl-1-hexyl, α-methylbenzyl, 2- methylbenzyl, 3- methylbenzyl, 4- methylbenzyl, 2-(p-tolyl) ethyl, β-methylphenethyl, 1-methyl-3-phenylpropyl, 2-chlorobenzyl, 3-chlorobenzyl,

4-chlorobenzyl, 2-phlorobenzyl, 3-phlorobenzyl, 4-phlorobenzyl, 4-bromophenethyl, 2-(2-chlorophenyl) ethyl, 2-(3-chlorophenyl) ethyl, 2-(4-chlorophenyl) ethyl, 2-(2-phlorophenyl) ethyl, 2-(3-phlorophenyl) ethyl, 2-(4-phlorophenyl) ethyl, 4-phloro-α, α-dimethylphenethyl, 2-methoxybenzyl, 3-methoxybenzyl, 4-methoxybenzyl, 2-ethoxybenzyl, 2-methoxyphenethyl, 3-methoxyphenethyl, 4-methoxyphenethyl, methyl, ethyl, propyl,1-propyl, butyl, t-butyl, sec-butyl, pentyl, hexyl, cyclohexyl, heptyl, octyl, lauryl, phenyl, 1-naphthyl, methoxymethyl, 2-methoxyethyl, 2-ethoxyethyl, 3-methoxypropyl, 2-butoxyethyl, 2-cyclohexyloxyethyl, 3-ethoxypropyl, 3-propoxypropyl, and 3-isopropoxypropylamine.

It is particularly preferably that the binder is a copolymer which can be obtained by reacting a primary amine compound to an anhydride group of a copolymer which contains (a) an maleic acid anhydride, (b) an aromatic vinyl monomer, and (c) a vinyl monomer of which the glass transition temperature (Tg) of homopolymer of the vinyl monomer is less than 80°C. A copolymer containing the component (a) and the component (b) makes it possible to achieve high surface hardness in the photosensitive layer, which will be hereinafter described, however, it may be difficult to assure self-laminating property of the photosensitive layer. A copolymer containing the component (a) and the component (c) makes it possible to achieve self-laminating property of the photosensitive layer, however, it may be difficult to assure the surface hardness of the photosensitive layer.

-- (b) Aromatic Vinyl Monomer --

The aromatic vinyl monomer is not particularly limited and may be suitably selected in accordance with the intended use, however, from the perspective that the surface hardness of the photosensitive layer to be formed using the photosensitive composition of the present invention can be enhanced, a compound of which the glass transition temperature (Tg) of the homopolymer is 80°C or more is preferable, and the glass transition temperature is more preferably 100°C or more.

Specific and preferred examples of the aromatic vinyl monomer include styrene derivatives such as styrene (Tg of the homopolymer = 100°C), α-methylstyrene (Tg of the homopolymer =168°C), 2-methylstyrene (Tg of the homopolymer =136°C), 3-methylstyrene (Tg of the homopolymer = 97°C), 4-methylstyrene (Tg of the homopolymer = 93°C), and 2,4-dimethylstyrene (Tg of the homopolymer = 112°C). Each of these aromatic vinyl monomers may be used alone or in combination with two or more.

- (c) Vinyl Monomer --

The vinyl monomer is required to contain a homopolymer having a glass transition temperature (Tg) of 80°C or less. The glass transition temperature (Tg) of the homopolymer is preferably 40°C or less, and more preferably 0°C or less.

Examples of the vinyl monomer include n-propyl acrylate (Tg of the homopolymer = -37°C), n-butyl acrylate (Tg of the homopolymer = -54°C), pentyl acrylate or hexyl acrylate (Tg of the homopolymer = -57°C), n-butyLmethacrylate (Tg of the homopolymer = -24°C), and n-hexyl methacrylate (Tg of the homopolymer = -5°C). Each of these vinyl monomers may be used alone or in combination with two or more.

-- Primary Amine Compound --

Examples of the primary amine compound include benzylamine, phenethylamine, 3-phenyl-1-propylamine, 4-phenyl-1-butylamine, 5-phenyl-1-pentylamine, 6-phenyl-1-hexylamine, α-methylbenzylamine, 2-methylbenzylamine, 3-methylbenzylamine, 4-methylbenzylamine, 2-(p-tolyl) ethylamine, β-methylphenethylamine, 1-methyl-3-phenylpropylamine, 2-chlorobenzylamine, 3-chlorobenzylamine, 4-chlorobenzylamine, 2-phlorobenzylamine, 3-phlorobenzylamine, 4-phlorobenzylamine, 4-bromophenetylamine, 2-(2-chlorophenyl) ethylamine, 2-(3-chlorophenyl) ethylamine, 2-(4-chlorophenyl) ethylamine, 2-(2-phlorophenyl) ethylamine, 2-(3-phlorophenyl) ethylamine, 2-(4-phlorophenyl) ethylamine, 4-phloro-α, α-dimethylphenethylamine, 2-methoxybenzylamine, 3-methoxybenzylamine, 4-methoxybenzylamine, 2-ethoxybenzylamine, 2-methoxyphenetylamine, 3-methoxyphenetylamine, 4-methoxyphenetylamine, methylamine, ethylamine, propylamine, 1-propylamine, butylamine, t-butylamine, sec-butylamine, pentylamine, hexylamine, cyclohexylamine, heptylamine, octylamine, laurylamine, aniline, octylaniline, anisidine, 4-chloraniline, 1-naphtylamine, methoxymethylamine, 2-methoxyethylamine, 2-ethoxyethylamine, 3-methoxypropylamine, 2-butoxyethylamine, 2-cyclohexyloxyethylamine, 3-ethoxypropylamine, 3-propoxypropylamine, and 3-isopropoxypropylamine. Of these, benzylamine and phenethylamine are particularly preferable.

Each of these primary amine compounds may be used alone or in combination with two or more.

The reacting dose of the primary amine compound needs to be an equivalent mass of 0.1 to 1.2 relative to the anhydride group, and is preferably 0.1 to 1.0 equivalent mass. When the reacting dose is more than 1. 2 equivalent mass relative to the anhydride group and one or more of the primary amine compounds are reacted together with a maleic anhydride copolymer, the solubility may significantly degrade.

The content of the binder in the maleic acid anhydride (a) is preferably 1 mol % to 50 mol %, more preferably 20 mol % to 45 mol %, and particularly preferably 20 mol% to 40 mol%. When the content is less than 15 mol%, alkali developing property may not be imparted. When the content is more than 50 mol%, alkali resistance may degrade, and a precise permanent pattern may not be formed due to difficulty of synthesis of the copolymer. In addition, in the present invention, the content of the aromatic vinyl monomer (b) in the binder is preferably 20 mol% to 60 mol%, and the content of the vinyl monomer of which the glass transition temperature (Tg) of the homopolymer is less than 80°C (c) in the binder is more preferably 15 mol% to 40 mol%. When the respective contents are within the above-noted ranges, both of the surface hardness and the self-laminating property of the photosensitive composition can be achieved.

The molecular mass of the binder of the compound prepared by reacting the primary amine compound with an anhydride group of the epoxy acrylate having a fluorene skeleton, or the polyamide (imide), or the maleic anhydride copolymer; or the molecular mass of the polyimide precursor is preferably 3,000 to 500,000, and more preferably 5,000 to 100,000. When the molecular mass of the binder is less than 3,000, the tucking property of the surface of the photosensitive layer, which will be hereinafter described, may be strengthened, and the film quality of the hardened photosensitive layer may be brittle, or the surface hardness may degrade. When the molecular mass of the binder is more than 500,000, the developing property of the photosensitive layer may degrade.

The solid content of the binder in the solids of the photosensitive composition is preferably 5% by mass to 80% by mass, and more preferably 10% by mass to 70% by mass. When the solid content of the binder is less than 5% by mass, the film strength of the photosensitive layer may be easily weakened, and the tucking property of the surface of the photosensitive layer may be strengthened. When the solid content is more than 50% by mass, the exposure sensitivity of the photosensitive layer may degrade.

- Polymerizable Compound for Solder Resist -

The polymerizable compound is not particularly limited and may be suitably selected in accordance with the intended use, however, a compound having at least one addition-polymerizable group in a molecule and a boiling point of 100°C or more under normal pressure is preferable. Preferred examples thereof include at least one selected from monomers having a (meth)acrylic group.

The monomer having a (meth)acrylic group is not particularly limited and may be suitably selected in accordance with the intended use. Examples thereof include monofunctional acrylates and monofunctional methacrylates such as polyethylene glycol mono(meth)acrylate, polypropylene glycol mono(meth)acrylate, and phenoxyethyl (meth)acrylate; compounds prepared by adding an ethylene oxide or a propylene oxide to a polyfunctional alcohol for reaction and making the reaction product into (meth)acrylate, examples of the polyfunctional are polyethylene glycol di(meth)acrylate, polypropylene glycol di(meth)acrylate, trimethylolethane triacrylate, trimethylolpropane triacrylate, trimethylol propane diacrylate, neopentyl glycol di(meth)acrylate, pentaerythritol tetra(meth)acrylate, pentaerythritol tri(meth)acrylate, dipentaerythritol hexa(meth)acrylate, dipentaerythritol penta(meth)acrylate, hexanediol di(meth)acrylate, trimethylol propane tri(acryloyl oxypropyl) ether, trimethylol propane tri(acryloyl oxypropyl) ether, tri(acryloyl oxyethyl) isocyanurate, tri(acryloyl oxyethyl) isocyanurate, tri(acryloyl oxyethyl) cyanurate, glycerin, and bisphenol; urethane acrylates described in Japanese Patent Application Publication (JP-B) Nos. 48-41708, 50-6034, and 51-37193; polyether acrylates described in Japanese Patent Application Laid-Open (JP-A) No. 48-64183, Japanese Patent Application Publication (JP-B) Nos. 49-43191, and 52-30490; and polyfunctional acrylates and methacrylates such as epoxy acrylates, which are reaction products between epoxy resins and (meth)acrylic acids. Among them, trimethylol propane tri(meth)acrylate, pentaerythritol tetra(meth)acrylate, dipentaerythritol hexa(meth)acrylate, and dipentaerythritol penta(meth)acrylate are particularly preferable.

The solid content of the polymerizable compound in the solids of the photosensitive composition is preferably 5% by mass to 50% by mass, and more preferably 10% by mass to 40% by mass. When the solid content of the polymerizable compound is less than 5% by mass, it may cause problems with degradation of developing property and degradation of exposure sensitivity. When the solid content of the polymerizable compound is more than 50% by mass, it is unfavorable because the adhesive property of the photosensitive layer may be excessively exerted.

- Photopolymerization Initiator for Solder Resist -

The photopolymerization initiator may be properly selected from conventional ones without particular limitations as long as it has the property to initiate polymerization; preferably the photopolymerization initiator is the one that exhibits photosensitivity to ultraviolet rays to visual lights. The photopolymerization initiator may be an active substance that generates a radical due to an effect with a photo-exited photosensitizer, or a substance that initiates cation polymerization depending on the monomer species.

Preferably, the photopolymerization initiator contains at least one component that has a molecular extinction coefficient of about 50 $M^{-1}cm^{-1}$ in a range of about 300 nm to 800 nm, more preferably about 330 nm to 500 nm.

Examples of the photopolymerization initiator include halogenated hydrocarbon derivatives such as having a triazine skeleton or an oxadiazole skeleton, phosphorous oxide, hexaaryl-biimidazols, oxime derivatives, organic peroxides, thio compounds, ketone compounds, aromatic onium salts, and ketoxime ether.

Examples of the halogenated hydrocarbon compounds having a triazine skeleton are the same compounds as used for preparing the above-noted photosensitive composition for dry film resist.

Examples of the oxime derivatives which are preferably used in the present invention include 3-benzoyloxyiminobutane-2-one, 3-acetoxyiminobutane-2-one, 3-propyonyloxyiminobutane-2-one, 2-acetoxyiminopentane-3-one, 2-acetoxyimino-1-phenylpropane-1-one, 2-benzoyloxyimino-1-phenylpropane-1-one, 3-(4-toluenesulfonyloxy)iminobutane-2-one, and 2-ethoxycarbonyloxyimino-1-phenylpropane-1-one.

As the photopolymerization initiator other than those stated above, acylphosphine oxides may be used, and examples of the acylphosphine oxides include bis(2,4,6-trimethylbenzoyl)-phenylphosphine oxide, bis(2,6-dimethoxybenzoyl)-2,4,4-trimethyl-pentylphenyl phosphine oxide, and Lucirin TPO.

Besides the photopolymerization initiators, the same compounds as used for preparing the above-noted photosensitive composition for dry film resist can also be used.

Examples of the ketone compounds include, besides the same compounds as used for preparing the above-noted photosensitive composition for dry film resist, 4,4'-bis(dialkylamino) benzophenones such as 4,4'-bis(dimethylamino) benzophenone, 4,4'-bisdicyclohexylamino) benzophenone, 4,4'-bis(diethylamino)benzophenone, 4,4'-bis (dihydroxyethylamino) benzophenone, 4-methoxy-4'-dimethylaminobenzophenone, 4,4'-dimethoxybenzophenone, and 4-dimethylaminobenzophenone; 4-dimethylaminoacetophenone, benzyl, anthraquinone, 2-t-butylanthraquinone, 2-methylanthraquinone, phenanthraquinone, xanthone, thioxanthone, 2-chloro-thioxanthone, 2,4-diethylthioxanthone, fluorenone, 2-benzyl-dimethylamino-1-(4-morpholinophenyl)-1-butanone, 2-methyl-1-[4-(methylthio)phenyl]-2-morpholino-1-propane, 2-hydroxy-2-methyl-[4-(1-methylvinyl) phenyl] propanol oligomer, benzoin; benzoin ethers such as benzoin methyl ether, benzoin ethyl ether, benzoin propyl ether, benzoin isopropyl ether, benzoin phenyl ether, and benzyl dimethyl ketal); acridone, chloroacridone, N-methylacridone, N-butylacridone, and N-butyl-chloroacridone.

In order to adjust the exposure sensitivity and photosensitive wavelength when exposing the photosensitive layer, which will be described hereinafter, it is possible to add a photosensitizer to the photosensitive composition in addition to the photopolymerization initiator, and the minimum exposure dose and the like can be easily adjusted depending on a selection of an appropriate photopolymerization initiator and a combination of the photopolymerization initiator with an appropriate photosensitizer.

It is preferred to use a photosensitizer in combination with the components set forth above because the minimum exposure dose can be easily adjusted, for example, such that the minimum exposure dose $S_{400}$ is 300 mJ/cm$^2$ or less, the minimum exposure dose $S_{410}$ is 300 mJ/cm$^2$ or less, and the $S_{410}/S_{400}$ is 0.6 to 1.6.

The maximum absorption wavelength of the photosensitizer is not particularly limited and may be suitably adjusted in accordance with the intended use, however, the maximum absorption wavelength is preferably 380 nm to 420 nm, more preferably 390 nm to 415 nm, and still more preferably 395 nm to 415 nm.

The photosensitizer may be suitably selected depending on the types of laser beam such as visible light, ultraviolet ray laser beam, and visible light laser beam, as a light irradiation unit, which will be hereinafter described.

The photosensitizer may be exited by active irradiation and may generate a radical, an available acidic group and the like through interaction with other substances such as radical generators and acid generators by transferring energy or electrons.

For the photosensitizer, the same photosensitizers used for preparing the above-noted photosensitive composition for dry film resist may be used.

As for the combination of the photopolymerization initiator and the photosensitizer, the initiating mechanism that involves electron transfer may be exemplified such as combinations of (1) an electron donating initiator and a photosensitizer dye, (2) an electron accepting initiator and a photosensitizer dye, and (3) an electron donating initiator, a photosensitizer dye, and an electron accepting initiator (ternary initiating mechanism) as described in JP-A No. 2001-305734.

The content of the photosensitizer is preferably 0.05 % by mass to 30 % by mass relative to the total components of the photosensitive composition, more preferably 0.1% by mass to 20 % by mass, and still more preferably 0.2 % by mass to 10 % by mass. When the content is less than 0.05 % by mass, the sensitivity to the active energy ray may decrease, longer period may be required for exposing process, and the productivity may tend to lower, and when the content is more than 30 % by mass, the photosensitizer may precipitate from the photosensitive layer during preservation period.

Each of these photopolymerization initiators may be used alone or in combination with two or more.

The photopolymerization initiator is not particularly limited and may be suitably selected in accordance with the intended use as long as it is photosensitive to a laser beam having a wavelength of 405 nm in the exposure process, which will be described below. Examples of the photopolymerization initiator include complex photoinitiators prepared by compounding the phosphine oxide, the $\alpha$-amino alkyl ketones, the halogenated hydrocarbon compound having a

triazine skeleton, and an amine compound as a photosensitizer, which will be described below; compounds prepared in combination with photosensitizers such as a hexaarylbiimidazole compound, and a photosensitizer such as acridone derivative; or titanocene.

The content of the photopolymerization initiator in the photosensitive composition is preferably 0.1 % by mass to 30 % by mass, more preferably 0.5 % by mass to 20 % by mass, and still more preferably 0.5 % by mass to 15 % by mass.

- Thermocrosslinker for Solder Resist -

The thermocrosslinker is not particularly limited and may be suitably selected in accordance with the intended use. In order to enhance the film strength of the hardened photosensitive layer which is formed by using the photosensitive composition, for example, it is possible to use an epoxy resin compound having at least two oxirane groups within one molecule or an oxetane compound having at least two oxetanyl groups within one molecule within the range where no adverse impact is anticipated on the developing property of the photosensitive layer.

Examples of the epoxy resin compound include bixylenol epoxy resins or biphenol epoxy resins (product name: "YX4000", manufactured by Japan Epoxy Resin K.K.) or mixtures thereof; heterocyclic epoxy resins having an isocyanurate skeleton or the like (product name: "TEPIC", manufactured by NISSAN CHEMICAL INDUSTRIES, LTD., "ARALDITE PT810", manufactured by Chiba Specialty Chemicals K.K., and the like); bisphenol A epoxy resins, novolac epoxy resins, bisphenol F epoxy resins, hydrogenerated bisphenol A epoxy resins, glycidylamine epoxy resins, hydantoin epoxy resins, cycloaliphatic epoxy resins, trihydroxyphenylmethane epoxy resins, bisphenol S epoxy resins, bisphenol A novolac epoxy resins, tetraphenylol ethane epoxy resins, glycidyl phthalate resins, tetraglycidyl xylenoyl ethane resins, naphthalene group-containing epoxy resins (product name: "ESN-190"and "ESN-360 manufactured by Nippon Steel Chemical Group; "HP-4032", "EXA-4750" and "EXA-4700" manufactured by Dainippon Ink and Chemicals, Inc., etc.); epoxy resins having a dicyclopentadiene skeleton ("HP-7200" and "HP-7200H" manufactured by Dainippon Ink and Chemicals, Inc., etc.); glycidylmethacrylate copolymer epoxy resins ("CP-50S" and "CP-50M" manufactured by NOF Corporation, etc.), and copolymerized epoxy resins between cyclohexyl maleimide and glycidyl methacrylate. However, the thermocrosslinker is not limited to those stated above. Each of these epoxy resins may be used alone or in combination with two or more.

Examples of the oxetane compounds include bis[(3-methyl-3-oxetanylmethoxy)methyl]ether, bis[(3-ethyl-3-oxetanylmethoxy)methyl]ether, 1,4-bis[(3-methyl-3-oxetanylmethoxy)methyl]benzene, 1,4-bis[(3-ethyl-3-oxetanylmethoxy)methyl]benzene, (3-methyl-3-oxetanyl)methylacrylate, (3-ethyl-3-oxetanyl)methyl acrylate, (3-methyl-3-oxetanyl) methyl methacrylate, (3-ethyl-3-oxetanyl)methyl methacrylate or oligomers thereof; or polyfunctional oxetanes such as copolymers thereof; and ether compounds prepared between an oxetane group and a resin having a hydroxyl group such as novolac resin, poly(p-hydroxystyrene), cardo bisphenols, calix-arenes, calix-resorcin arenas, and silsesquioxane; and copolymers between unsaturated monomer having an oxetane ring and alkyl (meth)acrylate.

The solid content of the epoxy resin compound or the oxetane compound in the solids of the photosensitive composition is preferably 1 % by mass to 50% by mass, and more preferably 3% by mass to 30% by mass. When the solid content is less than 1% by mass, the hygroscopicity of the hardened film may be increased to cause degradation of insulation properties or to cause degradation in solder heat resistance and electroless plating resistance. When the content is more than 50% by mass, it is unfavorable because the developing property and exposure sensitivity of the photosensitive layer may be degraded.

To accelerate thermal curing of the epoxy resin compound and the oxetane compound, it is possible to use, for example, amine compounds such as dicyandimide, benzyldimethylamine, 4-(dimethylamino)-N,N-dimethylbenzylamine, 4-methoxy-N,N-dimethylbenzylamine, and 4-methyl-N,N-dimethylbenzylamine; quaternary ammonium salt compounds such as triethylbenzyl ammonium chloride; block isocyanate compounds such as dimethylamine; bicyclic amidine compounds of imidazole derivatives such as imidazole, 2-methylimidazole, 2-ethylimidazole, 2-ethyl-4-methylimidazole, 2-phenylimidazole, 4-phenylimidazole, 1-cyanoethyl-2-phenylimidazole, and 1-(2-cyanoethyl)-2-ethyl-4-methylimidazole, and salts thereof; phosphorus compounds such as triphenylphosphine; guanamine compounds such as melamine, guanamine, acetoguanamine, and benzoguanamine; S-triazine derivatives such as 2,4-diamino-6-methacryloyloxyethyl-S-triazine, 2-vinyl-2,4-diamino-S-triazine, 2-vinyl-4,6-diamino-S-triazine-isocyanuric acid adducts, 2,4-diamino-6-methacryloyloxyethyl-S-triazine-isocyanuric acid adducts. Each of these compounds may be used alone or in combination with two or more. The compound may be property selected without particular limitations as long as it allows for curing catalyst of the epoxy resin compound and the oxetane compound or it can accelerate a reaction between a carboxyl group and the epoxy resin compound or the oxetane compound, and beside the compounds stated above, compounds capable of accelerating thermal curing other than those stated above may be used.

The solid content of the compound capable of accelerating thermal hardening of the epoxy resin, the oxetane compound, and a carboxylic acid in the solids of the photosensitive composition is typically 0.01 % by mass to 15% by mass.

For the above-noted thermocrosslinker, it is possible to use polyisocyanate compounds described in Japanese

Patent Application Laid-Open (JP-A) No. 5-9407, and the polyisocyanate compounds may be derived from an aliphatic compound or an alicyclic compound, or an aromatic group-substituted aliphatic compound each of which contains at least two isocyanate groups.

Specific examples of such polyisocyanate compounds include mixtures of 1,3-phenylene diisocyanate and 1,4-phenylene diisocyanate; bifunctional isocyanates such as 2,4-toluene diisocyanate, 2,6-toluene diisocyanate, 1,3-xylylene diisocyanate, 1,4-xylylene diisocyanate, bis(4-isocyanate-phenyl) methane, bis(4-isocyanatecyclohexyl) methane, isophorone diisocyanate, hexamethylene diisocyanate, trimethylhexamethylene diisocyanate; polyfunctional alcohols compounded between the bifunctional isocyanate, and trimethylolpropane, pentaerythritol, and glycerine; alkylene oxide adducts of the above-noted polyfunctional alcohol, and adducts with the above-noted bifunctional isocyanate; and cyclic trimers such as hexamethylene diisocyanate, hexamethylene-1,6-diisocyanate, and derivatives thereof.

Further, for enhancing shelf stability of the photosensitive composition or the pattern forming material of the present invention, a compound that can be prepared by reacting a blocking agent to the polyisocyanate or isocyanate group of the derivatives thereof may be used.

Examples of the isocyanate group-containing blocking agent include alcohols such as isopropanol, and tert.-butanol; lactams such as ε-caprolactam; phenols such as phenol, cresol, p-tert.-butylphenol, p-sec.-butylphenol, p-sec.-aminophenol, p-octylphenol, and p-nonylphenol; heterocyclic hydroxyl compounds such as 3-hydroxypyridine, and 8-hydroxyquinoline; active methylene compounds such as dialkyl malonate, methyl ethyl ketoxime, acetylacetone, alkyl acetoacetate oxime, acetooxime, and cyclohexanon oxime. Besides, the compounds having at least one polymerizable double bond or having at least one block isocyanate group in one molecule, which are described in Japanese Patent Application Laid-Open (JP-A) No. 6-295060, may be used.

Further, for the thermocrosslinker, melamine derivatives may be used. Examples of the melamine derivatives include methylolmelamine, and alkylated methylol melamine (a compound a methylol group is etherified with methyl, ethyl, or butyl). Each of these melamine derivatives may be used alone or in combination with two or more. Of these, alkylated methylol melamine is preferable, and haxa-methylated methylol melamine is particularly preferable in that excellent storage stability of the photosensitive layer can be assured, and it is useful in enhancing the surface hardness of the photosensitive layer or the film strength of the hardened film itself.

The solid content of the thermocrosslinker in the solids of the photosensitive composition is preferably 1% by mass to 40% by mass, and more preferably 3% by mass to 20% by mass. When the solid content of the thermocrosslinker is less than 1% by mass, the film strength of the hardened film may not be improved, and when the solid content is more than 40% by mass, it may cause degradations in developing property and exposure sensitivity.

- Other Components for Solder Resist -

As for the other components, polymerization inhibitor, plasticizer, colorant (color pigment or dye), and extender pigment are exemplified; in addition, adhesion promoter on substrate surface, and the other auxiliaries such as conductive particles, filler, defoamer, fire retardant, leveling agent, peeling promoter, antioxidant, perfume, adjustor of surface tension, chain transfer agent, and the like may be utilized together with. The properties of a target photosensitive composition or a pattern forming material, which will be hereinafter described, such as stability, photographic ability, can be adjusted when these components are contained appropriately.

- Polymerization Inhibitor for Solder Resist -

The polymerization inhibitor may be added to prevent thermal polymerization or temporal polymerization of the polymerizable compound.

Examples of the polymerization inhibitor include the same polymerization inhibitors as used for preparing the above-noted photosensitive composition for dry film resist.

The content of the photopolymerization inhibitor is preferably 0.001% by mass to 5% by mass, more preferably 0.005 % by mass to 2 % by mass, and still more preferably 0.01 % by mass to 1 % by mass. When the content of the polymerization inhibitor is less than 0.001% by mass, the stability during storage period may degrade, and when the content is more than 5% by mass, the photosensitivity to active energy ray may decrease.

- Color Pigment -

The color pigment is not particularly limited and may be suitably selected in accordance with the intended use. For example, the color pigment can be suitably selected for use from the same colorants as used for preparing the above-noted photosensitive composition for dry film resist such as phthalocyanine green, Victoria pure bule BO (C. I. 42595).

The solid content of the color pigment in the solids of the photosensitive composition may be determined in

view of the exposure sensitivity and resolution of the photosensitive layer in the permanent pattern forming process. The solid content of the color pigment varies depending on the types of the color pigment, however, is preferably 0.05 % by mass to 10 % by mass, and more preferably 0.1 % by mass to 5 % by mass.

- Extender Pigment -

The extender pigment is not particularly limited and may be suitably selected in accordance with the intended use, and examples thereof include inorganic pigments and organic fine particles. To the photosensitive composition for solder resist, the inorganic pigments and organic fine particles can be added in accordance with the necessity for improving the surface hardness of the permanent pattern, or restraining the coefficient of linear expansion of the permanent pattern to low-level, or restraining the dielectric constant and electrical loss tangent of the hardened film itself to low-level.

The inorganic pigment is not particularly limited and may be suitably selected from conventional inorganic pigments, and examples thereof include kaolin, barium sulfate, barium titanate, silicon oxide powder, silicon oxide fine powder, silica produced by gas phase process, indefinitely shaped silica, crystalline silica, molten silica, spherically shaped silica, talc, clay, magnesium carbonate, calcium carbonate, aluminum oxide, aluminum hydroxide, and mica.

The average particle diameter of the inorganic pigment is preferably 10 μm or less, and more preferably 3 μm or less. When the average particle diameter is larger than 10 μm, the resolution of the photosensitive layer may degrade due to light scattering.

The organic fine particles are not particularly limited and may be suitably selected in accordance with the intended use, and examples thereof include melamine resins, benzoguanamine resins, and crosslinkable polyethylene resins. Spherically shaped fine particles and the like made from silica or crosslinkable resin having an average particle diameter of about 1 μm to 5 μm, and an oil absorption of about 100 $m^2/g$ to 200 $m^2/g$ can be used.

The added amount of the extender pigment is preferably 5 % by mass to 60 % by mass. When the added amount is less than 5 % by mass, the coefficient of linear expansion may not be sufficiently reduced, and when the added amount is more than 60% by mass, when a hardened film is formed on a surface of the photosensitive layer, film quality of the hardened film may be brittle; and when an wiring board is formed using a permanent pattern, functions as a protective film of the interconnection may be impaired.

- Adhesion Promoter -

As an adhesion promoter for solder resist, the conventional adhesion promoters as used for preparing the above-noted photosensitive composition for dry film resist may be used for each layer in the same content as that of the photosensitive composition for dry film resist to improve inter-layer adhesive property or adhesive property between the photosensitive layer and the substrate.

- Pattern Forming Material -

The pattern forming material is a film in which a photosensitive layer made from the photosensitive composition of the present invention, a protective film, and other layers suitably selected in accordance with the intended use are formed in a laminate structure on a substrate; and the photosensitive composition contains any one of a photosensitive composition for dry film resist and a photosensitive composition for solder resist of the present invention.

The configuration of the pattern forming material is not particularly limited and may be suitably selected in accordance with the intended use, and examples thereof include a configuration of which the photosensitive layer and the protective film are formed in this order on the substrate; a configuration of which an oxygen-barrier layer (PC layer) to be described hereinafter, the photosensitive layer, and the protective film are formed in this order on the substrate; and a configuration of which a cushion layer to be described hereinafter, a PC layer to be described hereinafter, the photosensitive layer, and the protective film are formed in this order on the substrate. The photosensitive layer may be a single layer or a plurality of layers.

-- Support --

Material of the support is not particularly limited and may be suitably selected in accordance with the intended use. Preferably, the support exhibits a peeling ability against the photosensitive layer, and the support is highly transparent and has higher surface planality.

Preferably, the support is formed from a transparent synthetic resin; examples of the synthetic resin include various plastic films such as polyethylene terephthalate, polyethylene naphthalate, polypropylene, polyethylene, triacetyl cellulose, diacetyl cellulose, polyalkyl(meth)acrylate, poly(meth)acrylate copolymer, polyvinyl chloride, polyvinyl alcohol,

polycarbonate, polystyrene, cellophane, polyvinylidene chloride copolymer, polyamide, polyimide, vinylchloride-vinylacetate copolymer, polytetrafluoroethylene, polytrifluoroethylene, cellulose film, and nylon film. Among them, polyethylene terephthalate is particularly preferable. Each of these synthetic resins may be used alone or in combination with two or more.

For the support, the supports described in Japanese Patent Application Laid-Open (JP-A) Nos. 4-208940, 5-80503, 5-173320, and 5-72724 may also be used.

The thickness of the support may be properly selected depending on the application; preferably, the thickness is 4 μm to 300 μm, and more preferably 5 μm to 175 μm.

The shape of the support may be properly selected depending on the application, however, it is preferable that the pattern forming material is formed in an elongated sheet and wound to a cylindrical core tube in a roll shape for storage. The length of the elongated pattern forming material is not particularly limited and may be suitably selected from 10 m to 20,000 m, for example. The pattern forming material may be subjected to slit processing in a user-friendly manner such that the elongated pattern forming material of 100 m to 1,000 m is rolled in a roll shape. In this case, it is preferable that the pattern forming material is wound to a cylindrical core tube such that the support constitutes the outermost of the roll. Further, the rolled pattern forming material may be slit in sheet-like shape. During storage period, preferably a separator which is moisture proof and contains a drying agent is arranged at the edge faces from the perspective of protection of the edge faces and preventing edge fusion; and a material of lower moisture vapor permeability is preferably used for packaging.

- Photosensitive Layer --

The photosensitive layer can be formed from any one of the photosensitive composition for dry film resist and the photosensitive composition for solder resist. The site at which the photosensitive layer is formed in the pattern forming material is not particularly limited and may be suitably selected in accordance with the intended use. Typically, the photosensitive layer is formed on the support.

The thickness of the photosensitive layer is not particularly limited and may be suitably selected in accordance with the intended use, for example, the thickness is preferably 3 μm to 100 μm, and more preferably 5 μm to 70 μm.

- Protective Film -

The protective film serves to prevent contamination and damage of the photosensitive layer and protect the photosensitive layer.

The site at which the protective film is formed in the pattern forming material is not particularly limited and may be suitably selected in accordance with the intended use. Typically, the protective film is formed on the photosensitive layer.

Examples of the protective film include those used for the support, silicone paper, paper with polyethylene or polypropylene laminated thereon, polyolefin sheet or polytetrafluoroethylene sheet. Of these, polyethylene films and polypropylene films are preferable.

The thickness of the protective film is not particularly limited and may be suitably selected in accordance with the intended use, and for example, the thickness is preferably 5 μm to 100 μm, and more preferably 8 μm to 30 μm.

When the protective film is used, it is preferable that an adhesive strength A between the photosensitive layer and the support, and an adhesive strength B between the photosensitive layer and the protective film satisfy the relation, adhesive strength A > adhesive strength B.

The combinations of the support and the protective film, i.e. (support/ protective film), are exemplified by (polyethylene terephthalate/ polypropylene), (polyethylene terephthalate/ polyethylene), (polyvinyl chloride/cellophane), (polyimide/polypropylene), and (polyethylene terephthalate/ polyethylene terephthalate). Further, the surface treatment of the support and/or the protective film may result in the relation of the force set forth above. The surface treatment of the support may be utilized for enhancing the adhesive force with the photosensitive layer; examples of the surface treatment include deposition of under-coat layer, corona discharge treatment, flame treatment, ultraviolet-ray treatment, radio frequency exposure treatment, glow discharge treatment, active plasma treatment, and laser beam treatment.

The static friction coefficient between the support and the protective film is preferably 0.3 to 1.4, and more preferably 0.5 to 1.2.

When the static friction coefficient is less than 0.3, winding displacement may generate in roll configuration due to excessively high slipperiness, and when the static friction coefficient is more than 1.4, winding of the material in a roll configuration tends to be difficult.

The protective film may be subjected to a surface treatment in order to control the adhesive property between the protective film and the photosensitive layer. The surface treatment can be performed, for example, by forming an under-coat layer of polymer such as polyorganosiloxane, fluorinated polyolefin, polyfluoroethylene, and polyvinyl alcohol

on the surface of the protective film. The under-coat layer may be formed by applying the coating solution for the polymer over the surface of the protective film, then drying the coated surface at 30 °C to 150 °C, in particular 50 °C to 120 °C for 1 minute to 30 minutes.

The heating temperature is not particularly limited and may be suitably adjusted in accordance with the intended use, for example, the heating temperature is preferably 70 °C to 130 °C, and more preferably 80 °C to 110 °C.

The pressure at the pressurization is not particularly limited and may be suitably adjusted in accordance with the intended use, for example, the pressure is preferably 0.01 MPa to 1.0 MPa, and more preferably 0.05 MPa to 1.0 MPa.

An apparatus used to perform any one of the heating and pressurization is not particularly limited and may be suitably selected in accordance with the intended use. Preferred examples thereof include heat presses and heat roll laminators (such as VP-II, manufactured by Taisei Laminator Co., Ltd.), vacuum laminators (MV LP500, manufactured by MVLP).

-- Other Layers --

The other layers are not particularly limited and may be suitably selected in accordance with the intended use, and the pattern forming material may have a cushion layer, an oxygen-barrier layer (PC layer), a peeling layer, an adhesive layer, a light absorption layer, and a surface protective layer and the like. Each of these layers may be formed singularly or may be formed in combination with two or more in the pattern forming material.

The cushion layer has no tucking ability at room temperature, however, the layer is melted to flow when formed under vacuum and heating conditions.

The PC layer typically contains polyvinyl alcohol as main components, and the thickness of the formed PC layer is about 0.5 μm to 5 μm.

-- Method for producing a pattern forming material --

The pattern forming material is prepared in a similar method to the photosensitive composition for dry film resist and the photosensitive composition for solder resist.

In the case of a pattern forming material in which the photosensitive composition for dry film resist is laminated, it is required that the photosensitive layer has a maximum spectral sensitivity in the wavelength range of 380 nm to 420 nm, the minimum exposure dose $S_{400}$ capable of forming a pattern at a wavelength of 400 nm of the photosensitive composition is 200 mJ/cm$^2$ or less, the minimum exposure dose $S_{410}$ capable of forming a pattern at a wavelength of 410 nm of the photosensitive composition is 200 mJ/cm$^2$ or less; and $S_{400}$ and $S_{410}$ satisfy the relation, $0.6 < S_{400} / S_{410} < 1.4$. The method for preparing such a photosensitive layer is not particularly limited and may be suitably selected depending on the application. A method in which a photosensitizer having a maximum absorption wavelength of 340 nm to 420 nm is contained in a solution for photosensitive composition (photosensitive layer) is exemplified.

In the case of a pattern forming material in which the photosensitive composition for solder resist is laminated, it is required that the photosensitive layer has a maximum spectral sensitivity in the wavelength range of 380 nm to 420 nm, the minimum exposure dose $S_{400}$ capable of forming a pattern at a wavelength of 400 nm of the photosensitive composition is 300 mJ/cm$^2$ or less, the minimum exposure dose $S_{410}$ capable of forming a pattern at a wavelength of 410 nm of the photosensitive composition is 300 mJ/cm$^2$ or less, and $S_{400}$ and $S_{410}$ satisfy the relation, $0.6 < S_{400} / S_{410} < 1.6$. The method for preparing such a photosensitive layer is not particularly limited and may be suitably selected depending on the application. A method in which a photosensitizer having a maximum absorption wavelength of 380 nm to 420 nm is contained in a solution for photosensitive composition (photosensitive layer) is exemplified.

The content of the photosensitizer relative to the total content of the photosensitive layer is preferably 0.01% by mass to 5% by mass, more preferably 0.05% by mass to 3% by mass, and still more preferably 0.1% by mass to 1 % by mass from the perspective that the value $S_{410}/S_{400}$ can be readily adjusted ranging from 0.6 to 1.6.

The materials contained in the photosensitive layer are dissolved and emulsified or dispersed in water or a solvent to thereby prepare the solution for a photosensitive composition.

The photosensitive composition solution is not particularly limited and may be suitably selected in accordance with the intended use, and examples thereof include alcohols such as methanol, ethanol, n-propanol, isopropanol, n-butanol, sec-butanol, and n-hexanol; ketones such as acetone, methyl ethyl ketone, methyl isobutyl ketone, cyclohexanone, and diisobutyl ketone; esters such as ethyl acetate, butyl acetate, acetate-n-amyl, methyl sulfate, ethyl propionate, dimethyl phthalate, ethyl benzoate, and methoxy propyl acetate; aromatic hydrocarbons such as toluene, xylene, benzene, and ethyl benzene; halogenated hydrocarbons such as carbon tetrachloride, trichloroethylene, chloroform, 1,1,1-trichloroethane, methylene chloride, and monochlorobenzene; ethers such as tetrahydrofuran, diethyl ether, ethylene glycol monomethy ether, ethylene glycol monoethyl ether, and 1-methoxy-2-propanol; and dimethylformamide, dimethylacetoamide, dimethylsulfoxide, and sulfolane. Each of these compounds may be used alone or in combination with two or more. Further, conventional surfactants may be added thereto.

Next, the photosensitive composition solution is applied on a surface of the support, and the support surface is dried to form a photosensitive layer on the support, thereby a pattern forming material can be produced.

The method for applying the photosensitive composition solution to a support surface is not particularly limited and may be suitably selected in accordance with the intended use. Examples of the method include various coating methods such as spraying method, roll coating method, rotation coating method, slit-coating method, extrusion coating method, curtain-coating method, dye-coating method, gravure coating method, wire-bar coating method, and knife-coating method.

The drying conditions vary depending on the used components, type of solvent, usage ratio thereof, and the like, however, the support surface is typically dried at 60°C to 110°C for about 30 seconds to 15 minutes.

Since the pattern forming material of the present invention has a wavelength of ranging 400 nm to 410 nm and has a substantially constant photosensitivity distribution, the pattern forming material can be preferably used in forming various patterns to be exposed with a light beam at a wavelength ranging from 400 nm to 410 nm, in forming permanent patterns such as interconnection pattern, in producing members having a liquid crystal structure such as color filters, column members, rib members, spacers, and partition members, and in forming patterns such as hologram, micromachine, and proof. The pattern forming material is particularly preferably used in the pattern forming process and the pattern forming apparatus of the present invention.

- Photosensitive Laminate -

The photosensitive laminate is a substrate in which a photosensitive layer containing the photosensitive composition of the present invention and other layers suitably selected in accordance with the intended use are laminated on a substrate surface, and the photosensitive composition includes the photosensitive composition for dry film resist and the photosensitive composition for solder resist.

- Base --

The substrate is a transcription member on which the pattern forming material of the present invention is transcribed, is not particularly limited and may be suitably selected in accordance with the intended use. For example, the substrate may be arbitrarily selected from among those having a high surface planality to those having a concavoconvex surface. A sheet-like substrate is preferably used, and a so-called substrate is used as the substrate. Specific examples thereof include conventional substrates for producing printed wiring board, glass plates (soda glass plates, etc.), synthetic resin films, paper, and metal plates.

-- Method for producing a photosensitive laminate --

As a first embodiment of the method for producing a photosensitive laminate, a method is exemplified in which the photosensitive composition is applied on a surface of the substrate and the substrate surface is dried. As a second embodiment of the method for producing a photosensitive laminate, a method is exemplified in which the pattern forming material of the present invention is transcribed on a substrate surface while performing at least any one of heating or pressurizing the substrate surface to thereby form a photosensitive layer on the substrate surface.

According to the first embodiment of the method for producing a photosensitive laminate, the photosensitive composition is applied on a surface of the substrate, and the substrate surface is dried to thereby for a photosensitive layer.

The method for coating the photosensitive composition and drying the substrate surface is not particularly limited and may be suitably selected in accordance with the intended use. Examples of the method include a method in which the photosensitive composition is dissolved and emulsified or dispersed in water or a solvent to prepare a photosensitive composition solution, the photosensitive composition solution is directly applied on a surface of the substrate, the substrate surface is dried to thereby form a photosensitive layer on the substrate surface.

The solvent of the photosensitive composition solution is not particularly limited and may be suitably selected in accordance with the intended use, and the same solvents as used for the pattern forming material is exemplified. Each of these solvents may be used alone or in combination with two or more. Further, conventional surfactants may be added.

The method of coating the photosensitive composition solution and the drying conditions are not particularly limited and may be suitably selected in accordance with the intended use, and the same coating method and same drying conditions as used for the pattern forming material are used.

The thickness of the photosensitive layer is not particularly limited and may be suitably selected in accordance with the intended use, however, the thickness is preferably 3 μm to 100 μm, and more preferably 5 μm to 70 μm.

According to the second embodiment of the method for producing a photosensitive laminate, the pattern forming material of the present invention is laminated on a surface of the substrate while performing any one of heating and

pressurizing the pattern forming material to thereby form a photosensitive layer on the substrate surface. When the pattern forming material has the protective film, it is preferable that the protective film is peeled off from the substrate, and the pattern forming material is formed on the substrate surface such that the photosensitive layer is overlapped.

The heating temperature is not particularly limited and may be suitably selected in accordance with the intended use. For example, the heating temperature is preferably 15°C to 180°C, and more preferably 60°C to 140°C.

The pressure at the pressurization is not particularly limited and may be suitably selected in accordance with the intended use. For example, the pressure is preferably 0.1 MPa to 1.0 MPa, and more preferably 0.2 MPa to 0.8 MPa.

The apparatus used to perform any one of heating and pressurizing is not particularly limited and may be suitably selected in accordance with the intended use. For example, a laminator (VP-II, manufactured by Taisei Laminator Co., Ltd.) is preferably exemplified.

- Pattern Forming Apparatus and Pattern Forming Process -

In the pattern forming apparatus of the present invention, any one of the pattern forming material and the photosensitive laminate of the present invention is used, and the pattern forming apparatus has at least a light irradiation unit and a light modulating unit.

The pattern forming process of the present invention includes at least an exposure step and other suitably selected steps. The pattern forming apparatus of the present invention will be clarified hereinafter through the descriptions of the pattern forming process of the present invention.

[Exposure Step]

The exposure step is a step in which the photosensitive layer in the pattern forming material of the present invention is exposed. The pattern forming material of the present invention is as described above.

The target of the exposure is not particularly limited and may be suitably selected in accordance with the intended use as long as the target is a photosensitive layer in the pattern forming material. For example, it is preferred to expose a surface of a laminate of which the pattern forming material is formed on a substrate surface.

The substrate is not particularly limited and may be suitably selected in accordance with the intended use. For example, the substrate may be suitably selected from among those having a high surface planality to those having a concavoconvex surface. A sheet-like substrate is preferably used. Specific examples thereof include conventional substrates for producing printed wiring board (such as copper clad laminate), glass plates (soda glass plates, etc.), synthetic resin films, paper, and metal plates.

The layer configuration of the laminate is not particularly limited and may be suitably selected in accordance with the intended use. For examples, the photosensitive laminate preferably has a layer configuration in which the substrate, the photosensitive layer, the barrier layer, and the cushion layer, and the support are formed in this order.

The method for forming a laminate is not particularly limited and may be suitably selected in accordance with the intended use. It is preferred that the pattern forming material is formed on a surface of the substrate while performing at least any one of heating and pressurizing the pattern forming material to thereby form a laminate on the substrate surface.

The heating temperature is not particularly limited and may be suitably selected in accordance with the intended use. For example, the heating temperature is preferably 15°C to 180°C, and more preferably 60°C to 140°C.

The pressure at the pressurization is not particularly limited and may be suitably selected in accordance with the intended use. For example, the pressure is preferably 0.1 MPa to 1.0 MPa, and more preferably 0.2 MPa to 0.8 MPa.

The apparatus used to perform any one of heating and pressurizing is not particularly limited and may be suitably selected in accordance with the intended use. Preferred examples thereof include laminators and vacuum laminators.

The method for exposing the laminate is not particularly limited and may be suitably selected in accordance with the intended use. For example, the photosensitive layer may be exposed through the support, cushion layer, and barrier layer, or the support, cushion layer, and barrier layer may be peeled off from the laminate before exposing the photosensitive layer.

The exposing is not particularly limited and may be suitably selected in accordance with the intended use, and digital exposure and analog exposure are exemplified. Among them, digital exposure is preferable.

The digital exposure is not particularly limited and may be suitably selected in accordance with the intended use. For example, it is preferred that control signals are generated based on the information for forming a pattern to be formed and the laminate is digitally exposed using a light beam which is modulated according to the control signals.

The digital exposure unit is not particularly limited and may be suitably selected in accordance with the intended use. Examples of the digital exposure unit include a light irradiation unit configured to irradiate a target with a light, and a light modulating unit configured to modulate a light applied from the light irradiation unit based on the information of

a pattern to be formed.

< Light Modulating Unit >

The light modulating unit is not particularly limited and may be suitably selected in accordance with the intended use. For example, the light modulating unit preferably has "n" imaging portions.

The light modulating unit having "n" imaging portions is not particularly limited and may be suitably selected in accordance with the intended use. Preferable examples of such a light modulating unit include a spatial light modulator.

Specific examples of the spatial light modulator include a digital micromirror devices (DMDs), spatial light modulators (SLM) of micro electro mechanical system type (MEMS), PLZT elements or optical elements which modulate transmitted light by the effect of electrooptics, and liquid crystal shatters (FLC); among these, the DMDs are preferable.

The light modulating unit preferably has a pattern signal generating unit configured to generate control signals based on the information of a pattern to be formed. In this case, the light modulating unit modulates light beam according to the control signals generated by the pattern signal generating unit.

The control signals are not particularly limited and may be suitably selected in accordance with the intended use. Preferred examples of the control signals are digital signals.

The light modulating unit will be specifically explained with reference to figures in the following.

DMD 50 is a mirror device that has lattice arrays of many micromirrors 62, e.g. 1024 × 768, on SRAM cell or memory cell 60 as shown in FIG. 1, wherein each of the micromirrors serves as an imaging portion. At the upper most portion of the each imaging portion, micromirror 62 is supported by a pillar. A material having a higher reflectivity such as aluminum is vapor deposited on the surface of the micromirror. The reflectivity of the micromirrors 62 is 90 % or more; the array pitches in longitudinal and width directions are respectively 13.7 μm, for example. Further, SRAM cell 60 of a silicon gate CMOS produced by conventional semiconductor memory production processes is disposed just below each micromirror 62 through a pillar containing a hinge and yoke. The mirror device is entirely constructed as a monolithic body.

When a digital signal is written into SRAM cell 60 of DMD 50, micromirror 62 supported by a pillar is inclined toward the substrate, on which DMD 50 is disposed, within ± alpha degrees e.g. 12 degrees around the diagonal as the rotating axis. FIG. 2A indicates the condition that micromirror 62 is inclined + alpha degrees at on state, FIG. 2B indicates the condition that micromirror 62 is inclined - alpha degrees at off state. Therefore, each incident laser beam B on DMD 50 is reflected depending on each inclined direction of micromirrors 62 by controlling each inclined angle of micromirrors 62 in imaging portions of DMD 50 depending on pattern information as shown in FIG. 1.

FIG. 1 exemplarily shows a magnified condition of DMD 50 partly in which micromirrors 62 are controlled at an angel of - alpha degrees or + alpha degrees. Controller 302 (see FIG. 12) connected to DMD 50 carries out on-off controls of the respective micromirrors 62. An optical absorber (not shown) is disposed on the way of laser beam B reflected by micromirrors 62 at off state.

Preferably, DMD 50 is slightly inclined in the condition that the shorter side presents a pre-determined angle, e.g. 0.1 degrees to 5 degrees against the sub-scanning direction. FIG. 3A shows scanning traces of reflected laser image or exposing beam 53 by the respective micromirrors when DMD 50 is not inclined; FIG. 3B shows scanning traces of reflected laser image or exposing beam 53 by the respective micromirrors when DMD 50 is inclined.

In DMD 50, many micromirrors, e.g. 1024, are disposed in the longer direction to form one array, and many arrays, e.g. 756, are disposed in the shorter direction. Thus, by means of inclining DMD 50 as shown in FIG. 3B, the pitch $P_1$ of scanning traces or lines of exposing beam 53 from each micromirror may be reduced than the pitch $P_2$ of scanning traces or lines of exposing beam 53 without inclining DMD 50, thereby the resolution may be improved remarkably. On the other hand, the inclined angle of DMD 50 is small, therefore, the scanning direction $W_2$ when DMD 50 is inclined and the scanning direction $W_1$ when DMD 50 is not inclined are approximately the same.

The method to accelerate the modulation rate of the light modulating unit (hereinafter referring to as "high rate modulation") will be explained in the following.

Preferably, the light modulating unit is able to control any imaging portions of less than "n" disposed successively among the imaging portions depending on the pattern information ("n": an integer of 2 or more). Since there exist a limit in the data processing rate of the light modulating unit and the modulation rate per one line is defined in proportion to the utilized imaging portion number, the modulation rate per one line may be increased by utilizing only the imaging portions of less than "n" disposed successively.

The high rate modulation will be explained with reference to figures in the following.

When laser beam B is applied from fiber array laser source 66 to DMD 50, the reflected laser beam, at the micromirrors of DMD 50 being on state, is imaged on pattern forming material 150 by lens systems 54 and 58. In this way, the laser beam applied from the fiber array laser source is turned into on or off for each imaging portion, and the pattern forming material 150 is exposed in approximately the same number of imaging portion units or exposing areas 168 as the imaging portions utilized in DMD 50. In addition, when the pattern forming material 150 is conveyed with stage 152 at a constant rate, the pattern forming material 150 is sub-scanned to the direction opposite to the stage

moving direction by scanner 162, thus exposed regions 170 of band shape are formed correspondingly to the respective exposing heads 166.

In this example, micromirrors are disposed on DMD 50 as 1,024 arrays in the main-scanning direction and 768 arrays in the sub-scanning direction as shown in FIGs. 4A and 4B. Among these micromirrors, a part of micromirrors, e.g. 1,024 $\times$ 256, may be controlled and driven by the controller 302 (see FIG. 12).

In such control, the micromirror arrays disposed at the central area of DMD 50 may be employed as shown in FIG. 4A; alternatively, the micromirror arrays disposed at the edge portion of DMD 50 may be employed as shown in FIG. 4B. In addition, when micromirrors are partly damaged, the utilized micromirrors may be properly altered depending on the situations such that micromirrors with no damage are utilized.

Since there exist a limit in the data processing rate of DMD 50 and the modulation rate per one line is defined in proportion to the utilized imaging portion number, partial utilization of micromirror arrays leads to higher modulation rate per one line. Further, when exposing is carried out by moving continuously the exposing head relative to the exposing surface, the entire imaging portions are not necessarily required in the sub-scanning direction.

When the sub-scanning of pattern forming material 150 is completed by scanner 162, and the rear end of the pattern forming material 150 is detected by sensor 164, the stage 152 returns to the original site at the most upstream of gate 160 along guide 158, and the stage 152 is moved again from upstream to downstream of the gate 160 along guide 158 at a constant rate.

For example, when 384 arrays are utilized among the 768 arrays of micromirrors, the modulation rate may be enhanced two times per one line as compared to the modulation rate when utilizing all of 768 arrays; further, when 256 arrays are utilized among the 768 arrays of micromirrors, the modulation rate may be enhanced three times as compared to the modulation rate when utilizing all of 768 arrays.

As explained above, when DMD 50 is provided with 1,024 micromirror arrays in the main-scanning direction and 768 micromirror arrays in the sub-scanning direction, controlling and driving of partial micromirror arrays may lead to higher modulation rate per one line compared to the modulation rate in the case of controlling and driving of entire micromirror arrays.

In addition to the controlling and driving of partial micromirror arrays, elongated DMD on which many micromirrors are disposed on a substrate in planar arrays may similarly increase the modulation rate when the each angle of reflected surface is changeable depending on the various controlling signals, and the substrate is longer in a specific direction than its perpendicular direction.

Preferably, the exposing is performed while moving relatively the exposing laser and the thermosensitive layer; more preferably, the exposing is combined with the high rate modulation described above, thereby exposing may be carried out with higher rate in a shorter period.

As shown in FIG. 5, pattern forming material 150 may be exposed on the entire surface by one scanning of scanner 162 in X direction; alternatively, as shown in FIGs. 6A and 6B, pattern forming material 150 may be exposed on the entire surface by repeated plural exposing such that pattern forming material 150 is scanned in X direction by scanner 162, then the scanner 162 is moved one step in Y direction, followed by scanning in X direction. In this example, scanner 162 is provided with eighteen exposing heads 166; each exposing head contains a laser source and the light modulating unit.

The exposure is performed on a partial region of the photosensitive layer, thereby the partial region is hardened, followed by unhardened regions other than the partial hardened region are removed in developing step as set forth later, thus a pattern is formed.

A pattern forming apparatus including the light modulating unit will be exemplarily explained with reference to figures in the following.

The pattern forming apparatus containing the light modulating unit is equipped with flat stage 152 that absorbs and sustains sheet-like pattern forming material 150 on the surface.

On the upper surface of thick plate table 156 supported by four legs 154, two guides 158 are disposed that extend along the stage moving direction. Stage 152 is disposed such that the elongated direction faces the stage moving direction, and supported by guide 158 in reciprocally movable manner. A driving device is equipped with the pattern forming apparatus (not shown) so as to drive stage 152 along guide 158.

At the middle of the table 156, gate 160 is provided such that gate 160 strides the path of stage 152. The respective ends of the gate 160 are fixed to both sides of the table 156. Scanner 162 is provided at one side of gate 160, plural (e.g. two) detecting sensors 164 are provided at the opposite side of gate 160 in order to detect the front and rear ends of pattern forming material 150. Scanner 162 and detecting sensor 164 are mounted on gate 160 respectively and disposed stationarily above the path of stage 152. Scanner 162 and detecting sensor 164 are connected to a controller (not shown) that controls them.

As shown in FIGs. 8 and 9B, scanner 162 contains plural (e.g. fourteen) exposing heads 166 that are arrayed in substantially matrix of "m rows $\times$ n lines" (e.g. three $\times$ five). In this example, four exposing heads 166 are disposed at the third line considering the width of pattern forming material 150. The specific exposing head at "m" th row and "n"

th line is expressed as exposing head $166_{mn}$ hereinafter.

The exposing area 168 formed by exposing head 166 is rectangular having the shorter side in the sub-scanning direction. Therefore, exposed areas 170 are formed on pattern forming material 150 of a band shape that corresponds to the respective exposing heads 166 along with the movement of stage 152. The specific exposing area corresponding to the exposing head at "m" th row and "n" th line is expressed as exposing area $168_{mn}$ hereinafter.

As shown in FIGs. 9A and 9B, each of the exposing heads at each line is disposed with a space in the line direction so that exposed regions 170 of band shape are arranged without space in the perpendicular direction to the sub-scanning direction (space: (longer side of exposing area) × natural number; two times in this example). Therefore, the non-exposing area between exposing areas $168_{11}$ and $168_{12}$ at the first raw can be exposed by exposing area $168_{21}$ of the second raw and exposing area $168_{31}$ of the third raw.

Each of exposing heads $166_{11}$ to $166_{mn}$ is provided with a digital micromirror device (DMD) 50 (manufactured by US Texas Instruments Inc.) as a light modulating unit or spatial light modulator that modulates the incident laser beam depending on the pattern information as shown in FIGs. 10 and 11. Each DMD 50 is connected to controller 302 that contains a data processing part and a mirror controlling part as shown in FIG. 12. The data processing part of controller 302 generates controlling signals to control and drive the respective micromirrors in the areas to be controlled for the respective exposing heads 166 based on the input pattern information. The area to be controlled will be explained later. The mirror driving-controlling part controls the reflective surface angle of each micromirror of DMD 50 per each exposing head 166 based on the control signals generated at the pattern information processing part. The control of the reflective surface angle will be explained later.

At the incident laser side of DMD 50, fiber array laser source 66 that is equipped with a laser irradiating part where irradiating ends or emitting sites of optical fibers are arranged in an array along the direction corresponding with the longer side of exposing area 168, lens system 67 that compensates the laser beam emitted from fiber array laser source 66 and collects it on the DMD, and mirrors 69 that reflect laser beam through lens system 67 toward DMD 50 are disposed in this order. FIG. 10 schematically shows lens system 67.

Lens system 67 is provided with collective lens 71 that collects laser beam B for illumination from fiber array laser source 66, rod-like optical integrator 72 (hereinafter, referring to as "rod integrator") inserted on the optical path of the laser passed through collective lens 71, and image lens 74 disposed in front of rod integrator 72 or the side of mirror 69, as shown FIG. 11. Collective lens 71, rod integrator 72, and image lens 74 make the laser beam applied from fiber array laser source 66 enter into DMD 50 as a luminous flux of approximately parallel beam with uniform intensity in the cross section. The shape and effect of the rod integrator will be explained in detail later.

Laser beam B irradiated from lens system 67 is reflected by mirror 69, and is irradiated to DMD 50 through a total internal reflection prism 70 (not shown in FIG. 10).

At the reflecting side of DMD 50, imaging optical system 51 is disposed which images laser beam B reflected by DMD 50 onto pattern forming material 150. The imaging optical system 51 is equipped with the first imaging optical system of lens systems 52, 54, the second imaging optical system of lens systems 57, 58, and microlens array 55 and aperture array 59 interposed between these imaging systems as shown in FIG. 11.

Arranging two-dimensionally many microlenses 55a each corresponding to the respective imaging portions of DMD 50 forms microlens array 55. In this example, micromirrors of 1,024 rows × 256 lines among 1,024 rows × 768 lines of DMD 50 are driven, therefore, 1,024 rows × 256 lines of microlenses are disposed correspondingly. The pitch of disposed microlenses 55a is 41 μm in both of raw and line directions. Microlenses 55a have a focal length of 0.19 mm and a numerical aperture (NA) of 0.11 for example, and are formed of optical glass BK7. The shape of microlenses will be explained later. The beam diameter of laser beam B is 41 μm at the site of microlens 55a.

Aperture array 59 is formed of many apertures 59a each corresponding to the respective microlenses 55a of microlens array 55. The diameter of aperture 59a is 10 μm, for example.

The first imaging system forms the image of DMD 50 on microlens array 55 as a three times magnified image. The second imaging system forms and projects the image through microlens array 55 on pattern forming material 150 as a 1.6 times magnified image. Therefore, the image by DMD 50 is formed and projected on pattern forming material 150 as a 4.8 times magnified image.

Prism pair 73 is installed between the second imaging system and pattern forming material 150; through the operation to move up and down the prism pair 73, the image pint may be adjusted on the image forming material 150. In FIG. 11, pattern forming material 150 is fed to the direction of arrow F as sub-scanning.

The imaging portions are not particularly limited and may be properly selected in accordance with the intended use, provided that the imaging portions can receive the laser beam from the laser source or irradiating unit and can output the laser beam; for example, the imaging portions are pixels when the pattern formed by the pattern forming process according to the present invention is an image pattern, alternatively the imaging portions are micromirrors when the light modulating unit contains a DMD.

The number of imaging portions ("n") contained in the light modulating unit may be properly selected in accordance with the intended use.

The alignment of imaging portions in the light modulating unit may be properly selected in accordance with the intended use; preferably, the imaging portions are arranged two dimensionally, more preferably are arranged into a lattice pattern.

< Light Irradiating Unit >

The light irradiation unit may be properly selected in accordance with the intended use; examples thereof include an extremely high pressure mercury lamp, xenon lamp, carbon arc lamp, halogen lamp, fluorescent tube, LED, semiconductor laser, and the other conventional laser source, and also combination of these units. Among these units, a unit capable of irradiating two or more types of light or laser beam is preferable.

Examples of the light or laser beam emitted from the optical irradiating unit include electromagnetic rays, UV-rays, visible light, electron beam, X-ray, laser beam, each of which penetrates the substrate and activates photopolymerization initiators and sensitizers to be used. Among these, laser beam is preferable, and those containing two or more types of light (hereinafter, sometimes referring to as "combined laser") are more preferable. When the support is first exfoliated from the photosensitive layer and then is irradiated with light or laser beam similarly to the above can be also used.

The wavelength of the UV-rays and the visual light is preferably 300 nm to 1,500 nm, more preferably 320 nm to 800 nm, and most preferably 330 nm to 650 nm.

The wavelength of the laser beam is preferably 200 nm to 1,500 nm, more preferably 300 nm to 800 nm, still more preferably 330 nm to 500 nm, and most preferably 400 nm to 410 nm. Specifically, a laser beam having a wavelength of 405 nm output from a GaN semiconductor laser is the most preferable.

As for the unit to irradiate the combined laser, such a unit is preferably exemplified which contains plural laser irradiating devices, a multimode optical fiber, and a collecting optical system that collects respective laser beams and connect them to the multimode optical fiber.

The unit to irradiate combined laser or the fiber array laser source will be explained with reference to figures in the following.

Fiber array laser source 66 is equipped with plural (e.g. fourteen) laser modules 64 as shown in FIG. 27A. One end of each multimode optical fiber 30 is connected to each laser module 64. The other end of each multimode optical fiber 30 is connected to optical fiber 31 of which the core diameter is the same as that of multimode optical fiber 30 and of which the clad diameter is smaller than that of multimode optical fiber 30. As shown in FIG. 27B specifically, the ends of multimode optical fibers 31 at the opposite end of multimode optical fiber 30 are aligned as seven ends along the main scanning direction perpendicular to the sub-scanning direction, and the seven ends are aligned as two rows, thereby laser output portion 68 is constructed.

The laser output portion 68, formed of the ends of multimode optical fibers 31, is fixed by being interposed between two flat support plates 65 as shown in FIG. 27B. Preferably, a transparent protective plate such as a glass plate is disposed on the output end surface of multimode optical fibers 31 in order to protect the output end surface. The output end surface of multimode optical fibers 31 tends to bear dust and to degrade due to its higher optical density; the protective plate set forth above may prevent the dust deposition on the end surface and may retard the degradation.

In this example, in order to align optical fibers 31 having a lower clad diameter into an array without a space, multimode optical fiber 30 is stacked between two multimode optical fibers 30 that contact at the larger clad diameter, and the output end of optical fiber 31 connected to the stacked multimode optical fiber 30 is interposed between two output ends of optical fibers 31 connected to two multimode optical fibers 30 that contact at the larger clad diameter.

Such optical fibers may be produced by connecting concentrically optical fibers 31 having a length of 1 cm to 30 cm and a smaller clad diameter to the tip portions of laser beam output side of multimode optical fiber 30 having a larger clad diameter, for example, as shown in FIG. 28. Two optical fibers are connected such that the input end surface of optical fiber 31 is fused to the output end surface of multimode optical fiber 30 so as to coincide the center axes of the two optical fibers. The diameter of core 31a of optical fiber 31 is the same as the diameter of core 30a of multimode optical fiber 30 as set forth above.

Further, a shorter optical fiber produced by fusing an optical fiber having a smaller clad diameter to an optical fiber having a shorter length and a larger clad diameter may be connected to the output end of multimode optical fiber through a ferrule, optical connector or the like. The connection through a connector and the like in an attachable and detachable manner may bring about easy exchange of the output end portion when the optical fibers having a smaller clad diameter are partially damaged for example, resulting advantageously in lower maintenance cost for the exposing head. Optical fiber 31 is sometimes referred to as "output end portion" of multimode optical fiber 30.

Multimode optical fiber 30 and optical fiber 31 may be any one of step index type optical fibers, grated index type optical fibers, and combined type optical fibers. For example, step index type optical fibers produced by Mitsubishi Cable Industries, Ltd. are available. In one of the best mode according to the present invention, multimode optical fiber 30 and optical fiber 31 are step index type optical fibers; in the multimode optical fiber 30, clad diameter = 125 $\mu$m, core

diameter = 50 μm, NA = 0.2, transmittance = 99.5 % or more (at coating on input end surface); and in the optical fiber 31, clad diameter = 60 μm, core diameter = 50 μm, NA = 0.2.

Laser beams at infrared region typically increase the propagation loss while the clad diameter of optical fibers decreases. Accordingly, a proper clad diameter is defined usually depending on the wavelength region of the laser beam. However, the shorter is the wavelength, the less is the propagation loss; for example, in the laser beam of wavelength 405 nm applied from GaN semiconductor laser, even when the clad thickness (clad diameter - core diameter)/2 is made into about 1/2 of the clad thickness at which infrared beam of wavelength 800 nm is typically propagated, or made into about 1/4 of the clad thickness at which infrared beam of wavelength 1.5 μm for communication is typically propagated, the propagation loss does not increase significantly. Therefore, the clad diameter is possible to be as small as 60 μm.

Needless to say, the clad diameter of optical fiber 31 should not be limited to 60 μm. The clad diameter of optical fiber utilized for conventional fiber array laser sources is 125 μm; the smaller is the clad diameter, the deeper is the focal depth; therefore, the clad diameter of the multimode optical fiber is preferably 80 μm or less, more preferably 60 μm or less, still more preferably 40 μm or less. In the meanwhile, since the core diameter is appropriately at least 3 to 4 μm, the clad diameter of optical fiber 31 is preferably 10 μm or more.

Laser module 64 is constructed from the combined laser source or the fiber array laser source as shown in FIG. 29. The combined laser source is constructed from plural (e.g. seven) multimode or single mode GaN semiconductor lasers LD1, LD2, LD3, LD4, LD5, LD6 and LD7 disposed and fixed on heat block 10, collimator lenses 11, 12, 13, 14, 15, 16, and 17, one collecting lens 20, and one multimode optical fiber 30. Needless to say, the number of semiconductor lasers is not limited to seven. For example, with respect to the multimode optical fiber having clad diameter = 60 μm, core diameter = 50 μm, NA = 0.2, as much as twenty semiconductor lasers may be input, thus the number of optical fibers may be reduced while attaining the necessary optical quantity of the exposing head.

GaN semiconductor lasers LD1 to LD7 have a common oscillating wavelength e.g. 405 nm, and a common maximum output e.g.100 mW as for multimode lasers and 30 mW as for single mode lasers. The GaN semiconductor lasers LD1 to LD7 may be those having an oscillating wavelength of other than 405 nm as long as within the wavelength of 350 to 450 nm.

The combined laser source is housed into a box package 40 having an upper opening with other optical elements as shown in FIGs. 30 and 31. The package 40 is equipped with package lid 41 for shutting the opening. Introduction of sealing gas after evacuating procedure and shutting the opening of package 40 by means of package lid 41 presents a closed space or sealed volume constructed by package 40 and package lid 41, and the combined laser source is disposed in a sealed condition.

Base plate 42 is fixed on the bottom of package 40; the heat block 10, collective lens holder 45 to support collective lens 20, and fiber holder 46 to support the input end of multimode optical fiber 30 are mounted to the upper surface of the base plate 42. The output end of multimode optical fiber 30 is drawn out of the package from the aperture provided at the wall of package 40.

Collimator lens holder 44 is attached to the side wall of heat block 10, and collimator lenses 11 to 17 are supported thereby. An aperture is provided at the side wall of package 40, and interconnection 47 that supplies driving power to GaN semiconductor lasers LD1 to LD7 is directed through the aperture out of the package.

In FIG. 31, only the GaN semiconductor laser LD7 is indicated with a reference mark among plural GaN semiconductor laser, and only the collimator lens 17 is indicated with a reference number among plural collimators, in order not to make the figure excessively complicated.

FIG. 32 shows a front shape of attaching part for collimator lenses 11 to 17. Each of collimator lenses 11 to 17 is formed into a shape that a circle lens containing a non-spherical surface is cut into an elongated piece with parallel planes at the region containing the optical axis. The collimator lens with the elongated shape may be produced by a molding process. The collimator lenses 11 to 17 are closely disposed in the aligning direction of emitting points such that the elongated direction is perpendicular to the alignment of the emitting points of GaN semiconductor lasers LD1 to LD7.

In the meanwhile, as for GaN semiconductor lasers LD1 to LD7, the following laser may be employed which contains an active layer having an emitting width of 2 μm and emits the respective laser beams B1 to B7 under the condition that the divergence angle is 10 degrees and 30 degrees for the parallel and perpendicular directions against the active layer. The GaN semiconductor lasers LD1 to LD7 are disposed such that the emitting sites align as one line in parallel to the active layer.

Accordingly, laser beams B1 to B7 emitted from the respective emitting sites enter into the elongated collimator lenses 11 to 17 in a condition that the direction having a larger divergence angle coincides with the length direction of each collimator lens and the direction having a less divergence angle coincides with the width direction of each collimator lens. Namely, the width is 1.1 mm and the length is 4.6 mm with respect to respective collimator lenses 11 to 17, and the beam diameter is 0.9 mm in the horizontal direction and is 2.6 mm in the vertical direction with respect to laser beams B1 to B7 that enter into the collimator lenses. As for the respective collimator lenses 11 to 17, focal length f1 = 3 mm, NA = 0.6, pitch of disposed lenses =1.25 mm.

Collective lens 20 formed into a shape that a part of circle lens containing the optical axis and non-spherical surface is cut into an elongated piece with parallel planes and is arranged such that the elongated piece is longer in the direction of disposing collimator lens 11 to 17 i.e. horizontal direction, and is shorter in the perpendicular direction. As for the collective lens, focal length f2 = 23 mm, NA = 0.2. The collective lens 20 may be produced by molding a resin or optical glass, for example.

Further, since a high luminous fiber array laser source is employed that is arrayed at the output ends of optical fibers in the combined laser source for the illumination unit to illuminate the DMD, a pattern forming apparatus that exhibits a higher output and a deeper focal depth may be attained. In addition, the higher output of the respective fiber array laser sources may lead to less number of fiber array laser sources required to take a necessary output as well as a lower cost of the pattern forming apparatus.

In addition, the clad diameter at the output ends of the optical fibers is smaller than the clad diameter at the input ends, therefore, the diameter at emitting sites is reduced still, resulting in higher luminance of the fiber array laser source. Consequently, pattern forming apparatuses provided with a deeper focal depth may be achieved. For example, a sufficient focal depth may be obtained even for the extremely high resolution exposure such that the beam diameter is 1 $\mu$m or less and the resolution is 0.1 $\mu$m or less, thereby enabling rapid and precise exposure. Accordingly, the pattern forming apparatus is appropriate for the exposure of thin film transistor (TFT) that requires high resolution.

The illumination unit is not limited to the fiber array laser source that is equipped with plural combined laser sources; for example, such a fiber array laser source may be employed that is equipped with one fiber laser source, and the fiber laser source is constructed by one arrayed optical fiber that outputs a laser beam from one semiconductor laser having an emitting site.

Further, as for the illumination unit having plural emitting sites, such a laser array may be employed that contains plural (e.g. seven) tip-like semiconductor lasers LD1 to LD7 disposed on heat block 100 as shown in FIG. 33. In addition, multi cavity laser 110 is known which contains plural (e.g. five) emitting sites 110a disposed in a certain direction as shown in FIG. 34A. In the multi cavity laser 110, the emitting sites can be arrayed with higher dimensional accuracy as compared to arraying tip-like semiconductor lasers, thus laser beams emitted from the respective emitting sites can be easily combined. Preferably, the number of emitting sites 110a is five or less because deflection tends to arise on multi cavity laser 110 at the laser production process when the number increases.

Concerning the illumination unit, the multi cavity laser 110 set forth above, or the multi cavity array disposed such that plural multi cavity lasers 110 are arrayed in the same direction as emitting sites 110a of each tip as shown in FIG. 34B may be employed for the laser source.

The combined laser source is not limited to the types that combine plural laser beams emitted from plural tip-like semiconductor lasers. For example, such a combined laser source is available that contains tip-like multi cavity laser 110 having plural (e.g. three) emitting sites 110a as shown in FIG. 21. The combined laser source is equipped with multi cavity laser 110, one multimode optical fiber 130, and collecting lens 120. The multi cavity laser 110 may be constructed from GaN laser diodes having an oscillating wavelength of 405 nm, for example.

In the above noted construction, each laser beam B emitted from each of plural emitting sites 110a of multi cavity laser 110 is collected by collective lens 120 and enters into core 130a of multimode optical fiber 130. The laser beams entered into core 130a propagate inside the optical fiber and combine as one laser beam then output from the optical fiber.

The connection efficiency of laser beam B to multimode optical fiber 130 may be enhanced by way of arraying plural emitting sites 110a of multi cavity laser 110 into a width that is approximately the same as the core diameter of multimode optical fiber 130, and employing a convex lens having a focal length of approximately the same as the core diameter of multimode optical fiber 130, and also employing a rod lens that collimates the output beam from multi cavity laser 110 at only within the surface perpendicular to the active layer.

In addition, as shown in FIG. 35, a combined laser source may be employed which is equipped with laser array 140 formed by arraying on heat block 111 plural (e.g. nine) multi cavity lasers 110 with an identical space between them by employing multi cavity lasers 110 equipped with plural (e.g. three) emitting sites. The plural multi cavity lasers 110 are arrayed and fixed in the same direction as emitting sites 110a of the respective tips.

The combined laser source is equipped with laser array 140, plural lens arrays 114 that are disposed correspondingly to the respective multi cavity lasers 110, one rod lens 113 that is disposed between laser array 140 and plural lens arrays 114, one multimode optical fiber 130, and collective lens 120. Lens arrays 114 are equipped with plural microlenses each corresponding to emitting sites of multi cavity lasers 110.

In the above noted construction, laser beams B that are emitted from plural emitting sites 110a of plural multi cavity lasers 110 are collected in a certain direction by rod lens 113, then are paralleled by the respective microlenses of microlens arrays 114. The paralleled laser beams L are collected by collective lens 120 and are input into core 130a of multimode optical fiber 130. The laser beams entered into core 130a propagate inside the optical fiber and combine as one beam then output from the optical fiber.

Another combined laser source will be exemplified in the following. In the combined laser source, heat block

182 having a cross section of L-shape in the optical axis direction is installed on rectangular heat block 180 as shown in FIGS. 36A and 36B, and a housing space is formed between the two heat blocks. On the upper surface of L-shape heat block 182, plural (e.g. two) multi cavity lasers 110, in which plural (e.g. five) emitting sites are arrayed, are disposed and fixed with an identical space between them in the same direction as the aligning direction of respective tip-like emitting sites.

A concave portion is provided on the substantially rectangular heat block 180; plural (e.g. two) multi cavity lasers 110 are disposed on the upper surface of heat block 180, plural emitting sites (e.g. five) are arrayed in each multi cavity laser 110, and the emitting sites are situated at the same vertical surface as the surface where the emitting sites of the laser tip disposed on the heat block 182 are situated.

At the laser beam output side of multi cavity laser 110, collimate lens arrays 184 are disposed such that collimate lenses are arrayed correspondingly with the emitting sites 110a of the respective tips. In the collimate lens arrays 184, the length direction of each collimate lens coincides with the direction at which the laser beam represents wider divergence angle or the fast axis direction, and the width direction of each collimate lens coincides with the direction at which the laser beam represents less divergence angle or the slow axis direction. The integration by arraying the collimate lenses may increase the space efficiency of laser beam, thus the output power of the combined laser source may be enhanced, and also the number of parts may be reduced, resulting advantageously in lower production cost.

At the laser beam output side of collimate lens arrays 184, disposed are one multimode optical fiber 130 and collective lens 120 that collects laser beams at the input end of multimode optical fiber 130 and combines them.

In the above noted construction, the respective laser beams B emitted from the respective emitting sites 110a of plural multi cavity lasers 110 disposed on laser blocks 180, 182 are paralleled by collimate lens array, are collected by collective lens 120, then entered into core 130a of multimode optical fiber 130. The laser beams entered into core 130a propagate inside the optical fiber and combine as one beam then output from the optical fiber.

The combined laser source may be made into a higher output power source by multiple arrangement of the multi cavity lasers and the array of collimate lenses in particular. The combined laser source allows to construct a fiber array laser source and a bundle fiber laser source, thus is appropriate for the fiber laser source to construct the laser source of the pattern forming apparatus in the present invention.

A laser module may be constructed by housing the respective combined laser sources into a casing, and drawing out the output end of multimode optical fiber 130.

In the explanations set forth above, the higher luminance of fiber array laser source is exemplified which the output end of the multimode optical fiber of the combined laser source is connected to another optical fiber that has the same core diameter as that of the multimode optical fiber and a clad diameter smaller than that of the multimode optical fiber; alternatively a multimode optical fiber having a clad diameter of 125 μm, 80 μm, 60 μm or the like may be utilized without connecting another optical fiber at the output end, for example.

The pattern forming process of the present invention will be explained further.

As shown in FIG. 29, in each exposing head 166 of scanner 162, the respective laser beams B1, B2, B3, B4, B5, B6, and B7, emitted from GaN semiconductor lasers LD1 to LD 7 that constitute the combined laser source of fiber array laser source 66, are paralleled by the corresponding collimator lenses 11 to 17. The paralleled laser beams B1 to B7 are collected by collective lens 20 and converge at the input end surface of core 30a of multimode optical fiber 30.

In this example, the collective optical system is constructed from collimator lenses 11 to 17 and collective lens 20, and the combined optical system is constructed from the collective optical system and multimode optical fiber 30. Namely, laser beams B1 to B7 that are collected by collective lens 20 enter into core 30a of multimode optical fiber 30 and propagate inside the optical fiber, combine into one laser beam B, then output from optical fiber 31 that is connected at the output end of multimode optical fiber 30.

In each laser module, when the coupling efficiency of laser beams B1 to B7 with multimode optical fiber 30 is 0.85 and each output of GaN semiconductor lasers LD1 to LD7 is 30 mW, each optical fiber disposed in an array can take combined laser beam B of output 180 mW (= 30 mW $\times$ 0.85 $\times$ 7). Accordingly, the output is about 1 W (= 180 mW $\times$ 6) at laser emitting portion 68 of the array of six optical fibers 31.

Laser emitting portions 68 of fiber array source 66 are arrayed such that the higher luminous emitting sites are aligned along the main scanning direction. The conventional fiber laser source that connects laser beam from one semiconductor laser to one optical fiber is of lower output, therefore, a desirable output cannot be attained unless many lasers are arrayed; whereas the combined laser source of lower number (e.g. one) array can produce the desirable output because the combined laser source may generate a higher output.

For example, in the conventional fiber where one semiconductor laser and one optical fiber are connected, a semiconductor laser of about 30 mW output is usually employed, and a multimode optical fiber that has a core diameter of 50 μm, a clad diameter of 125 μm, and a numerical aperture of 0.2 is employed as the optical fiber. Therefore, in order to take an output of about 1 W (Watt), 48 (8 $\times$ 6) multimode optical fibers are necessary; since the area of emitting region is 0.62 $mm^2$ (0.675 mm $\times$ 0.925 mm), the luminance at laser emitting portion 68 is 1.6 $\times$ $10^6$ ($W/m^2$), and the luminance per one optical fiber is 3.2 $\times$ $10^6$ ($W/m^2$).

In contrast, when the laser emitting unit is one capable of emitting the combined laser, six multimode optical fibers can produce the output of about 1 W. Since the area of the emitting region in laser emitting portion 68 is 0.0081 $mm^2$ (0.325 mm $\times$ 0.025 mm), the luminance at laser emitting portion 68 is 123 $\times$ $10^6$ ($W/m^2$), which corresponds to about 80 times the luminance of conventional units. The luminance per one optical fiber is 90 $\times$ $10^6$ ($W/m^2$), which corresponds to about 28 times the luminance of conventional unit.

The difference of focal depth between the conventional exposing head and the exposing head in the present invention will be explained with reference to FIGs. 37A and 37B. For example, the diameter of exposing head is 0.675 mm in the sub-scanning direction of the emitting region of the bundle-like fiber laser source, and the diameter of exposing head is 0.025 mm in the sub-scanning direction of the emitting region of the fiber array laser source. As shown in FIG. 37A, in the conventional exposing head, the emitting region of illuminating unit or bundle-like fiber laser source 1 is larger, therefore, the angle of laser bundle that enters into DMD3 is larger, resulting in larger angle of laser bundle that enters into scanning surface 5. Therefore, the beam diameter tends to increase in the collecting direction, resulting in a deviation in focus direction.

In the meanwhile, as shown in FIG. 37B, the exposing head of the pattern forming apparatus in the present invention has a smaller diameter of the emitting region of fiber array laser source 66 in the sub-scanning direction, therefore, the angle of laser bundle that enters into DMD50 through lens system 67 is smaller, resulting in lower angle of laser bundle that enters into scanning surface 56, i.e. larger focal depth. In this example, the diameter of the emitting region is about 30 times the diameter of prior art in the sub-scanning direction, thus the focal depth approximately corresponding to the limited diffraction may be obtained, which is appropriate for the exposing at extremely small spots. The effect on the focal depth is more significant as the optical quantity required at the exposing head comes to larger. In this example, the size of one imaging portion projected on the exposing surface is 10 $\mu m$ $\times$ 10 $\mu m$. The DMD is a spatial light modulator of reflected type; in FIGs. 37A and 37B, it is shown as developed views to explain the optical relation.

The pattern information corresponding to the exposing pattern is input into a controller (not shown) connected to DMD50, and is memorized once to a flame memory within the controller. The pattern information is the data that expresses the concentration of each imaging portion that constitutes the pixels by means of binary i.e. presence or absence of the dot recording.

Stage 152 that absorbs pattern forming material 150 on the surface is conveyed from upstream to downstream of gate 160 along guide 158 at a constant velocity by a driving device (not shown). When the tip of pattern forming material 150 is detected by detecting sensor 164 installed at gate 160 while stage 152 passes under gate 160, the pattern information memorized at the flame memory is read plural lines by plural lines sequentially, and controlling signals are generated for each exposing head 166 based on the pattern information read by the data processing portion. Then, each micromirror of DMD50 is subjected to on-off control for each exposing head 166 based on the generated controlling signals.

When a laser beam is applied from fiber array laser source 66 onto DMD50, the laser beam reflected by the micromirror of DMD50 at on-condition is imaged on exposed surface 56 of pattern forming material 150 by means of lens systems 54, 58. As such, the laser beams emitted from fiber array laser source 66 are subjected to on-off control for each imaging portion, and pattern forming material 150 is exposed by imaging portions or exposing area 168 of which the number is approximately the same as that of imaging portions employed in DMD50. Further, through moving the pattern forming material 150 at a constant velocity along with stage 152, pattern forming material 150 is subjected to sub-scanning in the direction opposite to the stage moving direction by means of scanner 162, and band-like exposed region 170 is formed for each exposing head 166.

< Microlens Array >

Preferably, the photosensitive layer is exposed by applying the modulated laser beam through a microlens array, and further through an aperture array, image optics, and the like.

The microlens array is not particularly limited and may be suitably selected in accordance with the intended use. Preferred examples thereof include those having a non-spherical surface capable of compensating the aberration due to distortion at irradiating surface of the imaging portion.

The non-spherical surface is not particularly limited and may be properly selected in accordance with the intended use; preferably, the non-spherical surface is a toric surface, for example.

The microlens array, aperture array, imaging system set forth above will be explained with reference to figures.

FIG.13A shows an exposing head that is equipped with DMD 50, laser source 144 to irradiate laser beam onto DMD 50, lens systems or imaging optical systems 454 and 458 that magnify and image the laser beam reflected by DMD 50, microlens array 472 in which many microlenses 474 corresponding to the respective imaging portions of DMD 50 are arranged, aperture array 476 that aligns many apertures 478 corresponding to the respective microlenses of microlens array 472, and lens systems or imaging systems 480 and 482 that image laser beam through the apertures onto exposed surface 56.

FIG. 14 shows the flatness data as to the reflective surface of micromirrors 62 of DMD 50. In FIG. 14, contour lines express the respective same heights of the reflective surface; the pitch of the contour lines is five nano meters. In FIG. 14, X direction and Y direction are two diagonal directions of micromirror 62, and the micromirror 62 rotates around the rotation axis extending in Y direction. FIGs. 15A and 15B show the height displacements of micromirrors 62 along the X and Y directions respectively.

As shown in FIGs. 14, 15A and 15B, there exist strains on the reflective surface of micromirror 62, the strains of one diagonal direction (Y direction) is larger than another diagonal direction (X direction) at the central region of the mirror in particular. Accordingly, a problem may arise in which the shape is distorted at the site that collects laser beam B by microlenses 55a of microlens array 55.

In order to prevent such a problem, microlenses 55a of microlens array 55 are of special shape that is different from the prior art as explained later.

FIGs. 16A and 16B show the front shape and side shape of the entire microlens array 55 in detail. In FIGs. 16A and 16B, various parts of the microlens array are indicated as the unit of mm (millimeter). In the pattern forming process according to the present invention, micromirrors of 1,024 rows × 256 lines of DMD 50 are driven as explained above; microlens arrays 55 are correspondingly constructed as 1,024 arrays in length direction and 256 arrays in width direction. In FIG. 16A, the site of each microlens is expressed as "j" th line and "k" th row.

FIGs. 17A and 17B respectively show the front shape and side shape of one microlens 55a of microlens array 55. FIG. 17A also shows the contour lines of microlens 55a. The end surface of each microlens 55a of irradiating side is of a non-spherical shape to compensate the strain aberration of reflective surface of micromirrors 62. Specifically, microlens 55a is a toric lens; the curvature radius of optical X direction Rx is - 0.125 mm, and the curvature radius of optical Y direction Ry is - 0.1 mm.

Accordingly, the collecting condition of laser beam B within the cross section parallel to the X and Y directions are approximately as shown in FIGs. 18A and 18B respectively. Namely, comparing the X and Y directions, the curvature radius of microlens 55a is shorter, and the focal length is also shorter in Y direction.

FIGs. 19A, 19B, 19C, and 19D show the simulations of beam diameter near the focal point of microlens 55a in the above noted shape by means of a computer. For the reference, FIGs. 20A, 20B, 20C, and 20D show the similar simulations for microlens in a spherical shape of Rx = Ry = - 0.1 mm. The values of "z" in the figures are expressed as the evaluation sites in the focus direction of microlens 55a by the distance from the beam irradiating surface of microlens 55a.

The surface shape of microlens 55a in the simulation may be calculated by the following equation (1).

$$Z = \frac{C_x{}^2 X^2 + C_y{}^2 Y^2}{1 + SQRT\ (1 - C_x{}^2 X^2 - C_y{}^2 Y^2)}$$

In the above equation, Cx means the curvature (=1/Rx) in X direction, Cy means the curvature (=1/Ry) in Y direction, X means the distance from optical axis O in X direction, and Y means the distance from optical axis O in Y direction.

From the comparison of FIGs. 19A to 19D, and FIGs. 20A to 20D, it is apparent in the pattern forming process according to the present invention that the employment of the toric lens as the microlens 55a that has a shorter focal length in the cross section parallel to Y direction than the focal length in the cross section parallel to X direction may reduce the strain of the beam shape near the collecting site. Accordingly, images can be exposed on pattern forming material 150 with more clearness and without strain. In addition, it is apparent that the inventive mode shown in FIGs. 19A to 19D may bring about a wider region with smaller beam diameter, i.e. longer focal depth.

When the larger or smaller strain at the central region appears at the central region of micromirror 62 inversely with those set forth above, the employment of microlenses that has a shorter focal length in the cross section parallel to X direction than the focal length in the cross section parallel to Y direction may make possible to expose images on pattern forming material 150 with more clearness and without strain or distortion.

Aperture arrays 59 disposed near the collecting site of microlens array 55 are constructed such that each aperture 59a receives only the laser beam through the corresponding microlens 55a. Namely, aperture array 59 may afford the respective apertures with the insurance that the light incidence from the adjacent apertures 55a may be prevented and the extinction ratio may be enhanced.

Essentially, smaller diameter of apertures 59a provided for the above noted purpose may afford the effect to reduce the strain of beam shape at the collecting site of microlens 55a. However, such a construction inevitably increases the optical quantity interrupted by the aperture array 59, resulting in lower efficiency of optical quantity. On the contrary,

the non-spherical shape of microlenses 55a does not bring about the light interruption, thus the higher efficiency of optical quantity can be maintained.

In the pattern forming process explained above, microlens 55a of toric lens is applied which has different curvature radiuses in X and Y directions that respectively correspond to two diagonal directions of micromirror 62; alternatively, another microlens 55a' of toric lens may be applied which has different curvature radiuses in XX and YY directions that respectively correspond to two side directions of rectangular micromirror 62, as shown in FIGs. 38A and 38B that exhibit the front and side shapes with contour lines.

In the pattern forming process according to the present invention, the microlenses 55a may be non-spherical shape of secondary or higher order such as fourth or sixth. The employment of higher order non-spherical surface may lead to higher accuracy of beam shape.

In the mode set forth above, the end surface of irradiating side of microlens 55a is non-spherical or toric; alternatively, substantially the same effect may be derived by constructing one of the end surface as a spherical surface and the other surface as a cylindrical surface and thus providing the microlens.

Further, in the mode set forth above, each microlens 55a of microlens array 55 is non-spherical so as to compensate the aberration due to the strain of reflective surface of micromirror 62; alternatively, substantially the same effect may be derived by providing each microlens of the microlens array with the distribution of refractive index so as to compensate the aberration due to the strain of reflective surface of micromirror 62.

FIGs. 22A and 22B show exemplarily such a microlens 155a. FIGs. 22A and 22B respectively show the front shape and side shape of microlens 155a. The entire shape of microlens 155a is a planar plate as shown in FIGs. 22A and 22B. The X and Y directions in FIGs. 22A and 22B mean the same as set forth above.

FIGs. 23A and 23B schematically show the condition to collect laser beam B by microlens 155a in the cross section parallel with X and Y directions respectively. The microlens 155a exhibits a refractive index distribution that the refractive index gradually increases from the optical axis O to outward direction; the broken lines in FIGs. 23A and 23B indicate the positions where the refractive index decreases a certain level from that of optical axis O. As shown in FIGs. 23A and 23B, comparing the cross section parallel to the X direction and the cross section parallel to the Y direction, the latter represents a rapid change in the refractive index distribution, and shorter focal length. Thus, the microlens array having such a refractive index distribution may provide the similar effect as the microlens array 55 set forth above.

In addition, the microlens having a non-spherical surface as shown in FIGs. 17A, 17B, 18A and 18B may be provided with such a refractive index distribution, and both of the surface shape and the refractive index distribution may compensate the aberration due to strain or distortion of the reflective surface of micromirror 62.

In the respective microlens array set forth above, the aberration due to strain of reflective surface of micromirror 62 in DMD 50 is compensated; similarly, in the pattern forming process according to the present invention that employs a spatial light modulator other than DMD, the possible aberration due to strain may be compensated and the strain of beam shape may be prevented when the strain appears at the surface of imaging portion of the spatial light modulator.

The imaging optical system set forth above will be explained in the following.

In the exposing head, when laser beam is applied from the laser source 144, the cross section of luminous flux reflected to on-direction by DMD 50 is magnified several times, e.g. two times, by lens systems 454, 458. The magnified laser beam is collected by each microlens of microlens array 472 correspondingly with each imaging portion of DMD 50, then passes through the corresponding apertures of aperture array 476. The laser beam passed through the aperture is imaged on exposed surface 56 by lens systems 480 and 482.

In the imaging optical system, the laser beam reflected by DMD 50 is magnified into several times by magnifying lenses 454, 458, and is projected onto exposed surface 56, therefore, the entire image region is enlarged. When microlens array 472 and aperture array 476 are not disposed, one drawing size or spot size of each beam spot BS projected on exposed surface 56 is enlarged depending on the size of exposed area 468, thus MTF (modulation transfer function) property that is a measure of sharpness at exposing area 468 is decreased, as shown in FIG. 13B.

On the other hand, when microlens array 472 and aperture array 476 are disposed, the laser beam reflected by DMD 50 is collected correspondingly with each imaging portion of DMD 50 by each microlens of microlens array 472. Thereby, the spot size of each beam spot BS may be reduced into the desired size, e.g.10 $\mu$m $\times$ 10 $\mu$m even when the exposing area is magnified, as shown in FIG. 13C, and the decrease of MFT property may be prevented and the exposure may be carried out with higher accuracy. Inclination of exposing area 468 is caused by the DMD 50 that is disposed with inclination in order to eliminate the spaces between imaging portions.

Further, even when beam thickening exists due to aberration of microlenses, the beam shape may be arranged by the aperture array so as to form spots on exposed surface 56 with a constant size, and interference or cross talk between the adjacent imaging portions may be prevented by passing the beam through the aperture array provided correspondingly to each imaging portion.

In addition, employment of higher luminance laser source as laser source 144 may lead to prevention of partial entrance of luminous flux from adjacent imaging portions, since the angle of incident luminous flux that enters into each microlens of microlens array 472 from lens 458 is narrowed; namely, higher extinction ratio may be achieved.

- Other Optical System -

In the pattern forming process according to the present invention, the other optical system suitably selected from among conventional optical systems may be combined, for example, an optical system to compensate the optical quantity distribution may be employed additionally.

The optical system to compensate the optical quantity distribution alters the luminous flux width at each output site such that the ratio of the luminous flux width at the periphery region to the luminous flux width at the central region near the optical axis is higher in the output side than the input side, thus the optical quantity distribution at the exposed surface is compensated to be approximately constant when the parallel luminous flux from the light irradiation unit is irradiated to DMD. The optical system to compensate the optical quantity distribution will be explained with reference to figures in the following.

Initially, the optical system will be explained as for the case where the entire luminous flux widths H0 and H1 are the same between the input luminous flux and the output luminous flux, as shown in FIG. 24A. The portions denoted by reference numbers 51, 52 in FIG. 24A indicate imaginarily the input surface and output surface of the optical system to compensate the optical quantity distribution.

In the optical system to compensate the optical quantity distribution, it is assumed that the luminous flux width h0 of the luminous flux entered at central region near the optical axis Z1 and luminous flux width h1 of the luminous flux entered at peripheral region near are the same (h0 = h1). The optical system to compensate the optical quantity distribution affects the laser beam that has the same luminous fluxes h0, h1 at the input side, and acts to magnify the luminous flux width h0 for the input luminous flux at the central region, and acts to reduce the luminous flux width h1 for the input luminous flux at the periphery region conversely. Namely, the optical system affects the output luminous flux width h10 at the central region and the output luminous flux width h11 at the periphery region to turn into h11 < h10. In other words concerning the ratio of luminous flux width, (output luminous flux width at periphery region) / (output luminous flux width at central region) is smaller than the ratio of input, namely [h11/h10] is smaller than (h1/h0 = 1) or (h11/h10 < 1).

Owing to alternation of the luminous flux width, the luminous flux at the central region representing higher optical quantity may be supplied to the periphery region where the optical quantity is insufficient; thereby the optical quantity distribution is approximately uniformed at the exposed surface without decreasing the utilization efficiency. The level for uniformity is controlled such that the nonuniformity of optical quantity is 30 % or less in the effective region for example, preferably is 20 % or less.

When the luminous flux width is entirely altered for the input side and the output side, the operation and effect due to the optical system to compensate the optical quantity distribution are similar to those shown in FIGs. 24B, and 24C.

FIG. 24B shows the case that the entire optical flux bundle H0 is reduced and outputted as optical flux bundle H2 (H0 > H2). In such a case, the optical system to compensate the optical quantity distribution also tends to process the laser beam, in which luminous flux width h0 is the same as h1 at input side, into that the luminous flux width h10 at the central region is larger than that of the periphery region and the luminous flux width h11 is smaller than that of the central region in the output side. Considering the reduction ratio of the luminous flux, the optical system affects to decrease the reduction ratio of input luminous flux at the central region compared to the peripheral region, and affects to increase the reduction ratio of input luminous flux at the peripheral region compared to the central region. In the case, (output luminous flux width at periphery region) / (output luminous flux width at central region) is also smaller than the ratio of input, namely [H11/H10] is smaller than (h1/h0 =1) or (h11/h10 < 1).

FIG. 24C explains the case where the entire luminous flux width H0 at input side is magnified and output into width H3 (H0 < H3). In such a case, the optical system to compensate the optical quantity distribution also tends to process the laser beam, in which luminous flux width h0 is the same as h1 at input side, into that the luminous flux width h10 at the central region is larger than that of the periphery region and the luminous flux width h11 is smaller than that of the central region in the output side. Considering the magnification ratio of the luminous flux, the optical system acts to increase the magnification ratio of input luminous flux at the central region compared to the peripheral region, and acts to decrease the magnification ratio of input luminous flux at the peripheral region compared to that at the central region. In the case, (output luminous flux width at periphery region) / (output luminous flux width at central region) is also smaller than the ratio of input, namely [H11/H10] is smaller than (h1/h0 = 1) or (h11/h10 < 1).

As such, the optical system to compensate the optical quantity distribution alters the luminous flux width at each output site, and lowers the ratio (output luminous flux width at periphery region) / (output luminous flux width at central region) at output side compared to the input side; therefore, the laser beam having the same luminous flux turns into the laser beam at output side that the luminous flux width at central region is larger than that at the peripheral region and the luminous flux at the peripheral region is smaller than that at the central region. Owing to such effect, the luminous flux at the central region may be supplied to the periphery region, thereby the optical quantity distribution is approximately uniformed at the luminous flux cross section without decreasing the utilization efficiency of the entire optical system.

Next, specific lens data of a pair of combined lenses to be utilized for the optical system to compensate the optical quantity distribution will be exemplarily set forth. In this discussion, the lens data will be explained in the case

that the optical quantity distribution shows Gaussian distribution at the cross section of the output luminous flux, such as the case that the laser source is a laser array as set forth above. In a case that one semiconductor laser is connected to an input end of single mode optical fiber, the optical quantity distribution of output luminous flux from the optical fiber shows Gaussian distribution. The pattern forming process according to the present invention may be applied, in addition, to such a case that the optical quantity near the central region is significantly larger than the optical quantity at the peripheral region as in the case where the core diameter of multimode optical fiber is reduced and constructed similarly to a single mode optical fiber, for example.

The essential data for the lens are summarized in Table 1 below.

Table 1

| Basic Lens Data | | | |
|---|---|---|---|
| S i (surface No.) | r i (curvature radius) | d i (surface distance) | N i (refractive index) |
| 0 1 | non-spherical | 5.000 | 1.52811 |
| 0 2 | ∞ | 50.000 | |
| 0 3 | ∞ | 7.000 | 1.52811 |
| 0 4 | non-spherical | | |

As demonstrated in Table 1, a pair of combined lenses is constructed from two non-spherical lenses of rotational symmetry. The surfaces of the lenses are defined that the surface of input side of the first lens disposed at the light input side is the first surface; the opposite surface at light output side is the second surface; the surface of input side of the second lens disposed at the light input side is the third surface; and the opposite surface at light output side is the fourth surface. The first and the fourth surfaces are non-spherical.

In Table 1, 'Si (surface No.)' indicates "i" th surface (i =1 to 4), 'ri (curvature radius)' indicates the curvature radius of the "i" th surface, di (surface distance) means the surface distance between "i" th surface and "i+1" surface. The unit of di (surface distance) is millimeter (mm). Ni (refractive index) means the refractive index of the optical element containing "i" th surface for the light of wavelength 405 nm.

In Table 2 below, the non-spherical data of the first and the fourth surface is summarized.

Table 2

| non-spherical data | | |
|---|---|---|
| | first surface | fourth surface |
| C | $-1.4098 \times 10^{-2}$ | $-9.8506 \times 10^{-3}$ |
| K | -4. 2192 | $-3.6253 \times 10$ |
| a 3 | $-1.0027 \times 10^{-4}$ | $-8.9980 \times 10^{-5}$ |
| a 4 | $3.0591 \times 10^{-5}$ | $2.3060 \times 10^{-5}$ |
| a 5 | $-4.5115 \times 10^{-7}$ | $-2.2860 \times 10^{-6}$ |
| a 6 | $-8.2819 \times 10^{-9}$ | $8.7661 \times 10^{-8}$ |
| a 7 | $4.1020 \times 10^{-12}$ | $4.4028 \times 10^{-10}$ |
| a 8 | $1.2231 \times 10^{-13}$ | $1.3624 \times 10^{-12}$ |
| a 9 | $5.3753 \times 10^{-16}$ | $3.3965 \times 10^{-15}$ |
| a 1 0 | $1.6315 \times 10^{-18}$ | $7.4823 \times 10^{-18}$ |

The non-spherical data set forth above may be expressed by means of the coefficients of the following equation (A) that represent the non-spherical shape.

$$Z = \frac{C \cdot \rho^2}{1 + \sqrt{1 - K \cdot (C \cdot \rho)^2}} + \sum_{i=3}^{10} ai \cdot \rho^i \quad \cdots\cdots \quad (A)$$

In the above formula (A), the coefficients are defined as follows:

Z: length of perpendicular that extends from a point on non-spherical surface at height p from optical axis (mm) to tangent plane at vertex of non-spherical surface or plane vertical to optical axis;
p: distance from optical axis (mm);
K: coefficient for circular conic;
C: paraxial curvature (1/r, r: radius of paraxial curvature);
ai: "i" st non-spherical coefficient (i = 3 to 10).

For example, "1.0E-02" means "1.0 X $10^{-2}$".
FIG. 26 shows the optical quantity distribution of illumination light obtained by a pair of combined lenses shown in Table 1 and Table 2. The abscissa axis represents the distance from the optical axis, the ordinate axis represents the proportion of optical quantity (%). FIG. 25 shows the optical quantity distribution (Gaussian distribution) of illumination light without the compensation. As is apparent from FIGs. 25 and 26, the compensation by means of the optical system to compensate the optical quantity distribution brings about an approximately uniform optical quantity distribution significantly exceeding the optical quantity distribution obtained without the compensation, thus uniform exposing may be achieved by means of uniform laser beam without decreasing the optical utilization efficiency.

- Other Steps -

The other steps are not particularly limited and may be suitably selected from among the steps in known pattern forming steps, and examples thereof include developing, etching, and plating. Each of these steps may be used alone or may be combined with two or more.
In the developing step, a photosensitive layer in the pattern forming material is exposed in the exposing step, exposed areas of the photosensitive layer are hardened, and unhardened regions are removed, thereby developing the photosensitive layer surface to form a pattern.
The developing is preferably performed using, for example, a developing unit.
The developing unit is not particularly limited and may be suitably selected in accordance with the intended use as long as the developing unit can develop a photosensitive layer using a developer. Examples there of include a unit configured to spray the developer, a unit configured to apply the developer, and a unit configured to immerse a pattern forming material in the developer. Each of these developing units may be used alone or in combination with two or more.
The developing unit may be equipped with a developer exchange unit configured to exchange the developer, and a developer supplying unit configured to supply the developer.
The developer is not particularly limited and may be suitably selected in accordance with the intended use; examples of the developers include alkaline aqueous solutions, aqueous developing liquids, and organic solvents; among these, weak alkali aqueous solutions are preferable. The basic components of the weak alkali aqueous solutions are exemplified by lithium hydroxide, sodium hydroxide, potassium hydroxide, lithium carbonate, sodium carbonate, potassium carbonate, lithium hydrogencarbonate, sodium hydrogencarbonate, potassium hydrogencarbonate, sodium phosphate, potassium phosphate, sodium pyrophosphate, potassium pyrophosphate, and borax.
The weak alkali aqueous solution preferably exhibits a pH of about 8 to 12, more preferably about 9 to 11. Examples of such a solution are aqueous solutions of sodium carbonate and potassium carbonate at a concentration of 0.1% by mass to 5 % by mass. The temperature of the developer may be properly selected depending on the developing ability of the developer; for example, the temperature of the developer is about 25 °C to 40 °C.
The developer may be combined with surfactants, defoamers; organic bases such as ethylene diamine, ethanol amine, tetramethylene ammonium hydroxide, diethylene triamine, triethylene pentamine, morpholine, and triethanol amine; organic solvents to promote developing such as alcohols, ketones, esters, ethers, amides, and lactones. The developer set forth above may be an aqueous developer selected from aqueous solutions, aqueous alkali solutions, combined solutions of aqueous solutions and organic solvents, or an organic developer.
The etching may be carried out by a method selected properly from conventional etching methods.
The etching liquid used in the etching method is not particularly limited and may be suitably selected in accordance with the intended use; when the metal layer set forth above is formed of copper, exemplified are cupric chloride solution, ferric chloride solution, alkali etching solution, and hydrogen peroxide solution for the etching liquid; among these, ferric chloride solution is preferred in light of the etching factor.
The etching treatment and the removal of the pattern forming material may form a permanent pattern on the substrate. The permanent pattern is not particularly limited and may be suitably selected in accordance with the intended use; for example, the pattern is of interconnection.
The plating step may be performed by a method selected from conventional plating treatment methods.

Examples of the plating treatment include copper plating such as copper sulfate plating and copper pyrophosphate plating; solder plating such as high flow solder plating; nickel plating such as watt bath (nickel sulfate-nickel chloride) plating and nickel sulfamate plating; and gold plating such as hard gold plating and soft gold plating.

A permanent pattern may be formed by performing a plating treatment in the plating step, followed by removing the pattern forming material and optional etching treatment on unnecessary portions.

- Method for producing Printed Wiring Board and Color Filter -

The pattern forming process according to the present invention may be successfully applied to the production of printed wiring boards, particularly in the production of printed wiring boards having through holes or via holes, and to the production of color filters. The processes for producing printed wiring boards and color filters based on the pattern forming process according to the present invention will be exemplarily explained in the following.

- Method for producing Printed Wiring Board -

In process for producing printed wiring boards having through holes and/ or via holes, a pattern may be formed by (i) laminating the pattern forming material on a substrate of a printed wiring board having holes such that the photosensitive layer faces the substrate thereby to form a laminate, (ii) irradiating a light onto the regions for forming interconnection patterns and holes from the opposite side of the substrate of the laminate thereby to harden the photosensitive layer, (iii) removing the support of the pattern forming material from the laminate, and (iv) developing the photosensitive layer of the laminate to remove unhardened regions in the laminate.

Removing of the support of (iii) may be carried out between the (i) and (ii) instead of between (ii) and (iv) set forth above.

Then, using the formed pattern, etching treatment or plating treatment of the substrate of the printed wiring board by means of conventional subtractive or additive method e.g. semi-additive or full-additive method may produce the printed wiring board. Among these methods, the subtractive method is preferable in order to form printed wiring boards by industrially advantageous tenting. After the treatment, the hardened resin remaining on the substrate of the printed wiring board is peeled off, or copper thin film is etched after the peeling in the case of semi-additive process, thereafter the intended printed wiring board is obtained. In the case of multi-layer printed wiring board, the similar process with the printed wiring board may be applicable.

The process for producing printed wiring boards having through holes by means of the pattern forming material will be explained in the following.

Initially, the substrate of printed wiring board is prepared in which the surface of the substrate is covered with a metal plating layer. The substrate of printed wiring board may be a copper-laminated layer substrate, a substrate that is produced by forming a copper plating layer on an insulating substrate such as glass or epoxy resin, or a substrate that is laminated on these substrate and formed into a copper plating layer.

In a case where a protective layer exists on the pattern forming material, the protective film is peeled, and the photosensitive layer of the pattern forming material is contact bonded to the surface of the printed wiring board by means a pressure roller as a laminating process, thereby a laminate may be obtained that contains the substrate of the printed wiring board and the laminate set forth above.

The laminating temperature of the pattern forming material may be properly selected without particular limitations; the temperature may be about room temperature such as 15°C to 30 °C, or higher temperature such as 30°C to 180 °C, preferably it is substantially warm temperature such as 60°C to 140 °C.

The roll pressure of the contact bonding roll may be properly selected without particular limitations; preferably the pressure is 0.1 MPa to 1 MPa; the velocity of the contact bonding may be properly selected without particular limitations, preferably, the velocity is 1 meter/m to 3 meters/m.

The substrate of the printed wiring board may be pre-heated before the contact bonding; and the substrate may be laminated under a reduced pressure.

The laminate may be formed by laminating the pattern forming material on the substrate of the printed wiring board; alternatively by coating the solution of the photosensitive resin composition for pattern forming material directly on the substrate of the printed wiring board, followed by drying the solution, thereby laminating the photosensitive layer and the support on the substrate of the printed wiring board.

In the process, in accordance with the necessity, for example, when the light transmission of the support is insufficient, the support may be exfoliated before the exposing process.

In the case that the support exists on the support after the laser irradiation, the support is peeled from the laminate as the support peeling step.

The unhardened regions of the photosensitive layer on the substrate of the printed wiring board are dissolved away by means of an appropriate developer, a pattern is formed that contains a hardened layer for forming an interconnection pattern and a hardened layer for protecting a metal layer of through holes, and the metal layer is exposed at the substrate surface of the printed wiring board as the developing step.

Additional treatment to promote the hardening reaction, for example, may be performed by means of post-heating or post-exposing optionally. The developing may be of a wet method set forth above or a dry developing method.

Then, the metal layer exposed on the substrate surface of the printed wiring board is dissolved away by an etching liquid as an etching process. The apertures of the through holes are covered by hardened resin or tent film, therefore, the etching liquid does not infiltrate into the through holes to corrode the metal plating within the through holes, and the metal plating may maintain the specific shape, thus an interconnection pattern may be formed on the substrate of the printed wiring board.

The etching liquid may be properly selected depending on the application; cupric chloride solution, ferric chloride solution, alkali etching solution, and hydrogen peroxide solution are exemplified for the etching liquid when the metal layer set forth above is formed of copper; among these, ferric chloride solution is preferred in light of the etching factor.

Then, the hardened layer is removed from the substrate of the printed wiring board by means of a strong alkali aqueous solution for example as the removing step of hardened material.

The basic component of the strong alkali aqueous solution may be properly selected without particular limitations, examples of the basic component include sodium hydroxide and potassium hydroxide. The pH of the strong alkali aqueous solution may be about 12 to 14 for example, preferably about 13 to 14. The strong alkali aqueous solution may be an aqueous solution of sodium hydroxide or potassium hydroxide at a concentration of 1 to 10 % by mass.

The printed wiring board may be of multi-layer construction. By the way, the pattern forming material set forth above may be applied to plating processes instead of the etching process set forth above. The plating method may be copper plating such as copper sulfate plating and copper pyrophosphate plating; solder plating such as high flow solder plating; nickel plating such as watt bath (nickel sulfate-nickel chloride) plating and nickel sulfamate plating; and gold plating such as hard gold plating and soft gold plating.

- Method for producing color filters -

When a support is peeled away from a pattern forming material after laminating a photosensitive layer of a pattern forming material on a substrate such as glass substrate, there exist problems that the charged support or film and an operator may feel an unpleasant electric shock and dust may deposit on the charged support. Accordingly, it is preferred that a conductive layer is provided on the support or the support is treated to take conductivity. Further, when the conductive layer is provided on the support opposite to the photosensitive layer, it is preferred that a hydrophobic polymer layer is provided on the support to improve scratch resistance.

Then a pattern forming material having a red photosensitive layer, a pattern forming material having a green photosensitive layer, a pattern forming material having a blue photosensitive layer, and a pattern forming material having a black photosensitive layer are prepared. Using the pattern forming material having the red photosensitive layer for red pixels, the red photosensitive layer is laminated to the substrate to form a laminate, followed by exposing and developing image-wise to form red pixels. After forming the red pixels, the laminate is heated to harden the unhardened regions. These procedures are conducted similarly in terms of the green pixels and blue pixels to form the respective pixels.

The laminate may be formed by laminating the pattern forming material on the glass substrate, alternatively, by a way that a solution of photosensitive composition for pattern forming material is directly coated on the glass substrate and the solution is dried. When three types of red, green, and blue pixels are disposed, the pattern may be mosaic type, triangle type, four pixel type, or the like.

The pattern forming material having the black photosensitive layer is laminated on the disposed pixels, then exposure is conducted from the back side where no pixels are formed and to develop the black photosensitive layer to thereby form a black matrix. The laminate having the black matrix is heated to harden the unhardened regions to produce a color filter.

The pattern forming processes according to the present invention may be properly applied to produce various patterns, to form permanent patterns such as interconnection patterns, to produce liquid crystal materials such as color filters, column materials, rib materials, spacers, partitions, and the like, and to produce holograms, micromachine, proofs, and the like; in particular, the present invention may be properly applied to form highly fine and precise interconnection patterns.

- Pattern Forming Process for Solder Resist -

The pattern forming material prepared by forming a photosensitive layer containing the photosensitive composition for solder resist on a substrate surface can be widely used as display members such as printed wiring boards, color filters, column members, rib members, spacers, and partition members; and for forming permanent patterns such as hologram, micromachine, and proof, and can be preferably used for the permanent pattern forming process of the

present invention.

In particular, since the pattern forming material has a uniform film thickness, the pattern forming material can be finely and precisely formed on a surface of the substrate.

The exposure to a photosensitive laminate formed according to the second embodiment of the pattern forming process is not particularly limited and may be suitably selected in accordance with the intended use. For example, the photosensitive layer may be exposed through the support, or the photosensitive layer may be exposed after peeling off the support. When the pattern forming material has a cushion layer, a PC layer and the like for example, the photosensitive layer may be exposed through the support and these layers, or the photosensitive layer may be exposed through the cushion layer and the PC layer after peeling off the support, or the photosensitive layer may be exposed through the PC layer after peeling off the support and the cushion layer, or the photosensitive layer may be exposed after peeling off the support, the cushion layer, and the PC layer.

- Developing Step -

In the developing step, the photosensitive layer in the pattern forming material is exposed in the exposing step, exposed areas of the photosensitive layer are hardened, and unhardened regions are removed, thereby developing the photosensitive layer surface to form a permanent pattern.

The method of removing unhardened regions is not particularly limited and may be suitably selected in accordance with the intended use. Examples thereof include a method in which unhardened regions are removed using a developer.

The developer is not particularly limited and may be suitably selected in accordance with the intended use. Preferred examples of the developers include hydroxides of alkaline metals and alkaline earth metals or aqueous solutions of carbonates, hydrogen carbonates, ammonia water, and tetraammonium salts. Of these, a sodium carbonate aqueous solution is particularly preferable.

The developer may be combined with surfactants, defoamers; organic bases such as ethylene diamine, ethanol amine, tetramethylene ammonium hydroxide, diethylene triamine, triethylene pentamine, morpholine, and triethanol amine; organic solvents to promote developing such as alcohols, ketones, esters, ethers, amides, and lactones. The developer set forth above may be an aqueous developer selected from aqueous solutions, aqueous alkali solutions, combined solutions of aqueous solutions and organic solvents, or an organic developer.

- Hardening Treatment Step --

In the hardening treatment step, the photosensitive layer in the permanent pattern which is formed in the developing step is subjected to a hardening treatment.

The hardening treatment is not particularly limited and may be suitably selected in accordance with the intended use. For example, an entire surface exposing treatment, and an entire surface heating treatment are preferably exemplified.

For the method of subjecting the photosensitive layer to the entire surface exposing treatment, a method is exemplified in which after the developing step, the entire surface of the photosensitive laminate with the permanent pattern formed thereon is exposed. Exposing the entire surface of the photosensitive laminate accelerates hardening of the resin in the photosensitive composition which forms the photosensitive layer to thereby harden the surface of the permanent pattern.

An apparatus to perform the exposure of the entire surface is not particularly limited and may be suitably selected in accordance with the intended use. Preferred examples of the apparatus include UV exposers such as ultrahigh pressure mercury lamp.

For the method of subjecting the photosensitive layer to the entire surface heating treatment, a method is exemplified in which after the developing step, the entire surface of the photosensitive laminate with the permanent pattern formed thereon is heated. Heating the entire surface of the photosensitive laminate can enhance the film strength of the permanent pattern surface.

The heating temperature of the entire surface heating is preferably 120 °C to 250 °C, and more preferably 120 °C to 200 °C. When the heating temperature is less than 120 °C, the effect of enhancing the film strength that would be obtainable from a heat treatment may not be obtained. When the heating temperature is more than 250 °C, the quality of the film may be weakened and brittle due to decomposition of the resin in the photosensitive composition.

The heating time in the entire surface heating treatment is preferably 10 minutes to 120 minutes, and more preferably 15 minutes to 60 minutes.

An apparatus to perform the entire surface heating is not particularly limited and may be suitably selected from among conventional apparatuses. For example, dry oven, hot plate, IR heater are exemplified.

When the substrate is a printed wiring board such as a multilayered interconnection substrate, a permanent

pattern of the present invention can be formed on the printed wiring board, and further, the surface of the printed wiring board can be soldered as follows.

In other words, a hardened layer which is the permanent pattern is formed in the developing step, and a metal layer is exposed on the surface of the printed wiring board. The regions of the metal layer exposed on the surface of the printed wiring board are plated with gold and is then soldered. On the soldered regions, semiconductor, and components are mounted. At this point in time, the permanent pattern made of the hardened layer exerts a function as a protective film or an insulating film (interlayer insulating film) to block external impact shock and conduction between neighboring electrodes.

In the permanent pattern forming process of the present invention, preferably, at least any one of a protective film and an interlayer insulating film is formed. When the permanent pattern formed according to the permanent pattern forming process of the present invention is of a protective layer or an interlayer insulating film, the interconnection can be protected from external impact shock and bending. Particularly when the permanent patter is of an interlayer insulating layer, it is effective in high-density mounting of semiconductors and components onto multilayered interconnection substrates, build-up interconnection substrates, and the like.

The permanent pattern forming process of the present invention allows finely, precisely, and efficiently forming a permanent pattern by suppressing distortion of an image to be formed on the photosensitive layer, and thus the pattern forming process of the present invention can be preferably used for forming various patterns for which fine and precise exposure technique is required.

## Example

Hereafter, the present invention will be further described in detail referring to specific Examples and Comparative Examples, however, the present invention is not limited to the disclosed Examples.

### (Example 1)

- Preparation of Pattern Forming Material for Dry Film Resist -

Over a surface of a polyethylene terephthalate film having a thickness of 20 μm serving as the support set forth, a photosensitive composition solution for dry film resist was applied, and the surface of the support was dried to form a photosensitive layer having a thickness of 15 μm on the support, thereby preparing the above-noted pattern forming material for dry film resist.

[Composition of Photosensitive Composition for Dry Film Resist]

| | |
|---|---|
| • Methyl methacrylate/sty rene/benzyl methacrylate/methacrylic acid copolymer (copolymer composition (mass ratio): 8/30/37/25; mass average molecular mass: 60,000; acid value: 163) | 60 parts by mass |
| • Polymerizable monomer represented by the following formula (75) | 7.0 parts by mass |
| • Adduct between hexamethylene diisocyanate and tetraethylene oxide monomethacrylate (molar ratio:1/2) | 7.0 parts by mass |
| • N-methylacridone | 0.11 parts by mass |
| • 2,2-bis(o-chlorophenyl)-4,4',5,5'-tetraphenylbiimidazole | 2.17 parts by mass |
| • N-phenylbenzimidazole | 0.23 parts by mass |
| • Malachite green oxalate | 0.02 parts by mass |
| • Leucocrystal violet | 0.26 parts by mass |
| • Methyl ethyl ketone | 40 parts by mass |
| • 1-methoxy-2-propanol | 20 parts by mass |

The maximum absorption wavelength of N-methyl acridone serving as the photosensitizer was 395 nm.

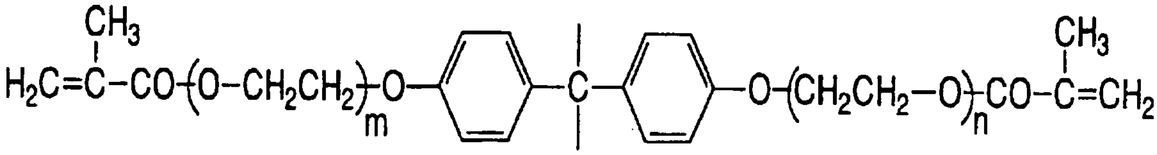

formula (75)

In the formula (75), "m + n" is equal to 10. The compound represented by the formula (75) is an example of compounds represented by the formula (38).

- Preparation of Photosensitive Laminate for Dry Film Resist -

On the photosensitive layer of the pattern forming material for dry film resist, a polyethylene film having a thickness of 20 μm as the protective film was laminated. Next, the pattern forming material for dry film resist was laminated on a copper clad laminate, as the above-noted substrate, having a copper thickness of 12 μm and no through hole whose surface had been polished, washed, and dried using a laminator (MODEL 8B-720-PH, manufactured by Taisei Laminator Co., Ltd.) while peeling off the protective film of the pattern forming material for the dry film resist, thereby preparing a photosensitive laminate in which the copper clad laminate, the photosensitive layer, and the polyethylene terephthalate film (support) were formed in this order.

The pressure bonding conditions were set as follows. The temperature of the pressure roller: 105 °C; the pressure of the pressure roller: 0.3 MPa; and the laminating speed: 1 meter/ m.

With respect to the prepared pattern forming material for dry film resist and the photosensitive laminate for dry film resist, the shortest developing time, the spectral sensitivity, and the minimum exposure does capable of forming a pattern were measured.

- Shortest Developing Time -

The polyethylene terephthalate film serving as a support was peeled off from the photosensitive laminate for dry film resist, and 1 % by mass sodium carbonate aqueous solution (30°C) was sprayed over the entire surface of the photosensitive layer formed on the copper clad laminate under a pressure of 0.15 MPa. The time required from the start of spraying the sodium carbonate aqueous solution until the photosensitive layer on the copper clad laminate was dissolved and removed was measured, and the time was taken as the shortest developing time. As the result, the shortest developing time was 7 seconds.

- Measurement of Spectral Sensitivity -

The photosensitive layer was irradiated with a light beam having a constant wavelength within the range of 350 nm to 700 nm while varying the light energy quantity ranging from 0.1 $mJ/cm^2$ to 100 mJ/cm at an interval of $2^{1/2}$ times to harden a partial region of the photosensitive layer. The pattern forming material was left intact at room temperature for 10 minutes, and then the polyethylene terephthalate film (support) was peeled off from the pattern forming material for dry film resist. Over the entire surface of the photosensitive layer, a sodium carbonate aqueous solution (30 °C, 1% by mass) was sprayed under a spray pressure of 0.15 MPa for twice as long as the shortest developing time, which will be described hereinafter, thereby dissolving and removing the unhardened regions. The height (thickness) of the hardened regions applied with the light beam while varying the light energy quantities for every wavelength was measured. The light energy quantity with which a pattern could be formed was calculated from the height (thickness) of the obtained pattern. The wavelengths were plotted along the abscissa, and the reciprocal numbers of the light energy quantities were plotted along the ordinate to form a spectral sensitivity curve. The spectral sensitivity curve proved that the photosensitive layer had a maximum peak of spectral sensitivity at a wavelength of 405 nm. The light energy quantities were measured using a light beam emitted from a xenon lamp. Table 3 shows the measurement results.

- Measurement of the minimum exposure dose capable of forming a pattern -

In the measurement of the spectral sensitivity, the light energy quantities when the thickness of the hardened region was 15 μm in the wavelengths of 400 nm, 405 nm, and 410 nm were regarded as the minimum exposure dose capable of forming a pattern.

As the result, it was found that the minimum exposure dose $S_{400}$ capable of forming a pattern at a wavelength of 400 nm of the photosensitive composition was 3.0 mJ/$cm^2$; the minimum exposure dose $S_{405}$ capable of forming a pattern at a wavelength of 405 nm was 3.3 mJ/$cm^2$; and the minimum exposure dose $S_{410}$ capable of forming a pattern at a wavelength of 410 nm was 3.65 mJ/$cm^2$. In addition, it was also found that the value $S_{400}/S_{410}$ of the photosensitive composition was 0.82. Table 3 shows the measurement results.

The photosensitive laminate for dry film resist was exposed using the pattern forming apparatus set forth above. Variations in line width of the formed lines were measured. Table 3 shows the measurement results.

- Variation in Line Width -

The photosensitive laminate for dry film resist was left intact at room temperature (23 °C, relative humidity = 55%) for 10 minutes. The obtained photosensitive laminate for dry film resist was exposed in the region of each exposure line width of 67.24 mm with a line/ space of 20 μm/20 μm using eight exposure heads of the pattern forming apparatus from the polyethylene terephthalate film (support) side. The exposure dose measured for each wavelength is the minimum energy of the light corresponding to the respective wavelengths obtained in the measurement of the spectral sensitivity.

Then, the photosensitive laminate was left intact at room temperature for 10 minutes, and then the polyethylene terephthalate film (support) was peeled off from the photosensitive laminate for dry film resist. Over the entire surface of the photosensitive layer formed on the copper clad laminate, a sodium carbonate aqueous solution (30 °C, 1% by mass) as the above-noted developer was sprayed under a spray pressure of 0.15 MPa for twice as long as the shortest developing time to thereby dissolve and remove the unhardened regions. The surface of the thus obtained copper clad laminate with a hardened resin pattern formed on the surface thereof was observed through an optical microscope. With respect to the eight regions exposed by the eight exposure heads, the line widths of the formed lines were measured. As the result, the individual line widths were within the range of 19.8 μm to 20.2 μm, and the variation range was 0.6 μm.

(Example 2)

A pattern forming material for dry film resist and a photosensitive laminate for dry film resist were produced in the same manner as in Example 1 except that N-methyl acridone in the photosensitive composition solution for dry film resist was changed to 10-N-butyl-2-chloroacridone. The maximum absorption wavelength of 10-N-butyl-2-chloroacridone as the above-noted photosensitizer was 365 nm.

With respect to the pattern forming material for dry film resist and the photosensitive laminate, the shortest developing time, the spectral sensitivity, and the minimum exposure dose capable of forming a pattern were measured in the same manner as in Example 1. Further, variations in line width of the formed lines were measured in the same manner as in Example 1. Table 3 shows the measurement results. The shortest developing time was 7 seconds.

(Example 3)

A pattern forming material for dry film resist and a photosensitive laminate for dry film resist were produced in the same manner as in Example 1 except that the content of 2,2-bis(o-chlorophenyl)-4,4',5,5'-tetraphenylbiimidazole was changed to 0.50 parts by mass.

With respect to the pattern forming material for dry film resist and the photosensitive laminate, the shortest developing time, the spectral sensitivity, and the minimum exposure dose capable of forming a pattern were measured in the same manner as in Example 1. Further, variations in line width of the formed lines were measured in the same manner as in Example 1. Table 3 shows the measurement results. The shortest developing time was 7 seconds.

(Comparative Example 1)

A pattern forming material for dry film resist and a photosensitive laminate for dry film resist were produced in the same manner as in Example 1 except that 0.11 parts by mass of N-methyl acridone in the photosensitive composition solution for dry film resist was changed to 0.04 parts by mass of 4,4'-bis (diethylamino) benzophenone. The maximum absorption wavelength of 4,4'-bis (diethylamino) benzophenone as the above-noted photosensitizer was 365 nm.

With respect to the pattern forming material for dry film resist and the photosensitive laminate, the shortest developing time, the spectral sensitivity, and the minimum exposure dose capable of forming a pattern were measured in the same manner as in Example 1. Further, variations in line width of the formed lines were measured in the same manner as in Example 1. Table 3 shows the measurement results. The shortest developing time was 7 seconds.

(Comparative Example 2)

A pattern forming material for dry film resist and a photosensitive laminate for dry film resist were produced in the same manner as in Example 1 except that N-methyl acridone in the photosensitive composition solution for dry film resist was changed to coumarin 6. The maximum absorption wavelength of coumarin 6 as the above-noted photosensitizer was 450 nm.

With respect to the pattern forming material for dry film resist and the photosensitive laminate, the shortest developing time, the spectral sensitivity, and the minimum exposure dose capable of forming a pattern were measured in the same manner as in Example 1. Further, variations in line width of the formed lines were measured in the same manner as in Example 1. Table 3 shows the measurement results. The shortest developing time was 7 seconds. Deterioration of the pattern forming material for dry film resist of Comparative Example 2 was observed under a treatment of yellow light.

(Comparative Example 3)

A pattern forming material for dry film resist and a photosensitive laminate for dry film resist were produced in the same manner as in Example 1 except that the content of 2,2-bis(o-chlorophenyl)-4,4',5,5'-tetraphenylbiimidazole was changed to 1.00 parts by mass.

With respect to the pattern forming material for dry film resist and the photosensitive laminate, the shortest developing time, the spectral sensitivity, and the minimum exposure dose capable of forming a pattern were measured in the same manner as in Example 1. Further, variations in line width of the formed lines were measured in the same manner as in Example 1. Table 3 shows the measurement results. The shortest developing time was 7 seconds.

Table 3

| | Wavelength (nm) in maximum spectral sensitivity | Minimum exposure dose capable of forming a pattern | | | | | Line width | |
|---|---|---|---|---|---|---|---|---|
| | | $S_{400}$ (mJ/cm$^2$) | $S_{405}$ (mJ/cm$^2$) | $S_{410}$ (mJ/cm$^2$) | $S_{400}/S_{410}$ | $S_{410}/S_{400}$ | Range (μm) | Variation (μm) |
| Ex.1 | 400 | 3.0 | 3.3 | 3.65 | 0.82 | 1.22 | 19.8-20.2 | 0.4 |
| Ex.2 | 405 | 3.0 | 3.0 | 3.09 | 0.97 | 1.03 | 19.8-20.2 | 0.4 |
| Ex.3 | 400 | ’12.0 | 13.2 | 14.4 | 0.83 | 1.22 | 19.8-20.2 | 0.4 |
| Compara. Ex.1 | 365 | 10.0 | 14.0 | 17.0 | 0.59 | 0.55 | 18.0-21.0 | 3.0 |
| Compara. Ex. 2 | 450 | 18.0 | 14.0 | 10.0 | 1.80 | 1.80 | 18.0-21.0 | 3.0 |
| Compara. Ex. 3 | 365 | 10.0 | 14.0 | 17.0 | 0.59 | 0.55 | 18.0-21.0 | 3.0 |

The results shown in Table 3 demonstrated that the pattern forming materials for dry film resist of Examples 1 to 3 caused less variations in line width even when a pattern was formed by exposing the respective photosensitive layers with a laser having a wavelength of 405 nm that the wavelength range of 400 nm to 410 nm was assumed because the values of $S_{400}/S_{410}$ of the pattern forming materials were respectively within the range of 0.6 to 1.4. In contrast, the results shown in Table 3 showed that the pattern forming materials for dry film resist of Comparative Examples 1 to 3 had large variations in line width because the values of $S_{400}/S_{410}$ of these pattern forming materials were respectively outside the range.

Hereinafter, the present invention will be further described in detail referring to specific Examples and Comparative Examples using the photosensitive composition for solder resist, however, the present invention is not limited to the disclosed Examples.

(Example 4)

In Example 4, a photosensitive composition for solder resist was prepared based on the following composition; and the photosensitive composition was kneaded using a roller mill according to a conventional method.

[Photosensitive Composition Solution for Solder Resist]

| | |
|---|---|
| • Barium sulfate (B30 manufactured by Sakai Chemical Industry Co., Ltd.) | 50.00 parts by mass |
| • PCR-1157H (epoxy acrylate 61.8% by mass ethylene glycol monoethyl ether acrylate solution manufactured by Nippon Kayaku Co., Ltd.) | 81.70 parts by mass |
| • Dipentaerithritol hexaacrylate | 13.16 parts by mass |
| • IRGACURE 819 (manufactured by Chiba Specialty Chemicals K.K.) | 6.82 parts by mass |
| • YX4000 (epoxy resin manufactured by Japan Epoxy Resin Co., Ltd.) | 20.00 parts by mass |
| • RE 306 (epoxy resin manufactured by Nippon Kayaku Co., Ltd.) | 5.00 parts by mass |
| • Dicyanediamide | 0.13 parts by mass |
| • Hydroquinone monomethyl ether | 0.024 parts by mass |
| • Phthalocyanine green | 0.42 parts by mass |

The above-noted barium sulfate dispersion was prepared by preliminarily mixing 30 parts by mass of barium sulfate (B30 manufactured by Sakai Chemical Industry Co., Ltd.), 34.29 parts by mass of 61.2% by mass solution of diethylene glycol monomethyl ether acetate of the above-noted PCR-1157, and 35.71 parts by mass of methyl ethyl ketone, and dispersing the mixture using zirconia beads having a diameter of 1.0 mm in MOTOR MILL M-200 (manufactured by EIGER Japan K.K.) at a circumferential speed of 9m/s for 3.5 hours.

- Preparation of Pattern Forming Material for Solder Resist -

The obtained photosensitive composition solution for solder resist was applied over a surface of a polyethylene terephthalate (PET) film having a thickness of 20 μm as the above-noted support, and the support surface was dried to form a photosensitive layer having a thickness of 35 μm. Next, a polypropylene film having a thickness of 12 μm as the above-noted protective film was laminated on the photosensitive layer to thereby prepare a pattern forming material for solder resist.

- Formation of Permanent Pattern -

-- Preparation of Photosensitive Laminate for Solder Resist -

Next, as the above-noted substrate, a surface of a copper clad laminate with interconnection formed thereon (having a thickness of 12 μm with no through hole) was subjected to a chemical polishing treatment to prepare a substrate. On the copper clad laminate, the photosensitive layer in the pattern forming material for solder resist was laminated using a vacuum laminator (MVLP500, manufactured by MEIKI Co., Ltd.) while peeling off the protective film in the pattern forming material for solder resist such that the photosensitive layer surface made contact with the copper clad laminate surface, thereby preparing a photosensitive laminate for solder resist in which the copper clad laminate, the photosensitive layer, and the polyethylene terephthalate film (support) were laminated in this order. The pressure bonding conditions were set as follows. The pressure bonding temperature: 90 °C; the pressure of the pressure bonding: 0.4 MPa; and the laminating speed: 1 meter/m.

- Measurement of Spectral Sensitivity -

A laminate was prepared in the same manner as the preparation of the photosensitive laminate for solder resist except that a copper clad laminate with no interconnection formed thereon was used as the substrate. The laminate was irradiated with a light having a constant wavelength within the range of 350 nm to 700 nm while varying the light energy quantity ranging from 0.1 mJ/cm$^2$ to 300 mJ/cm at an interval of $2^{1/2}$ times to harden a partial region of the photosensitive layer. The laminate was left intact at room temperature for 10 minutes, and then the polyethylene terephthalate film (support) was peeled off from the pattern forming material. Over the entire surface of the photosensitive layer, a sodium carbonate aqueous solution (30 °C,1% by mass) was sprayed under a spray pressure of 0.15 MPa for 60 seconds thereby dissolving and removing the unhardened regions. The height (thickness) of the hardened regions applied with the light beam while varying the light energy quantities for every wavelength was measured. The light energy quantity with which a pattern could be formed was calculated from the height of the obtained pattern. The wavelengths were plotted along the abscissa, and the reciprocal numbers of the light energy quantities were plotted along the ordinate to form a spectral sensitivity curve. The spectral sensitivity curve proved that the photosensitive layer had a maximum peak of spectral sensitivity at a wavelength of 405 nm. The light energy quantities were measured using a light beam emitted from a xenon lamp. Table 4 shows the measurement results.

- Measurement of Minimum Exposure Dose capable of forming a pattern -

In the measurement of the spectral sensitivity, the light energy quantities when the thickness of the hardened region was 35 μm in the wavelengths of 400 nm, 405 nm, and 410 nm were regarded as the minimum exposure dose capable of forming a pattern.

As the result, it was found that the minimum exposure dose $S_{400}$ capable of forming a pattern at a wavelength of 400 nm of the photosensitive composition was 35.0 mJ/cm$^2$; the minimum exposure dose $S_{405}$ capable of forming a pattern at a wavelength of 405 nm was 35.7 mJ/cm$^2$; and the minimum exposure dose $S_{410}$ capable of forming a pattern at a wavelength of 410 nm was 37.8 mJ/cm$^2$. In addition, it was also found that the value $S_{400}/S_{410}$ of the photosensitive composition was 0.92. Table 4 shows the measurement results.

- Variation of Formed Pattern -

The above-noted laminate was left intact at room temperature (23 °C, relative humidity: 55%) for 10 minutes.

The obtained laminate was irradiated and exposed by means of eight exposure heads of the pattern forming apparatus from the polyethylene terephthalate film (support) side so as to obtain a pattern in which holes of 50 μm (width) × 300 μm (length) were formed at the bottom of the pattern, to thereby harden a partial region of the photosensitive layer. The exposure dose measured for each wavelength is the minimum energy of the light corresponding to the wavelength of 405 nm obtained in the measurement of the spectral sensitivity.

The pattern was subjected to a developing treatment in the same way as described above to dissolve and remove unhardened regions. The obtained pattern was observed using an electron microscope. With respect to the eight regions exposed with the eight exposure heads, the bottom widths of the respective holes of the pattern were measured to determine the difference between the maximum value and the minimum value. Table 4 shows the measurement results.

- Exposure Step -

The photosensitive layer of the thus prepared laminate for solder resist was irradiated and exposed with a laser beam having a wavelength of 405 nm from the polyethylene terephthalate film (support) side using a pattern forming apparatus to be hereinafter described so as to obtain a pattern in which holes each having a different diameter were formed, to thereby harden a partial region of the photosensitive layer.

The pattern forming apparatus used here is the same one as used for forming the pattern forming material for dry film resist. The same units and methods as used for forming the pattern forming material for dry film resist.

- Developing Step -

The laminate for solder resist pattern was left intact at room temperature for 10 minutes, and then the polyethylene terephthalate film (support) was peeled off from the laminate for solder resist. The entire surface of the photosensitive layer on the copper clad laminate substrate was showered with 1 % by mass of sodium carbonate aqueous solution of a temperature of 30°as an alkaline developer for developing for 60 seconds to thereby dissolve and remove unhardened regions. Then, the photosensitive layer surface was washed with water, and dried to thereby form a permanent pattern.

- Hardening Treatment Step -

The entire surface of the laminate for solder resist with the permanent pattern formed thereon was subjected to a heating treatment at 160 °C for 30 minutes to harden the surface of the permanent pattern and enhance the film strength thereof. The permanent pattern was visually checked, and no air bubble was observed on the surface of the permanent pattern.

Further, the printed interconnection substrate with the permanent pattern formed on the surface thereof was plated with gold according to a conventional method and then was subjected to an aqueous flux treatment. Next, the printed interconnection substrate was soaked in a solder bath with the temperature set at 260 °C for 5 seconds three times to wash and remove the flux with water. Then, with respect to the permanent pattern that the flux had been removed away, the pencil hardness was measured based on JIS K-5400.

As the measurement result, the pencil hardness of the permanent pattern was 5H or more. The permanent pattern was visually checked, and no film peel-off, blister and discolored portion of the hardened film were observed in the permanent pattern.

(Example 5)

The following photosensitive composition solution for solder resist and pattern forming material were prepared in the same manner as in Example 4 except that hexamethoxy methylol melamine was further added as a thermocrosslinker to the photosensitive composition for solder resist.

[Photosensitive Composition Solution for Solder Resist]

| | |
|---|---|
| • Barium sulfate dispersion | 24.75 parts by mass |
| • 35% by mass methyl ethyl ketone solution of an addition reactant between styrene/maleic acid anhydride/butyl acrylate copolymer (molar ratio: 40/32/28) and benzyl amine (1.0 equivalent amount relative to the anhydride group of the copolymer) | 13.36 parts by mass |
| • R712 (bifunctional acryl monomer, manufactured by Nippon Kayaku Co., Ltd.) | 3.06 parts by mass |
| • Dipentaerithritol hexaacrylate | 4.59 parts by mass |
| • IRGACURE 819 (manufactured by Chiba Specialty Chemicals K.K.) | 1.98 parts by mass |
| • MW30HM (hexamethoxy methylol melamine, manufactured by Sanwa Chemical Co., Ltd.) | 5.00 parts by mass |
| • 30% by mass methyl ethyl ketone solution of F780F (manufactured by Dainippon Ink and Chemicals, Inc.) | 0.066 parts by mass |
| • Hydroquinone monomethyl ether | 0.024 parts by mass |
| • Methyl ethyl ketone | 8.60 parts by mass |

The above-mentioned barium sulfate dispersion was prepared in the same manner as in Example 4.

- Measurement of Spectral Sensitivity and Minimum Exposure Dose capable of forming a pattern -

With respect to the thus obtained pattern forming material, the spectral sensitivity and the minimum exposure dose capable of forming a pattern were measured in the same manner as in Example 4. As the result, it was found that the minimum exposure dose $S_{400}$ capable of forming a pattern at a wavelength of 400 nm of the photosensitive composition was 30.2 mJ/cm$^2$; the minimum exposure dose $S_{405}$ capable of forming a pattern at a wavelength of 405 nm was 30.8 mJ/cm$^2$; and the minimum exposure dose $S_{410}$ capable of forming a pattern at a wavelength of 410 nm was 32.6 mJ/cm$^2$. In addition, it was also found that the value $S_{400}/S_{410}$ of the photosensitive composition was 0.93. Table 4 shows the measurement results.

- Variation of Formed Pattern -

The pattern forming material for solder resist that the photosensitive layer had been hardened was observed in the same manner as in Example 4. Table 4 shows the measurement result.

- Exposure, Developing, Hardening -

The pattern forming material for solder resist of Example 5 was subjected to the same exposure step, developing step, and hardening treatment step as in Example 4. The pencil hardness of the permanent pattern was 5H or more.

The permanent pattern was visually checked, and no film peel-off, blister and discolored portion of the hardened film were observed in the permanent pattern.

(Example 6)

A photosensitive composition solution for solder resist was produced in the same manner as in Example 4 except that IRGACURE 819 was changed to the following components.

| | |
|---|---|
| • N-methyl acridone | 0.22 parts by mass |
| • 2,20bis(o-chlorophenyl)-4,4',5,5'-tetraphenylbiimidazole | 4.01 parts by mass |

- Preparation of Photosensitive Laminate for Solder Resist -

The obtained photosensitive composition solution for solder resist was directly applied over a surface of a copper clad laminate (having no through hole) which was the same type as used in Example 4, and the surface of the laminate was dried to prepare a photosensitive laminate for solder resist having a thickness of 35 μm.

- Measurement of Spectral Sensitivity and Minimum Exposure Dose capable of forming a pattern -

With respect to the obtained laminate for solder resist, the spectral sensitivity and the minimum exposure dose capable of forming a pattern were measured in the same manner as in Example 4. As the result, it was found that the minimum exposure dose $S_{400}$ capable of forming a pattern at a wavelength of 400 nm of the photosensitive composition was 26.5 mJ/cm$^2$; the minimum exposure dose $S_{405}$ capable of forming a pattern at a wavelength of 405 nm was 26.5 mJ/cm$^2$; and the minimum exposure dose $S_{410}$ capable of forming a pattern at a wavelength of 410 nm was 27.2 mJ/cm$^2$. In addition, it was also found that the value $S_{400}/S_{410}$ of the photosensitive composition was 0.83. Table 4 shows the measurement results.

- Variation of Formed Pattern -

The pattern forming material for solder resist that the photosensitive layer had been hardened was observed in the same manner as in Example 4. Table 4 shows the measurement result.

- Exposure, Developing, Hardening -

The laminate for solder resist of Example 6 was subjected to the same exposure step, developing step, and hardening treatment step as in Example 4. The pencil hardness of the permanent pattern was 5H or more. The permanent pattern was visually checked, and no film peel-off, blister and discolored portion of the hardened film were observed in the permanent pattern.

(Example 7)

A photosensitive composition for solder resist and a pattern forming material were prepared in the same manner as in Example 4 except that IRGACURE 819 used in Example 5 was changed to the following components.

| | |
|---|---|
| • 10-N-butyl-2-chloroacridone | 0.06 parts by mass |
| • 2,2-bis(o-chlorophenyl)-4,4',5,5'-tetraphenylbiimidazole | 1.17 parts by mass |

- Measurement of Spectral Sensitivity and Minimum Exposure Dose capable of forming a pattern -

With respect to the obtained pattern forming material, the spectral sensitivity and the minimum exposure dose capable of forming a pattern were measured in the same manner as in Example 4. As the result, it was found that the minimum exposure dose $S_{400}$ capable of forming a pattern at a wavelength of 400 nm of the photosensitive composition was 26.5 mJ/cm$^2$; the minimum exposure dose $S_{405}$ capable of forming a pattern at a wavelength of 405 nm was 26.5 mJ/cm$^2$; and the minimum exposure dose $S_{410}$ capable of forming a pattern at a wavelength of 410 nm was 27.2 mJ/cm$^2$. In addition, it was also found that the value $S_{400}/S_{410}$ of the photosensitive composition was 0.97. Table 4 shows the measurement results.

- Variation of Formed Pattern -

The pattern forming material for solder resist that the photosensitive layer had been hardened was observed in the same manner as in Example 4. Table 4 shows the measurement result.

- Exposure, Developing, Hardening -

The pattern forming material for solder resist of Example 7 was subjected to the same exposure step, developing step, and hardening treatment step as in Example 4. The pencil hardness of the permanent pattern was 5H or more. The permanent pattern was visually checked, and no film peel-off, blister and discolored portion of the hardened film were observed in the permanent pattern.

(Comparative Example 4)

A photosensitive composition solution and a pattern forming material were prepared in the same manner as in Example 4 except that IRGACURE 819 was changed to IRGACURE 369.

- Measurement of Spectral Sensitivity and Minimum Exposure Dose capable of forming a pattern -

With respect to the obtained pattern forming material, the spectral sensitivity and the minimum exposure dose capable of forming a pattern were measured in the same manner as in Example 4. As the result, it was found that the minimum exposure dose $S_{400}$ capable of forming a pattern at a wavelength of 400 nm of the photosensitive composition was 55.6 mJ/cm$^2$; the minimum exposure dose $S_{405}$ capable of forming a pattern at a wavelength of 405 nm was 73.0 mJ/cm$^2$; and the minimum exposure dose $S_{410}$ capable of forming a pattern at a wavelength of 410 nm was 94.6 mJ/cm$^2$. In addition, it was also found that the value $S_{400}/S_{410}$ of the photosensitive composition was 0.59. Table 4 shows the measurement results.

- Variation of Formed Pattern -

The pattern forming material for solder resist that the photosensitive layer had been hardened was observed in the same manner as in Example 4. Table 4 shows the measurement result.

- Exposure, Developing, Hardening -

The pattern forming material for solder resist of Comparative Example 4 was subjected to the same exposure step, developing step, and hardening treatment step as in Example 4. The pencil hardness of the permanent pattern was 5H or more. The permanent pattern was visually checked, and no film peel-off, blister and discolored portion of the hardened film were observed in the permanent pattern.

(Comparative Example 5)

A photosensitive composition solution for solder resist and a pattern forming material were prepared in the same manner as in Example 4 except that 0.06 parts by mass of 10-N-butyl-2-chloroacridone used in Example 7 was changed to 0.07 parts by mass of 4,4'-bis(diethylamino) benzophenone.

- Measurement of Spectral Sensitivity and Minimum Exposure Dose capable of forming a pattern -

With respect to the obtained pattern forming material, the spectral sensitivity and the minimum exposure dose capable of forming a pattern were measured in the same manner as in Example 4. As the result, it was found that the minimum exposure dose $S_{400}$ capable of forming a pattern at a wavelength of 400 nm of the photosensitive composition was 150 mJ/cm$^2$; the minimum exposure dose $S_{405}$ capable of forming a pattern at a wavelength of 405 nm was 125 mJ/cm$^2$; and the minimum exposure dose $S_{410}$ capable of forming a pattern at a wavelength of 410 nm was 87.1 mJ/cm$^2$. In addition, it was also found that the value $S_{400}/S_{410}$ of the photosensitive composition was 0.58. Table 4 shows the measurement results.

- Variation of Formed Pattern -

The pattern forming material for solder resist that the photosensitive layer had been hardened was observed

in the same manner as in Example 4. Table 4 shows the measurement result.

- Exposure, Developing, Hardening -

The pattern forming material for solder resist of Comparative Example 5 was subjected to the same exposure step, developing step, and hardening treatment step as in Example 4. The pencil hardness of the permanent pattern was 5H or more. The permanent pattern was visually checked, and no film peel-off, blister and discolored portion of the hardened film were observed in the permanent pattern.

Table 4

| | Wavelength (nm) in maximum spectral sensitivity | Minimum exposure dose capable of forming a pattern | | | | | Variation ($\mu$m) |
|---|---|---|---|---|---|---|---|
| | | $S_{400}$ (mJ/cm$^2$) | $S_{405}$ (mJ/cm$^2$) | $S_{410}$ (mJ/cm$^2$) | $S_{400}/S_{410}$ $S_{400}/S_{410}$ | $S_{410}/S_{400}$ $S_{410}/S_{400}$ | |
| Ex.4 | 398 | 35.0 | 35.7 | 37.8 | 0.93 | 1.08 | 1.2 |
| Ex.5 | 398 | 30.2 | 30.8 | 32.6 | 0.93 | 1.08 | 1.2 |
| Ex.6 | 400 | 210 | 230 | 255 | 0.83 | 1.21 | 2.1 |
| Ex.7 | 405 | 26.5 | 26.5 | 27.2 | 0.97 | 1.03 | 1.2 |
| Compara. Ex. 4 | 390 | 55.6 | 73.0 | 94.6 | 0.59 | 1.70 | 4.0 |
| Compara. Ex. 5 | 365 | 87.1 | 125 | 150 | 0.58 | 0.58 | 3.6 |

The results shown in Table 4 demonstrated that the pattern forming materials for solder resist and the photosensitive laminate for solder resist of Examples 4 to 7 caused less variations in line width even when a pattern was formed by exposing the respective photosensitive layers with a laser having a wavelength of 405 nm that the wavelength range of 400 nm to 410 nm was assumed because the values of $S_{400}/S_{410}$ of the pattern forming materials were respectively within the range of 0.6 to 1.6. In contrast, the results shown in Table 4 showed that the pattern forming materials for solder resist of Comparative Examples 4 and 5 had large variations in line width because the values of $S_{400}/S_{410}$ of these pattern forming materials were respectively outside the range of 0.6 to 1.6.

Industrial Applicability

Since the pattern forming material and the photosensitive laminate according to the present invention has a substantially constant photosensitivity distribution relative to an exposure light having a wavelength in the region of short-wavelengths (blue-violet light), in particular, having a wavelength of 400 nm to 410 nm and allows for easy handling under bright room environments without being affected by variations in exposure wavelength during exposure with a laser beam, the pattern forming material and the photosensitive laminate can be preferably used in forming various patterns, in forming permanent patterns such as interconnection pattern, in producing members having a liquid crystal structure such as color filters, column members, rib members, spacers, and partition members, and in forming patterns such as hologram, micromachine, and proof. The pattern forming material and the photosensitive laminate can be particularly preferably used in forming highly fine and precise interconnection patterns.

Since the pattern forming apparatus of the present invention is provided with the pattern forming material or the photosensitive laminate of the present invention, and in the pattern forming process of the present invention, the pattern forming material or the photosensitive laminate of the present invention is used, the pattern forming apparatus and the pattern forming process can be preferably used in forming various patterns, in forming permanent patterns such as interconnection pattern, in producing members having a liquid crystal structure such as color filters, column members, rib members, spacers, and partition members, and in forming patterns such as hologram, micromachine, and proof. The pattern forming apparatus and the pattern forming process can be particularly preferably used in forming highly fine and precise interconnection patterns.

**Claims**

1. A photosensitive composition comprising:

   a binder,
   a polymerizable compound, and
   a photopolymerization initiator,
   wherein the photosensitive composition has a maximum spectral sensitivity in the wavelength range of 380 nm to 420 nm; the minimum exposure dose $S_{400}$ capable of forming a pattern at a wavelength of 400 nm of the photosensitive composition is 300 mJ/cm$^2$ or less; the minimum exposure dose $S_{410}$ capable of forming a pattern at a wavelength of 410 nm of the photosensitive composition is 300 mJ/cm$^2$ or less; and $S_{400}$ and $S_{410}$ satisfy the relation $0.6 < S_{400}/S_{410} < 1.6$.

2. The photosensitive composition according to claim 1, wherein the minimum exposure dose $S_{405}$ capable of forming a pattern at a wavelength of 405nm of the photosensitive composition is 300 mJ/cm$^2$ or less.

3. The photosensitive composition according to any one of claims 1 to 2, further comprising a photosensitizer, wherein the minimum exposure dose $S_{400}$ capable of forming a pattern at a wavelength of 400 nm of the photosensitive composition is 200 mJ/cm$^2$ or less; the minimum exposure dose $S_{410}$ capable of forming a pattern at a wavelength of 410 nm of the photosensitive composition is 200 mJ/cm$^2$ or less; and $S_{400}$ and $S_{410}$ satisfy the relation $0.6 < S_{400}/S_{410} < 1.4$.

4. The photosensitive composition according to any one of claims 1 to 3, wherein the photosensitizer has a maximum absorption wavelength of 380 nm to 420 nm.

5. The photosensitive composition according to any one of claims 1 to 4, wherein the photosensitizer is a fused-ring compound.

6. The photosensitive composition according to any one of claims 1 to 5, wherein the photosensitizer is at least one selected from the group consisting of acridones, acridines, and coumarins.

7. The photosensitive composition according to any one of claims 1 to 6, wherein the content of the photosensitizer is 0.1% by mass to 10% by mass relative to the total amount of the photosensitive composition.

8. The photosensitive composition according to any one of claims 1 to 7, wherein the polymerizable compound comprises a monomer having at least any one of a urethane group and an aryl group.

9. The photosensitive composition according to any one of claims 1 to 8, wherein the photopolymerization initiator comprises at least one selected from the group consisting of halogenated hydrocarbon derivatives, hexaaryl-biimidazoles, oxime derivatives, organic peroxides, thio compounds, ketone compounds, aromatic onium salts, and metallocenes.

10. The photosensitive composition according to any one of claims 1 to 2, further comprising a thermocrosslinker.

11. The photosensitive composition according to any one of claims 1 to 2 and 10, wherein the binder is an epoxy acrylate compound.

12. The photosensitive composition according to any one of claims 1 to 2 and 10 to 11, wherein the binder is a copolymer which can be obtained by reacting a primary amine compound in an equivalent mass of 0.1 to 1.2 to an anhydride group of a maleic anhydride copolymer.

13. The photosensitive composition according to any one of claims 1 to 2 and 10 to 12, wherein the binder is a copolymer which can be obtained by reacting a primary amine compound in an equivalent mass of 0.1 to 1.0 to an anhydride group of a copolymer which comprises (a) an maleic acid anhydride, (b) an aromatic vinyl monomer, and (c) a vinyl monomer of which the glass transition temperature (Tg) of homopolymer of the vinyl monomer is less than 80°C.

14. The photosensitive composition according to any one of claims 1 to 2 and 10 to 13, wherein the thermocrosslinker is at least one selected from the compounds which can be obtained by reacting a blocking agent to any one of an

epoxy resin compound, an oxetane compound, a polyisocyanate compound, and a polyisocyanate compound, and melamine derivatives.

**15.** The photosensitive composition according to any one of claim 1 to 2 and 10 to 14, wherein the melamine derivative is an alkylated methylol melamine.

**16.** The photosensitive composition according to any one of claim 1 to 2 and 10 to 15, wherein any one of the photopolymerization initiator and the photopolymerization initiating system comprises at least one selected from the group consisting of halogenated hydrocarbon derivatives, phosphine oxides, hexaaryl-biimidazoles, oxime derivatives, organic peroxides, thio compounds, ketone compounds, acylphosphine oxide compounds, aromatic onium salts, and ketoxime ethers.

**17.** A pattern forming material comprising:

a photosensitive layer on a support,
wherein the photosensitive layer comprises a photosensitive composition according to any one of claims 1 to 16 on a support.

**18.** A photosensitive laminate comprising:

a photosensitive layer on a substrate,
wherein the photosensitive layer comprises a photosensitive composition according to any one of claims 1 to 16 on a substrate.

**19.** A pattern forming apparatus provided with at least any one of a pattern forming material according to claim 17 and a photosensitive laminate according to claim 18, comprising:

a light irradiation unit configured to irradiate a light beam, and
a light modulating unit configured to modulate the light beam applied from the light irradiation unit to expose any one of the photosensitive layer in the pattern forming material and the photosensitive layer in the photosensitive laminate.

**20.** A pattern forming process comprising:

exposing any one of a photosensitive layer in a pattern forming material according to claim 17 and a photosensitive layer in a photosensitive laminate according to claim 18 with a light beam.

**21.** The pattern forming process according to claim 20, wherein any one of the photosensitive layer in the pattern forming material and the photosensitive layer in the photosensitive laminate is exposed with the use of a light beam which is modulated according to control signals generated based on the information of a pattern to be formed.

**22.** The pattern forming process according to any one of claims 20 to 21, wherein after the light beam is modulated by the light modulating unit, any one of the photosensitive layer in the pattern forming material and the photosensitive layer in the photosensitive laminate is exposed through a microlens array having an array of microlenses each having a non-spherical surface capable of compensating the aberration due to distortion at irradiating surface of the imaging portion in the light modulating unit.

**23.** The pattern forming process according to claim 22, wherein the non-spherical surface is a toric surface.

**24.** The pattern forming process according to any one of claims 20 to 23, wherein any one of the photosensitive layer in the pattern forming material and the photosensitive layer in the photosensitive laminate is exposed with the use of a laser beam having a wavelength of 395 nm to 415 nm.

**25.** The pattern forming process according to any one of claims 20 to 24, wherein after exposing any one of the photosensitive layer in the pattern forming material and the photosensitive layer in the photosensitive laminate with a light beam or a laser beam, the photosensitive layer is subjected to a developing treatment.

**26.** The pattern forming process according to any one of claims 20 to 25, wherein after developing any one of the

photosensitive layer in the pattern forming material and the photosensitive layer in the photosensitive laminate, an etching pattern is formed on the photosensitive layer.

**27.** A permanent pattern forming process comprising:

subjecting any one of a photosensitive layer in a pattern forming material according to claim 17 and a photosensitive layer in a photosensitive laminate according to claim 18 to any one of the exposing treatment and the developing treatment according to any one of claims 20 to 26, and
hardening the photosensitive layer.

**28.** The permanent pattern forming process according to claim 27, wherein at least any one of a protective layer, an interlayer insulating film, and a solder resist pattern is formed.

FIG. 1

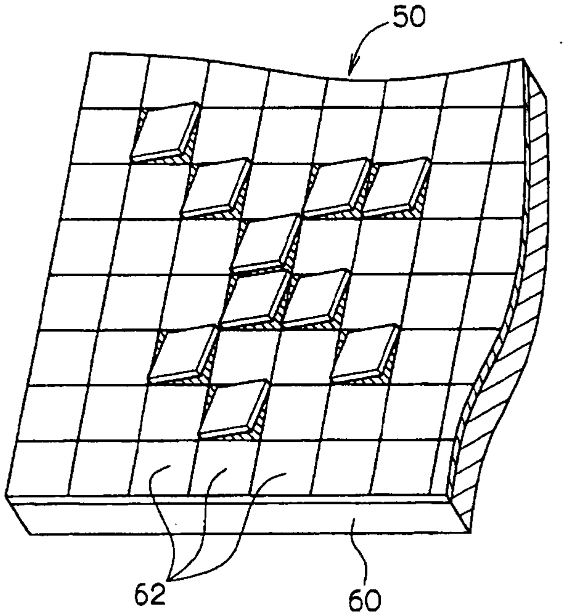


FIG. 2A

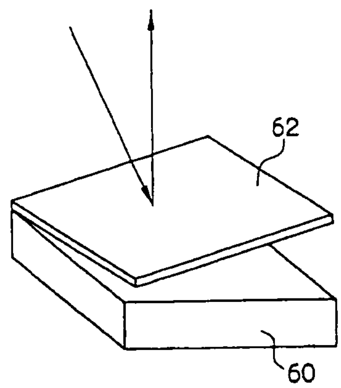


FIG. 2B

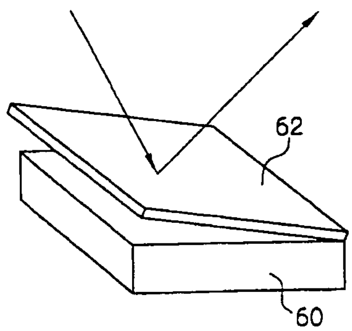

FIG.3A

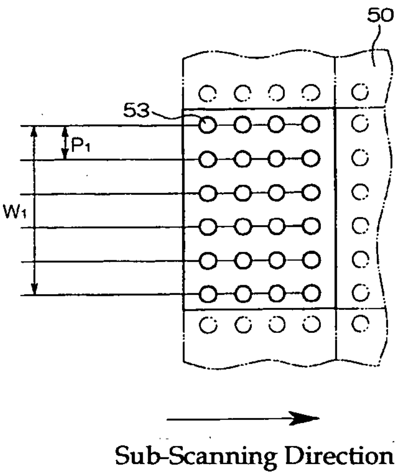


FIG.3B

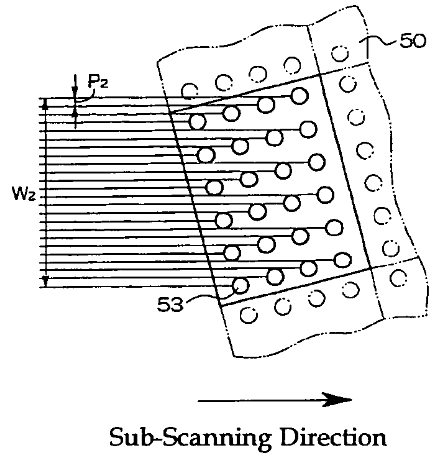


FIG.4A

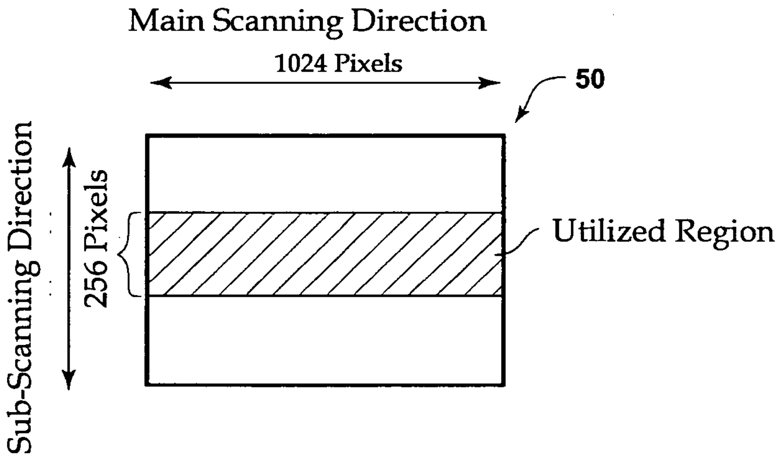


FIG.4B

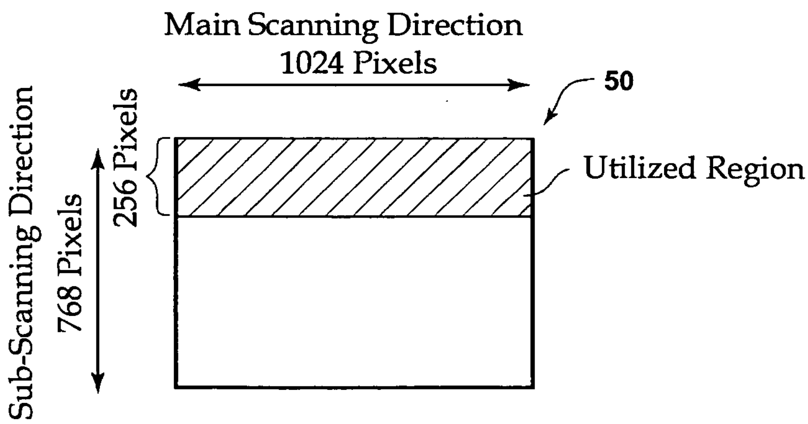

FIG. 5

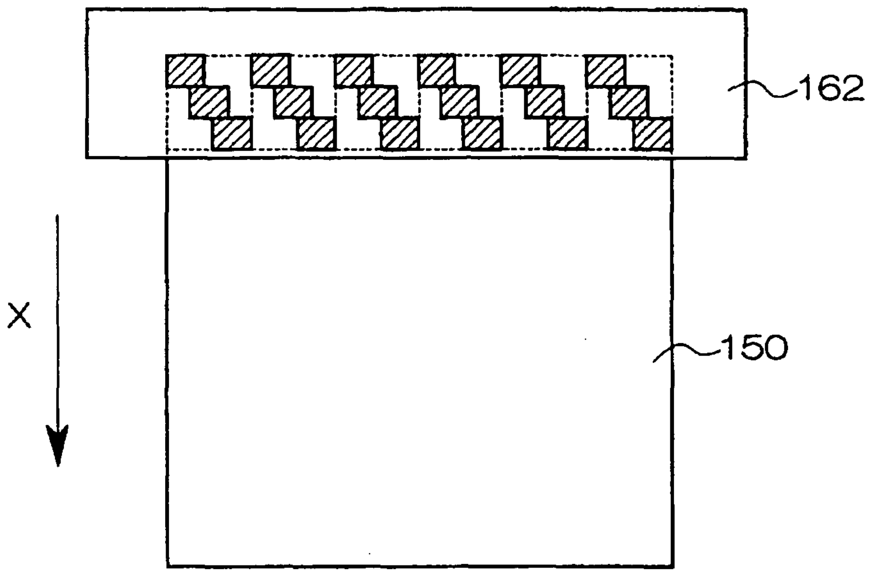

FIG.6A

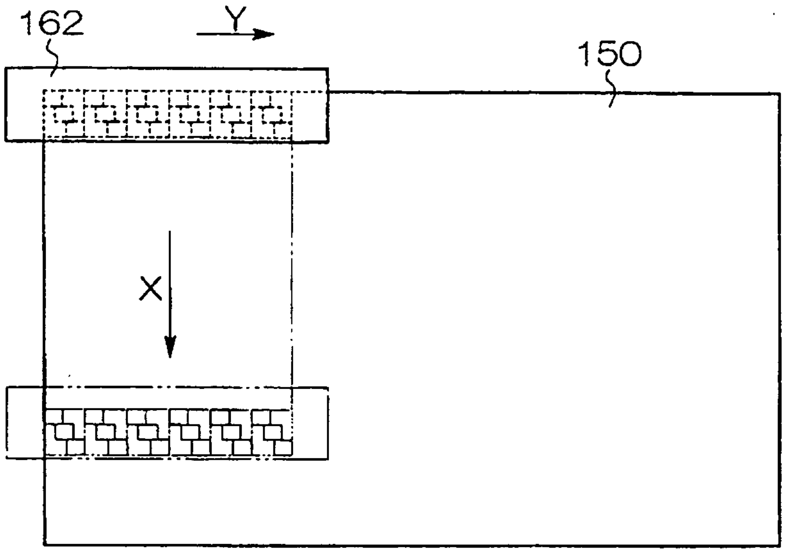


FIG.6B

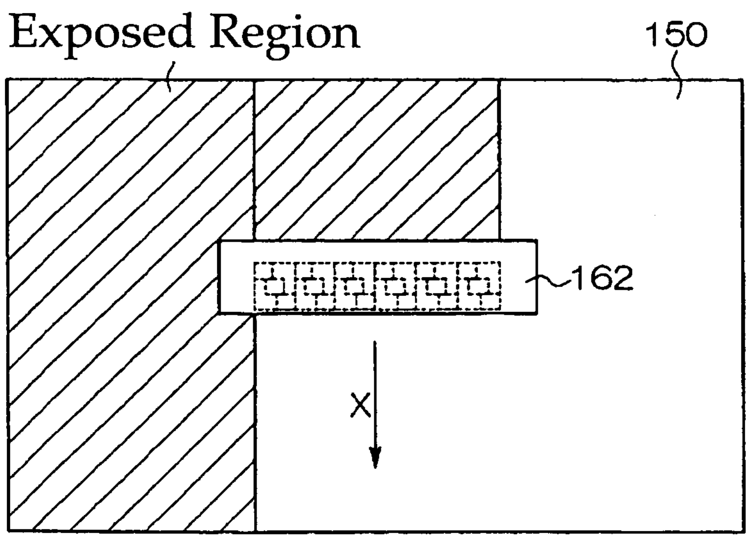

FIG. 7

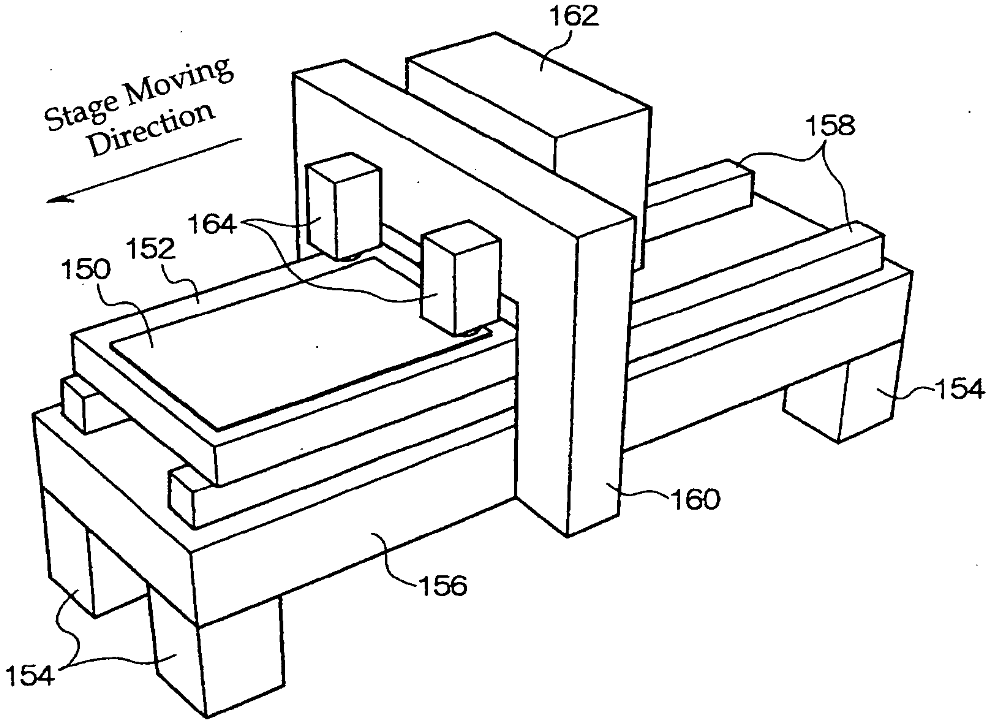
162
Stage Moving Direction
158
164
152
150
154
160
156
154

FIG. 8

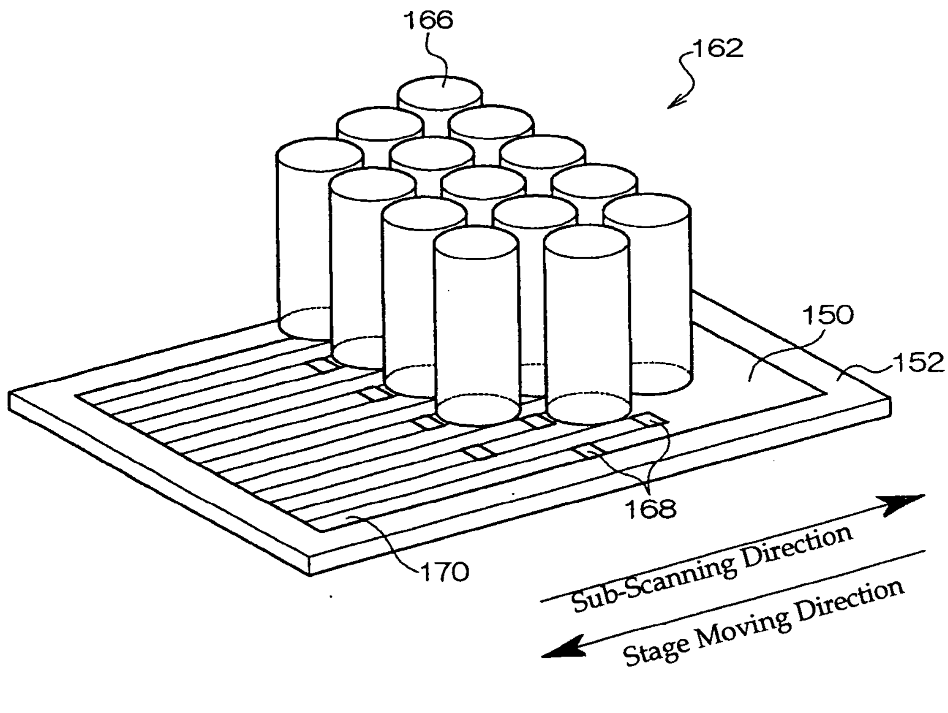
166
162
150
152
168
170
Sub-Scanning Direction
Stage Moving Direction

FIG.9A

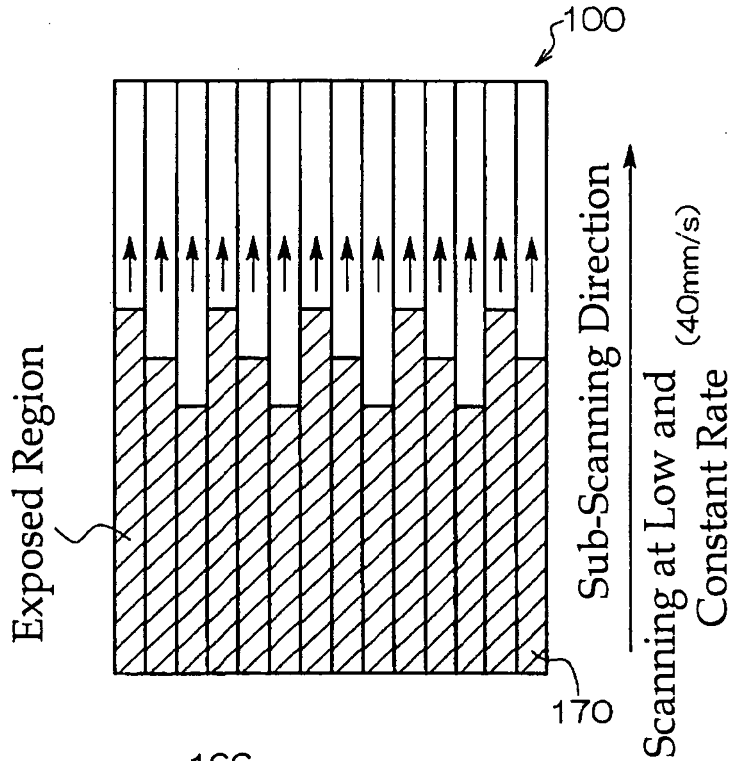
100
Exposed Region
Sub-Scanning Direction
Scanning at Low and Constant Rate
(40mm/s)
170

FIG.9B

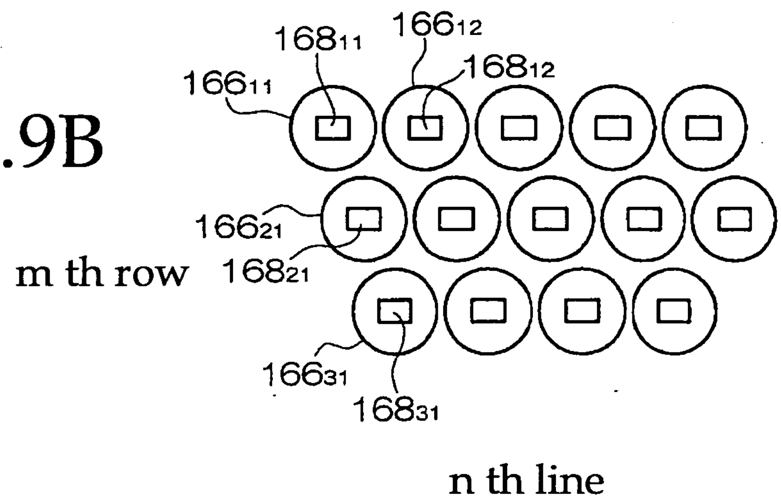
168₁₁
166₁₂
168₁₂
166₁₁
166₂₁
m th row
168₂₁
166₃₁
168₃₁
n th line

FIG. 10

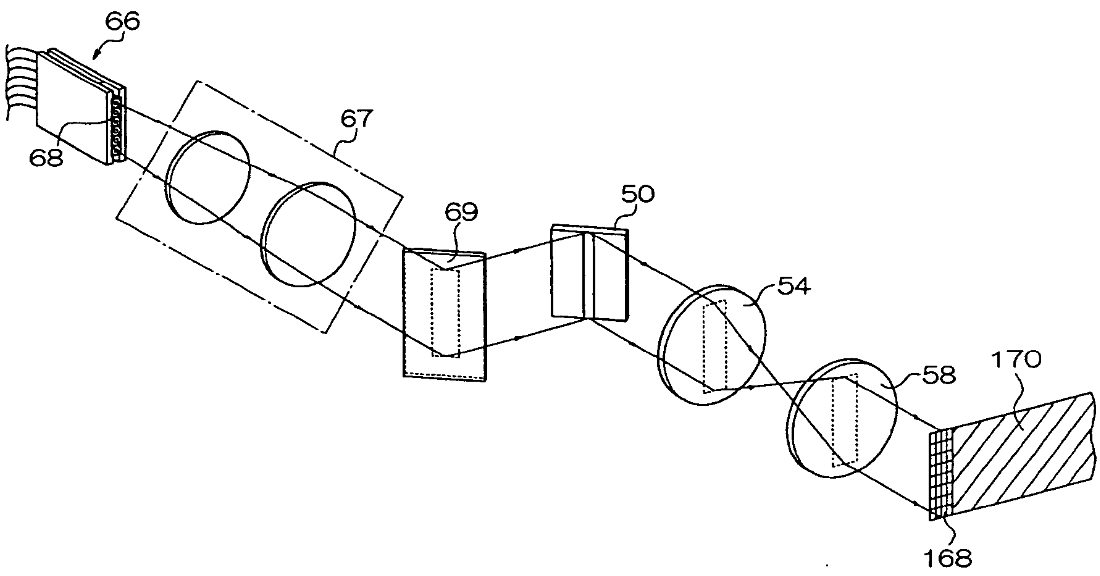

FIG. 11

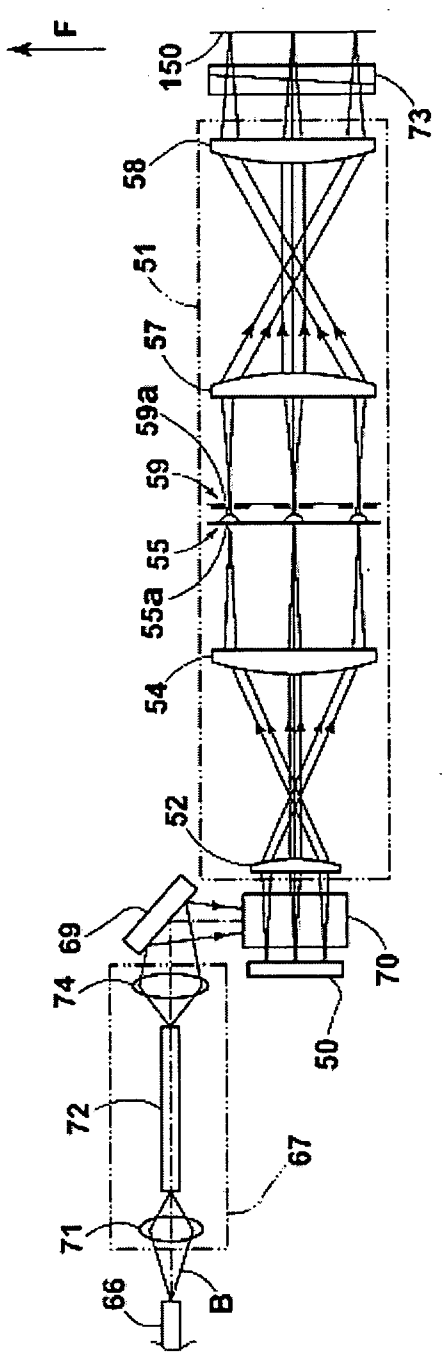

FIG. 12

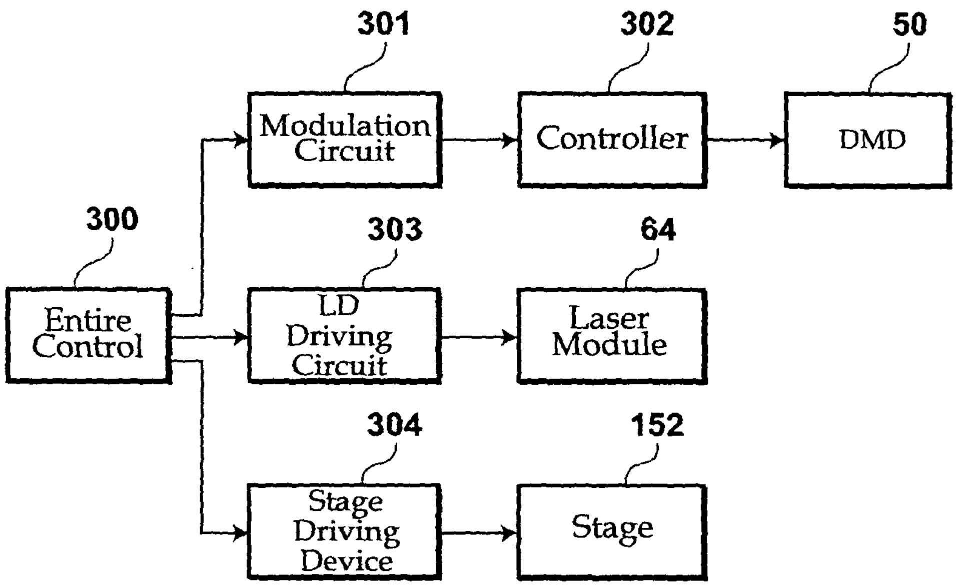


FIG.13A

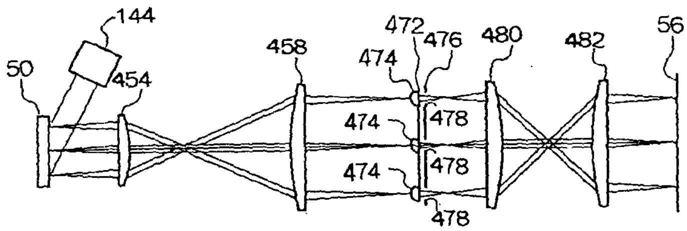


FIG.13B

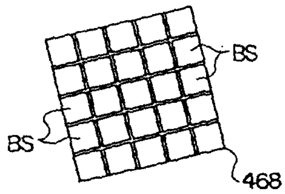


FIG.13C

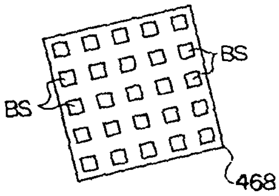

FIG. 14

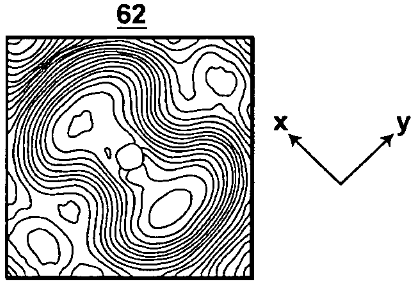


FIG. 15A

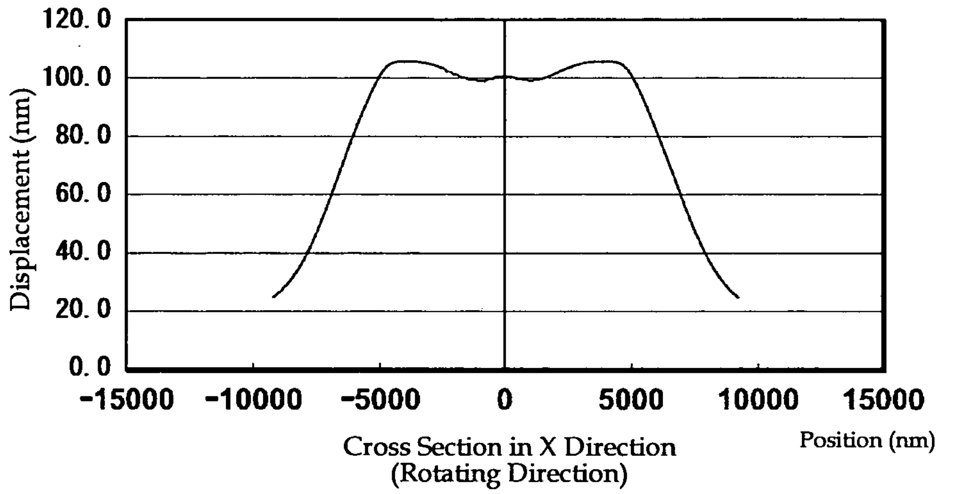


FIG. 15B

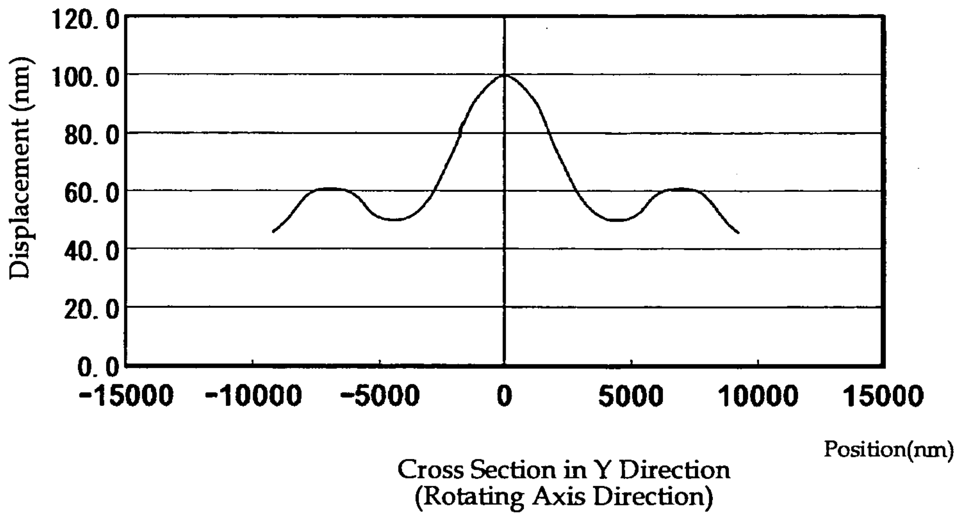

FIG. 16A

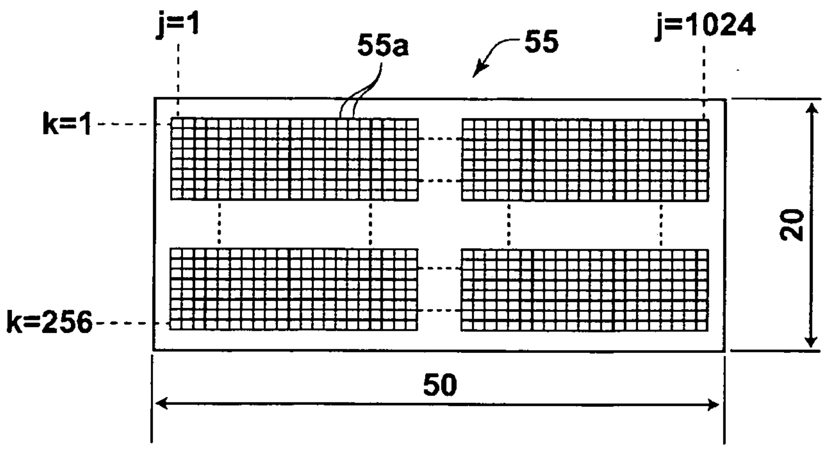


FIG. 16B

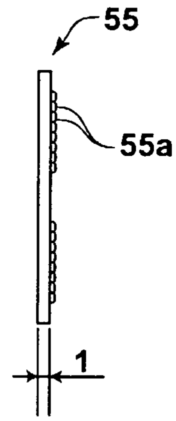


FIG. 17A

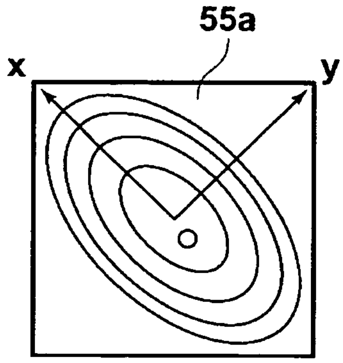


FIG. 17B

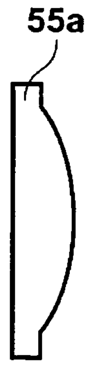

FIG. 18A

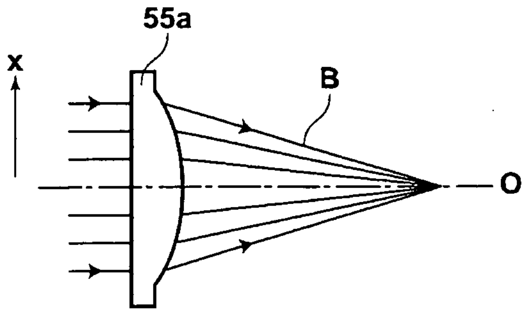


FIG. 18B

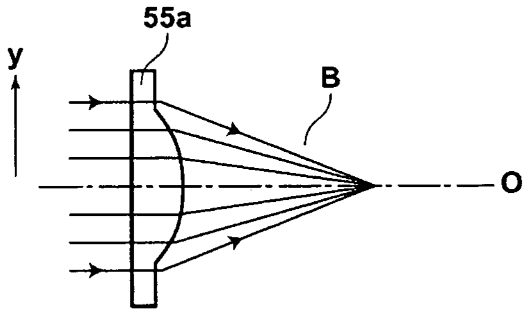


FIG. 19A

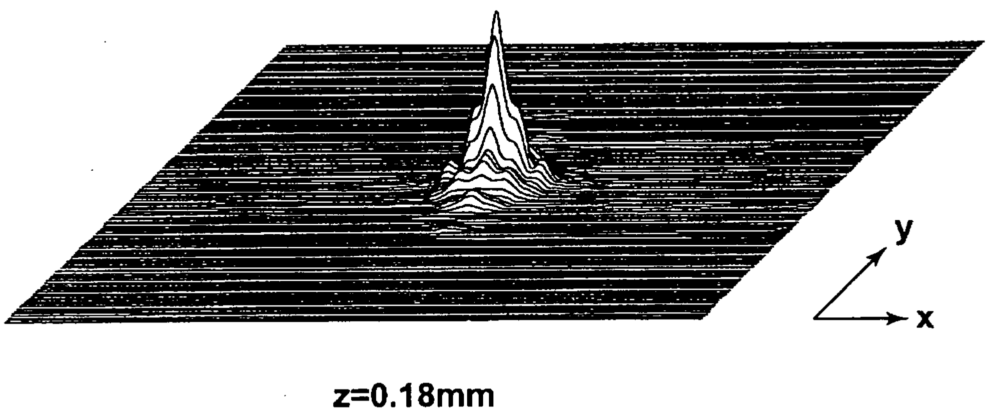

FIG. 19B

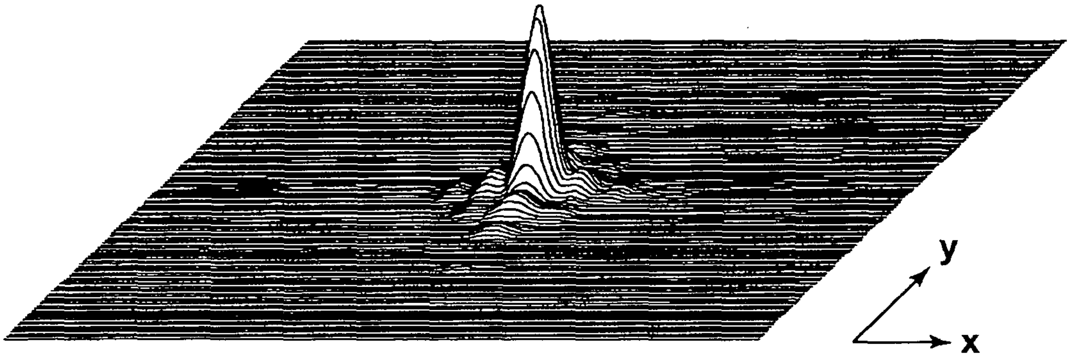


z=0.2mm

FIG. 19C

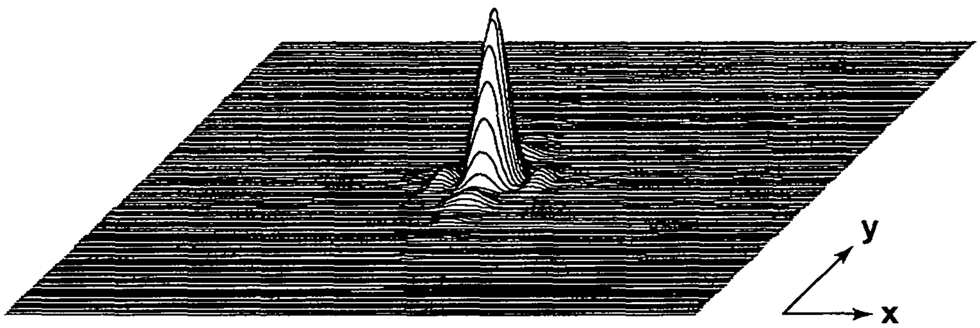


z=0.22mm

FIG. 19D

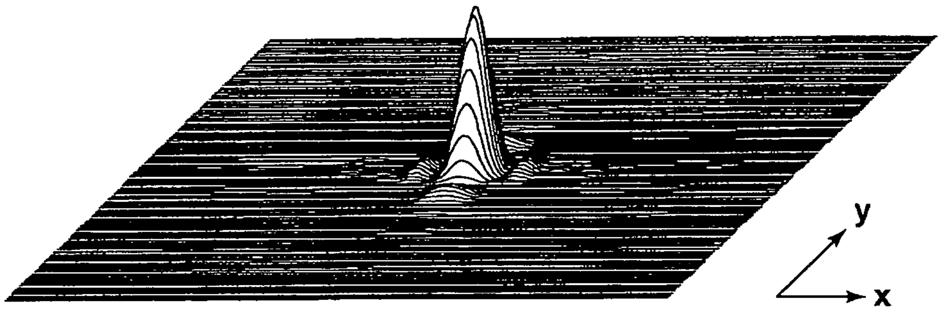


z=0.24mm

FIG. 20A

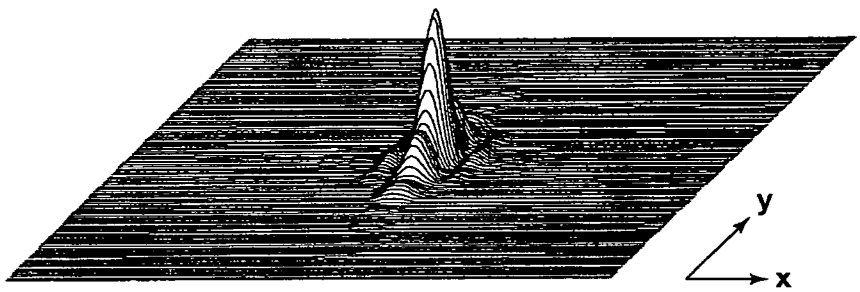


z=0.18mm

FIG. 20B

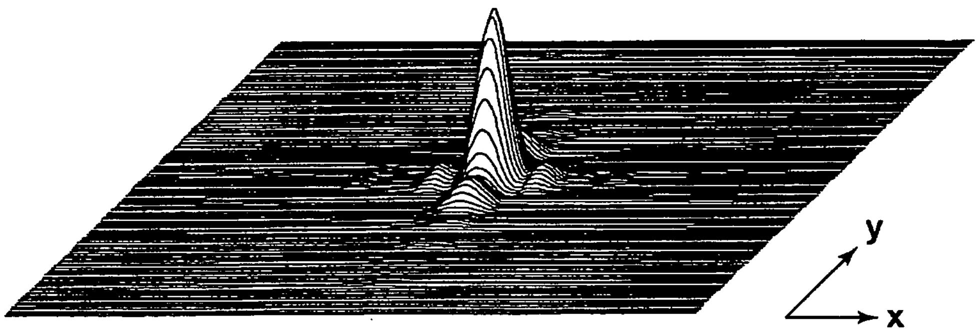


z=0.2mm

FIG. 20C

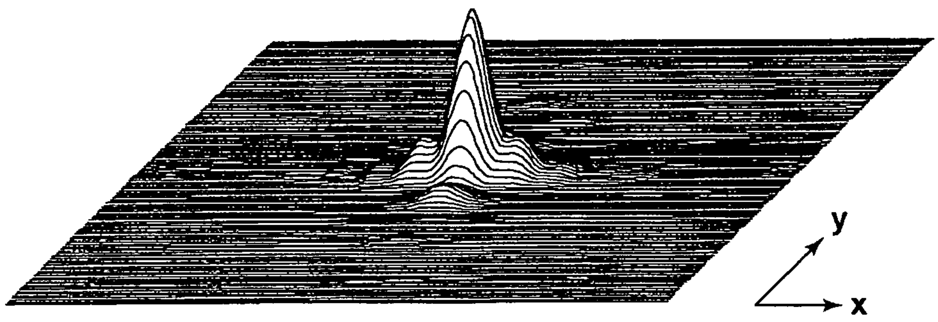


z=0.22mm

FIG. 20D

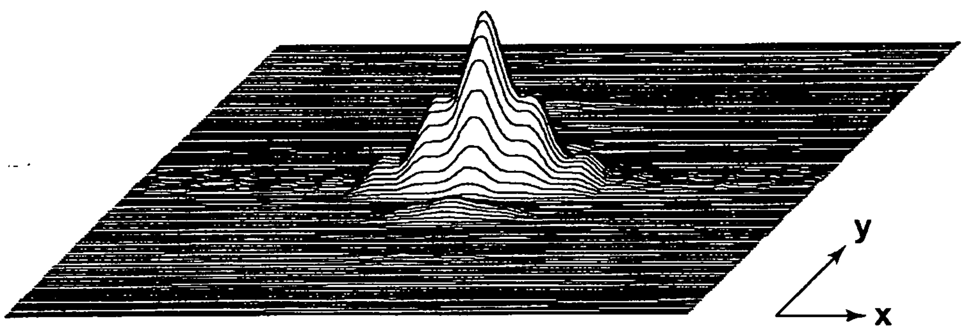


z=0.24mm

FIG. 21

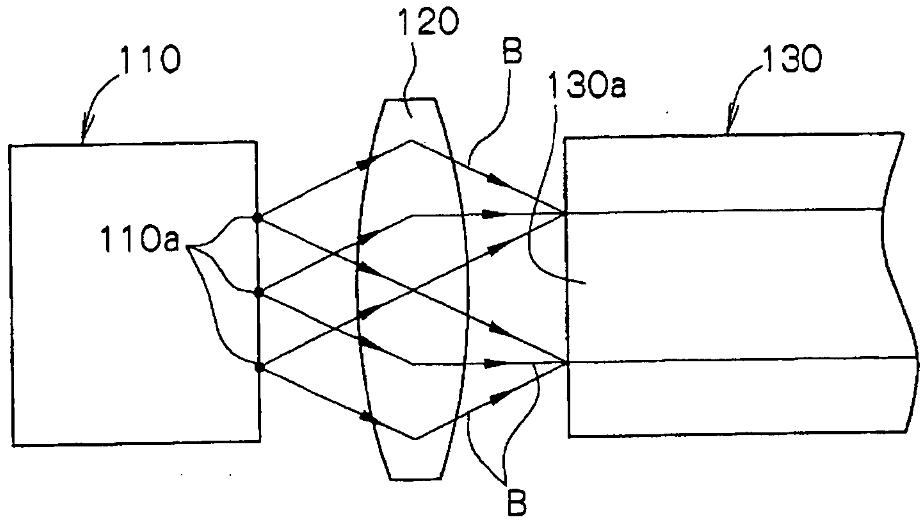


FIG. 22A

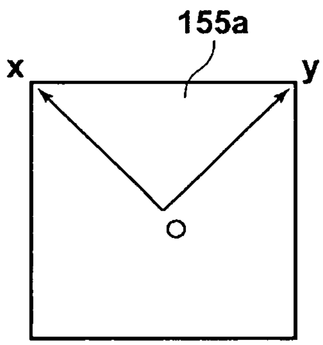


FIG. 22B

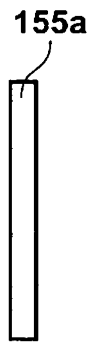

FIG. 23A

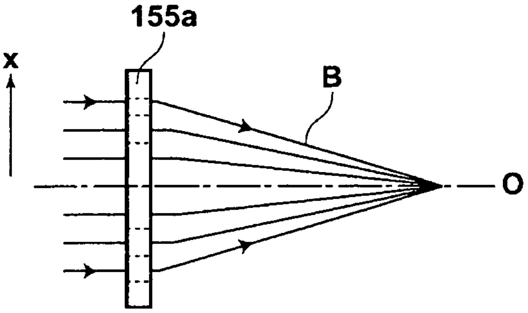


FIG. 23B

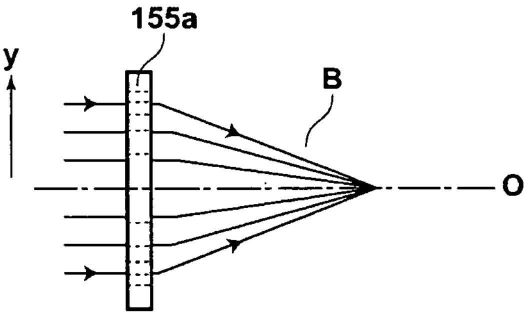

FIG. 24A

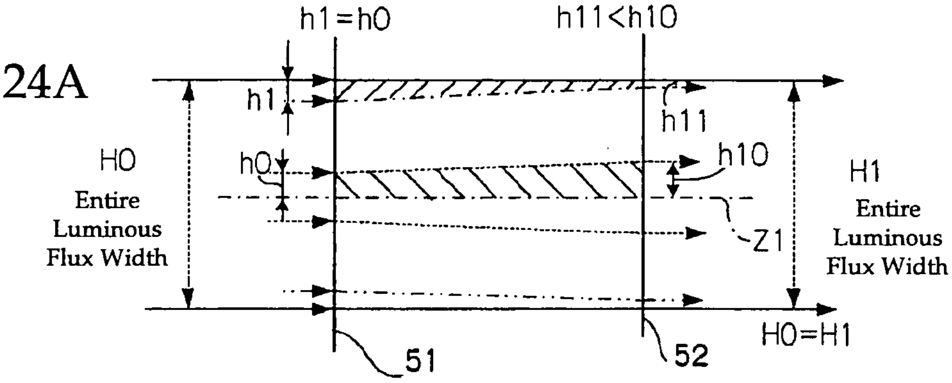


FIG. 24B

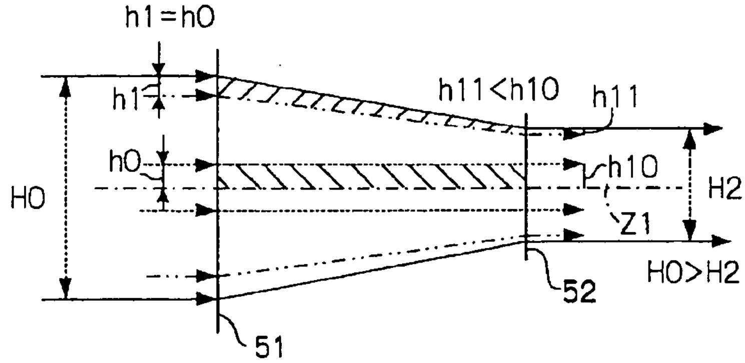


FIG. 24C

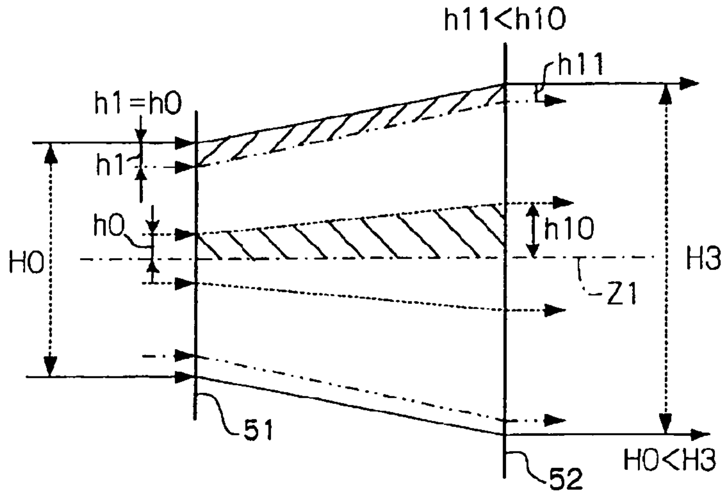

FIG. 25

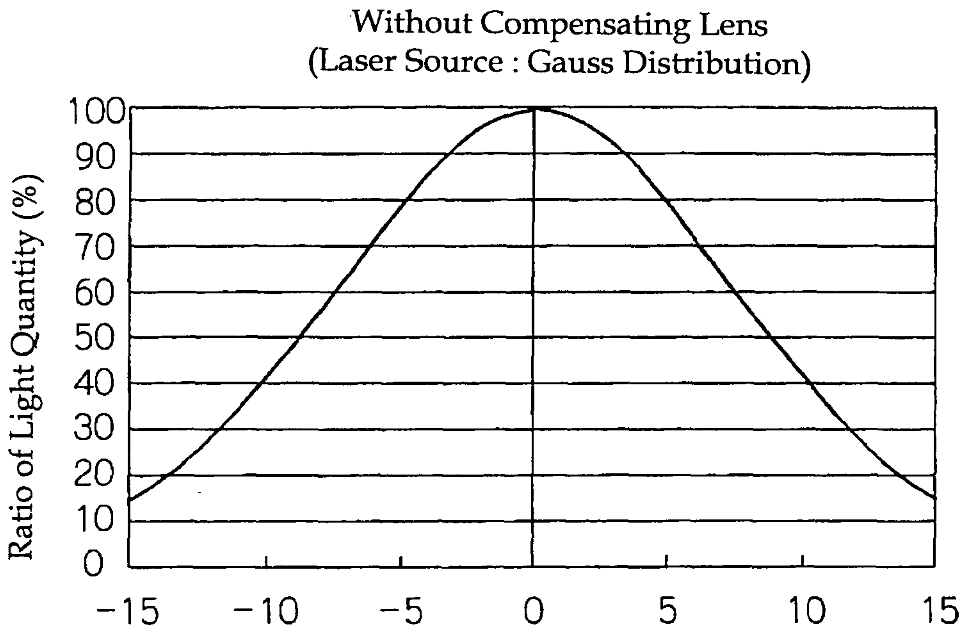
Without Compensating Lens
(Laser Source : Gauss Distribution)
Ratio of Light Quantity (%)
100
90
80
70
60
50
40
30
20
10
0
-15
-10
-5
0
5
10
15

FIG. 26

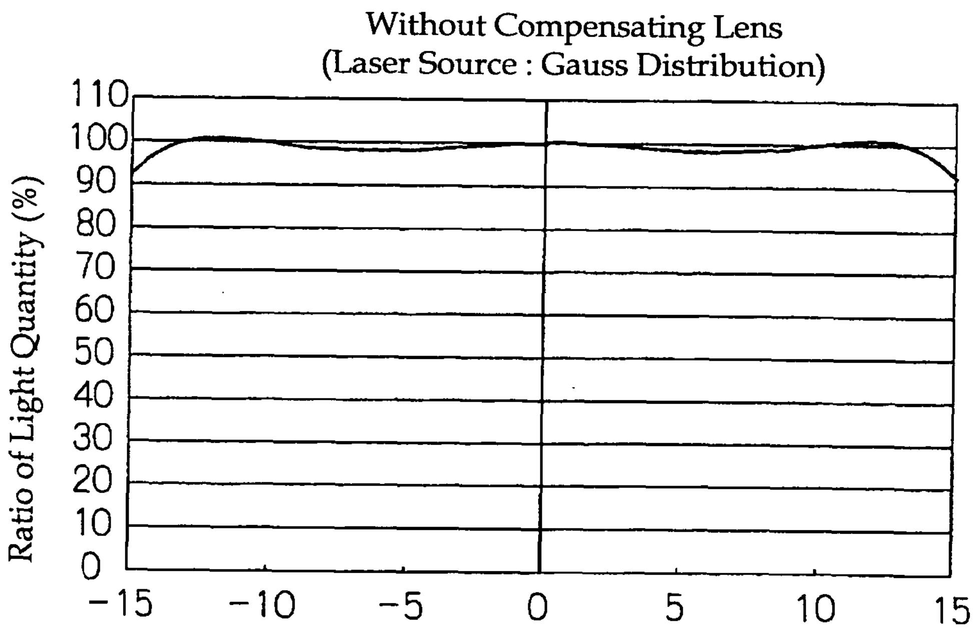
Without Compensating Lens
(Laser Source : Gauss Distribution)
Ratio of Light Quantity (%)
110
100
90
80
70
60
50
40
30
20
10
0
-15
-10
-5
0
5
10
15

FIG. 27A

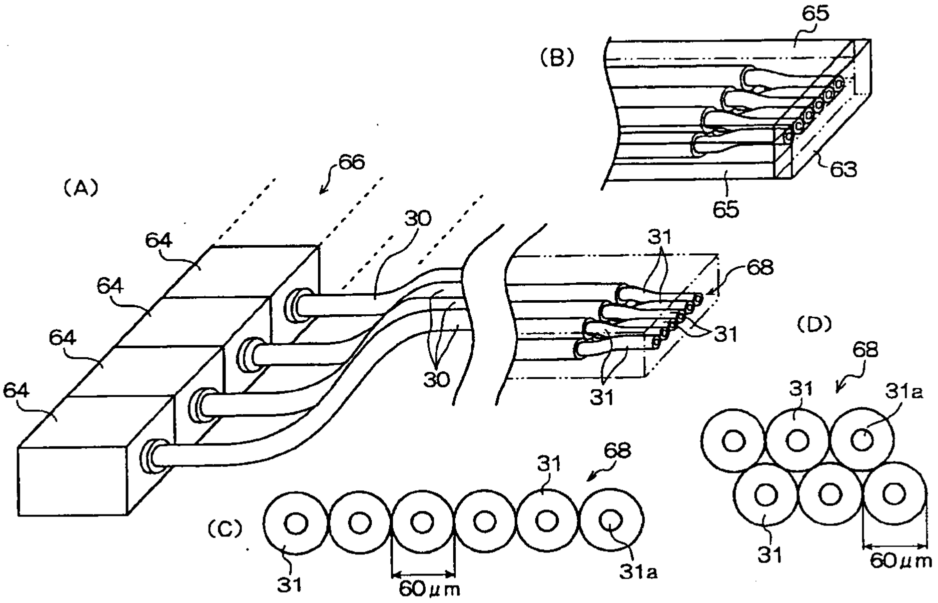


FIG. 27B

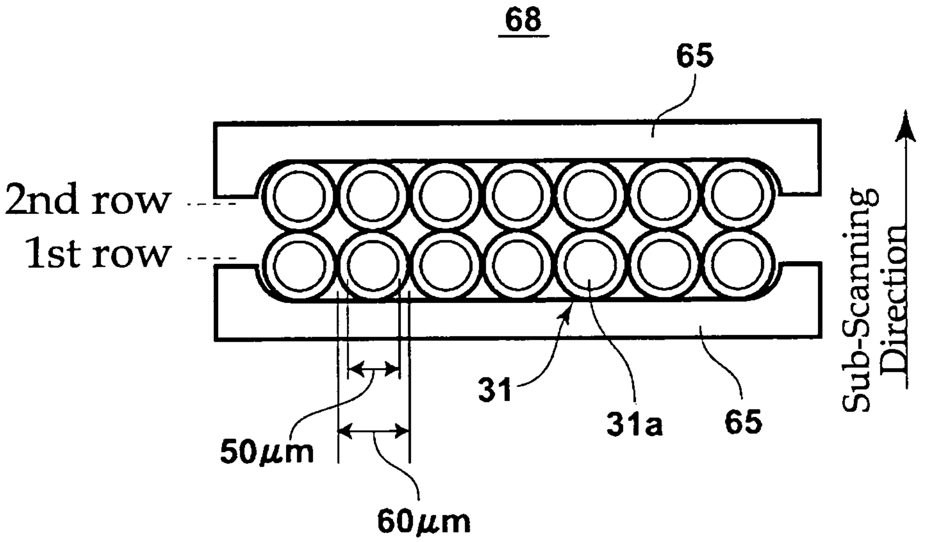

FIG. 28

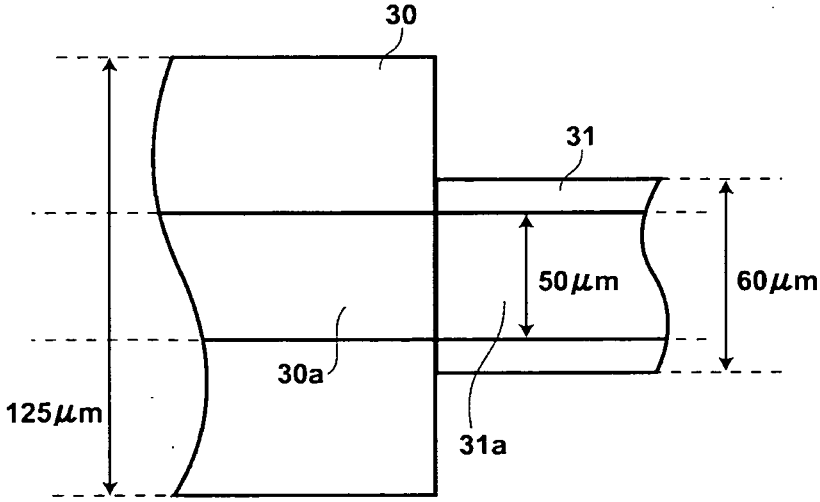
30
31
50μm
60μm
30a
125μm
31a

FIG. 29

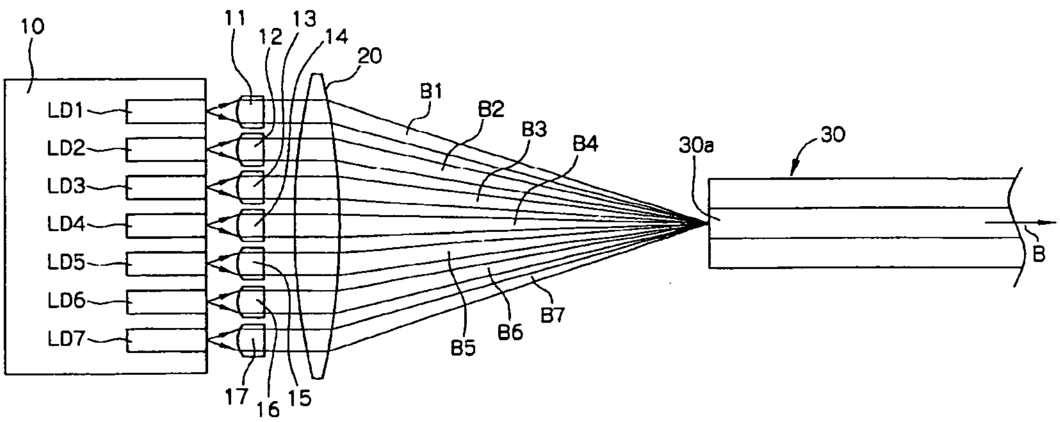
10
11
12
13
14
20
LD1
LD2
LD3
LD4
LD5
LD6
LD7
B1
B2
B3
B4
B5
B6
B7
30a
30
B
17
16
15

# FIG. 30

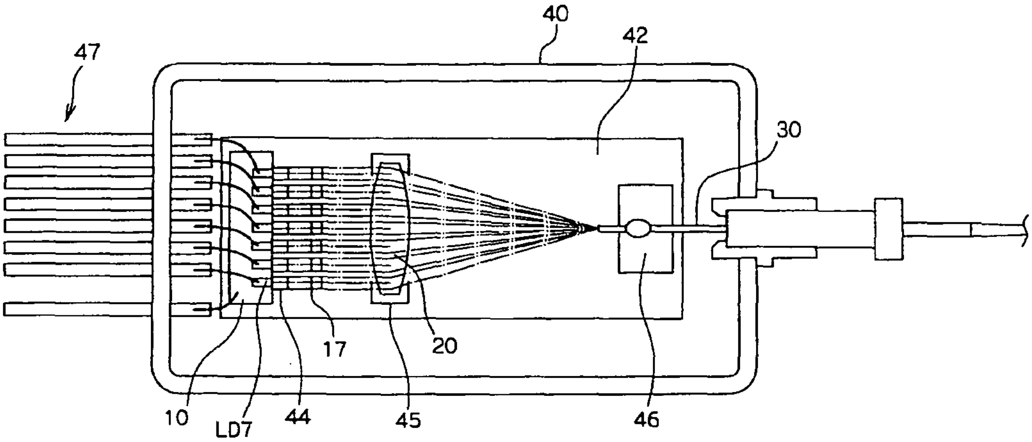
40
42
47
30
10
LD7
44
17
45
20
46

# FIG. 31

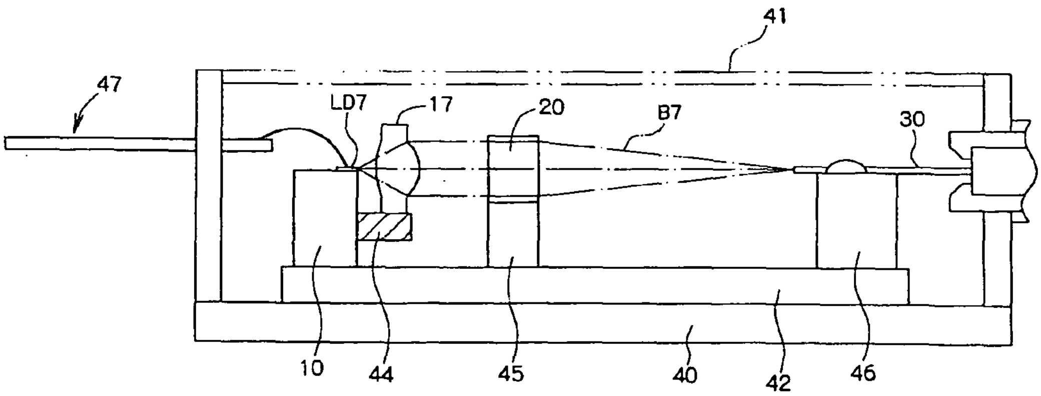
41
47
LD7
17
20
B7
30
10
44
45
40
42
46

FIG. 32

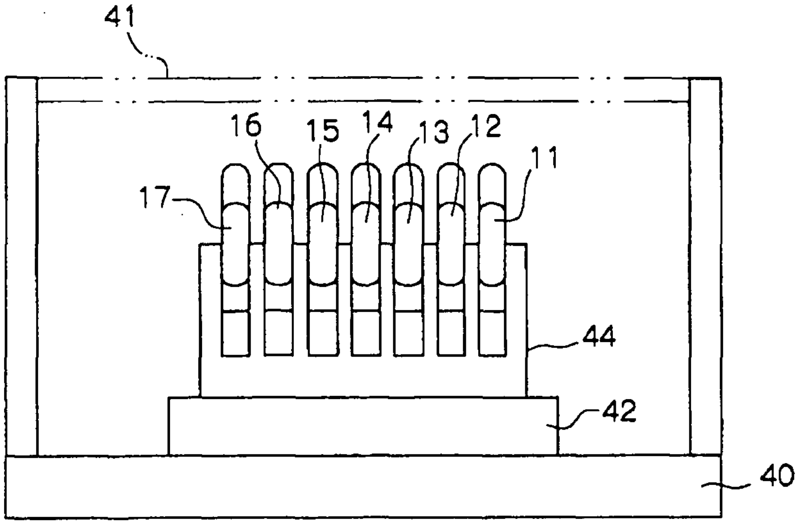


FIG. 33

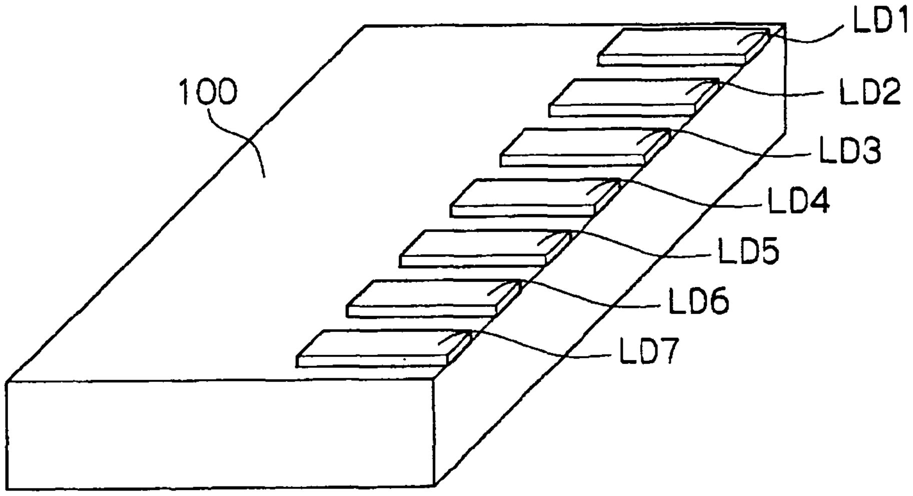

FIG. 34A

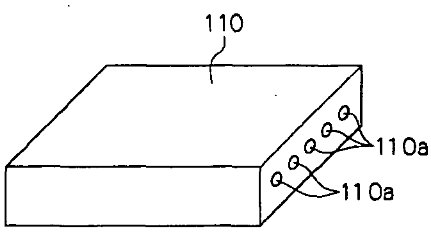


FIG. 34B

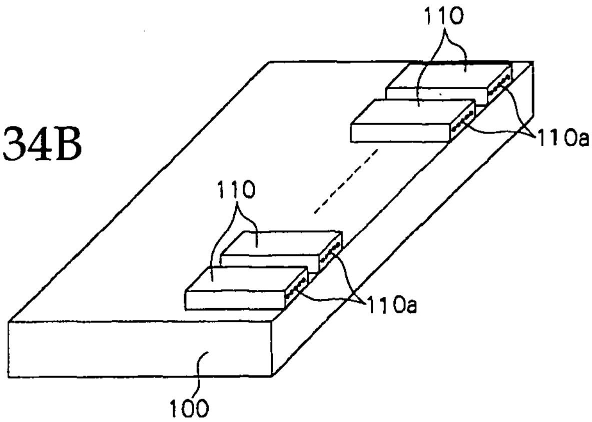


FIG. 35

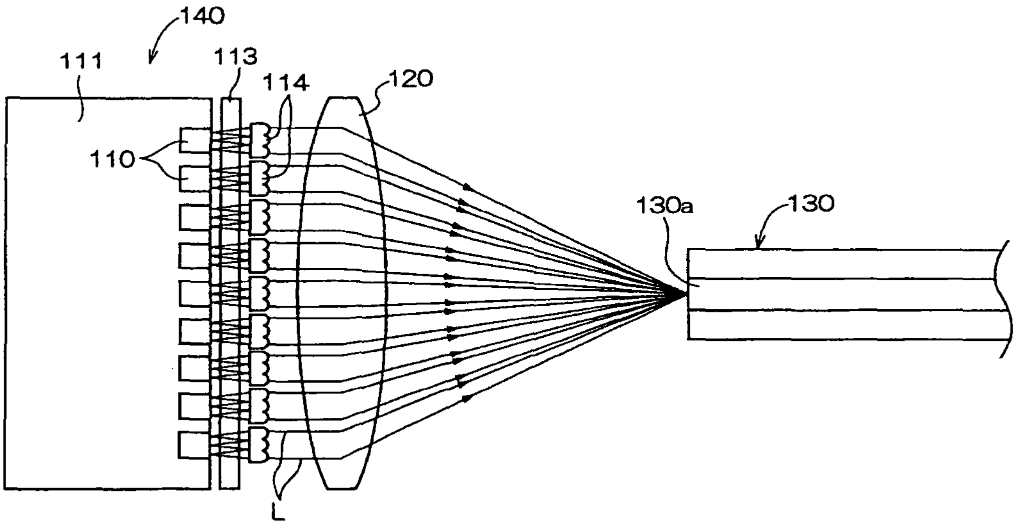

FIG. 36A

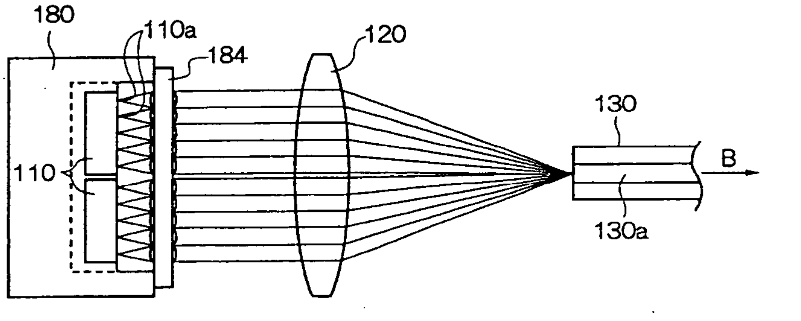


FIG. 36B

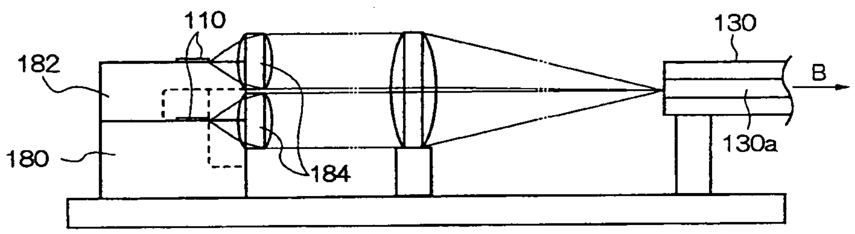


FIG. 37A

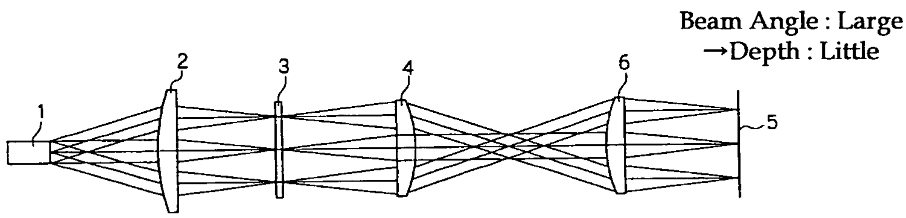


FIG. 37B

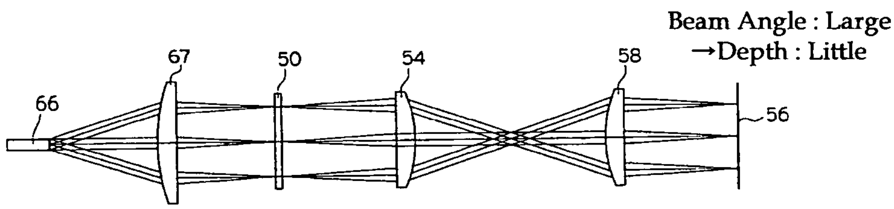

**INTERNATIONAL SEARCH REPORT**

International application No.
PCT/JP2005/013048

A. CLASSIFICATION OF SUBJECT MATTER
Int.Cl[7] G03F7/028, 7/004, 7/027, 7/029, 7/031, H01L21/027

According to International Patent Classification (IPC) or to both national classification and IPC

B. FIELDS SEARCHED

Minimum documentation searched (classification system followed by classification symbols)
Int.Cl[7] G03F7/004-7/42, H01L21/027

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2005 |
| Kokai Jitsuyo Shinan Koho | 1971-2005 | Toroku Jitsuyo Shinan Koho | 1994-2005 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | WO 2004/015497 A1 (Mitsubishi Chemical Corp.), 19 February, 2004 (19.02.04), Full text & JP 2004-212958 A & JP 2004-252421 A & JP 2004-264834 A & JP 2004-272212 A | 1-9,11, 16-18,20, 24-26 |
| X | JP 2004-184871 A (Mitsubishi Chemical Corp.), 02 July, 2004 (02.07.04), Full text (Family: none) | 1-9,11, 16-18,20, 24-26 |
| X | JP 2004-163492 A (Mitsubishi Chemical Corp.), 10 June, 2004 (10.06.04), Full text (Family: none) | 1-9,11, 16-18,20, 24-26 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 12 October, 2005 (12.10.05) | 25 October, 2005 (25.10.05) |

| Name and mailing address of the ISA/ | Authorized officer |
|---|---|
| Japanese Patent Office | |
| Facsimile No. | Telephone No. |

Form PCT/ISA/210 (second sheet) (April 2005)

**INTERNATIONAL SEARCH REPORT**

International application No.
PCT/JP2005/013048

C (Continuation). DOCUMENTS CONSIDERED TO BE RELEVANT

| Category* | Citation of document, with indication, where appropriate, of the relevant passages | Relevant to claim No. |
|---|---|---|
| X | JP 2004-170609 A (Mitsubishi Chemical Corp.), 17 June, 2004 (17.06.04), Full text (Family: none) | 1-9,11, 16-18,20, 24-26 |
| P,X<br>P,Y | JP 2004-326084 A (Hitachi Chemical Co., Ltd.), 18 November, 2004 (18.11.04), Full text (Family: none) | 1-9,16-18, 20,24-26<br>11 |
| P,X<br>P,Y | JP 2004-348114 A (Hitachi Chemical Co., Ltd.), 19 December, 2004 (19.12.04), Full text (Family: none) | 1-9,16-18, 20,24-26<br>11 |
| P,X | JP 2005-115151 A (Mitsubishi Chemical Corp.), 28 April, 2005 (28.04.05), Full text (Family: none) | 1-9,11, 16-18,20, 24-26 |
| P,X | JP 2005-122048 A (Mitsubishi Chemical Corp.), 12 May, 2005 (12.05.05), Full text (Family: none) | 1-9,11, 16-18,20, 24-26 |
| P,X | JP 2005-128508 A (Mitsubishi Chemical Corp.), 19 May, 2005 (19.05.05), Full text (Family: none) | 1-9,11, 16-18,20, 24-26 |

Form PCT/ISA/210 (continuation of second sheet) (April 2005)

**INTERNATIONAL SEARCH REPORT**

International application No.
PCT/JP2005/013048

**Box No. II Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

**Box No. III Observations where unity of invention is lacking (Continuation of item 3 of first sheet)**

This International Searching Authority found multiple inventions in this international application, as follows:

See extra sheet.

1. ☐ As all required additional search fees were timely paid by the applicant, this international search report covers all searchable claims.
2. ☐ As all searchable claims could be searched without effort justifying an additional fee, this Authority did not invite payment of any additional fee.
3. ☐ As only some of the required additional search fees were timely paid by the applicant, this international search report covers only those claims for which fees were paid, specifically claims Nos.:

4. ☒ No required additional search fees were timely paid by the applicant. Consequently, this international search report is restricted to the invention first mentioned in the claims; it is covered by claims Nos.: 1-9, 11, 16-18, 20 and 24-26.

**Remark on Protest**

☐ The additional search fees were accompanied by the applicant's protest and, where applicable, the payment of a protest fee..

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (April 2005)

INTERNATIONAL SEARCH REPORT

International application No.
PCT/JP2005/013048

Continuation of Box No.III of continuation of first sheet(2)

The matter common to the inventions of claims 1-28 is a photosensitive composition defined in claim 1.

However, the "photosensitive layer having a maximum of spectral sensitivity in a 380 to 420 nm wavelength region, wherein the minimum exposure intensity capable of pattern formation at 400 nm, $S_{400}$, is $\leq$ 300 mJ/cm$^2$ and the minimum exposure intensity capable of pattern formation at 410 nm, $S_{410}$, is $\leq$ 300 mJ/cm$^2$, these $S_{400}$ and $S_{410}$ satisfying the relationship $0.6<S_{400}/S_{410}<1.6$" recited in claim 1 only suggests that the minimum exposure intensity is influenced by definition and measuring means, and restricts, for exposure with laser of 405 nm wavelength, the upper limits of sensitivity at 400 nm and 410 nm and the ratio thereof to a certain level of range sandwiching 1. Thus, these only recite conditions for satisfying the task of exhibiting stable sensitivity at 400 to 410 nm, and the constitution thereof is unclear.

Moreover, the reference WO 2004/015497 A1 (Mitsubishi Chemical Corp.), 19 February, 2004 (19.02.04) describes inclusion of the minimum exposure sensitivity at 410 nm in the above indicated range. Although the condition at 400 nm is not described, as it is intended to carry out laser exposure at 405 nm, it appears that the above requirement is inherently satisfied.

Thus, the above requirement is either inherently described or a matter of design.

Consequently, the photosensitive composition defined in claim 1 as the common matter is not a special technical feature within the meaning of PCT Rule 13.2, second sentence.

Thus, there is no matter common to all the inventions of claims 1-18 and 20-28.

Accordingly, claims 1-28 involve the following 14 invention groups:

photosensitive composition claimed in claims 1 and 2,

photosensitive composition containing a sensitizer, claimed in claims 3 and 4,

photosensitive composition containing a sensitizer specified, claimed in claim 6,

photosensitive composition containing a monomer specified, claimed in claim 8,

photosensitive composition containing a photopolymerization initiator specified, claimed in claims 9 and 16,

photosensitive composition containing a thermal crosslinking agent specified and a method of pattern formation through exposure means specified, claimed in claims 10, 14 and 15 [additional invention 1],

photosensitive composition containing a binder consisting of an epoxy acrylate compound, claimed in claim 11,

photosensitive composition containing a binder including maleic anhydride, claimed in claims 12 and 13 [additional invention 2],

pattern forming material claimed in claim 17, and a method of pattern formation including ordinary exposure (exposure to exposure light ensuring sensitivity) (development) thereof claimed in claims 20, 24, 25 and 26,

photosensitive laminate claimed in claim 18,

pattern forming apparatus, claimed in claim 19 [additional invention 3],

(continued to further extra sheet)

**INTERNATIONAL SEARCH REPORT**

International application No.
PCT/JP2005/013048

method of pattern formation characterized by exposure means, claimed in claim 21 [additional invention 4],
method of pattern formation characterized by lenses of exposure means, claimed in claims 22 and 23 [additional invention 4], and
method of forming a permanent pattern, claimed in claims 27 and 28 [additional invention 5].

Although it does not appear that the above invention groups are linked with each other so as to form a single general inventive concept, those other than [additional invention 2] to [additional invention 5] are matters of degree described in the reference (1) and thus regarded as causing any extra search burden and not needing to invite additional fees. With respect to the additional invention 4, although two inventions are covered, they are regarded as being searchable without extra burden.

Therefore, with respect to claims 1-9, 11, 16-18, 20 and 24-26, partial international search has been carried out.

Form PCT/ISA/210 (extra sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2001194782 A
- JP 2873889 B
- JP 48041708 B
- JP 51037193 A
- JP 5050737 B
- JP 7007208 B
- JP 2001154346 A
- JP 2001356476 A
- WO 0198832 A
- JP 48064183 A
- JP 49043191 B
- JP 52030490 B
- WO 0122165 A
- JP 6236031 A
- JP 2744643 B
- JP 2548016 B
- WO 0052529 A
- GB 1388492 A
- JP 53133428 A
- DE 3337024
- JP 62058241 A
- JP 5281728 A
- JP 5034920 A
- US 4212976 A
- US 4239850 A
- JP 57001819 B
- JP 57006096 B
- US 3615455 A
- JP 5019475 A
- JP 7271028 A
- JP 2002363206 A
- JP 2002363207 A
- JP 2002363208 A
- JP 2002363209 A
- US 2367660 A
- US 2448828 A
- US 2722512 A
- US 3046127 A
- US 2951758 A
- JP 2002229194 A
- WO 0171428 A
- US 3549367 A
- JP 51048516 B
- JP 2002263209 A
- JP 2001305734 A
- US 3042515 A
- US 3042517 A
- JP 5011439 A
- JP 5341532 A
- JP 6043638 A
- JP 51131706 A
- JP 52094388 A
- JP 6462375 A
- JP 2097513 A
- JP 3289656 A
- JP 61243869 A
- JP 2002296776 A
- JP 6295060 A
- JP 50059315 A
- JP 5070528 A
- JP 11288087 A
- JP 2097502 A
- JP 11282155 A
- JP 50006034 B
- JP 51037193 B
- JP 5009407 A
- JP 4208940 A
- JP 5080503 A
- JP 5173320 A
- JP 5072724 A


### Non-patent literature cited in the description


- *Journal of Adhesion Society of Japan,* 1984, vol. 20 (7), 300-308
- *Bulletin of the Chemical Society of Japan,* 1960, vol. 33, 565
- *Journal of Organic Chemistry,* 1971, vol. 36 (16), 2262
- **WAKABAYASI.** *Bulletin of the Chemical Society of Japan,* 1969, vol. 42, 2924
- **F.C. SCHAEFER.** *Journal of Organic Chemistry,* 1964, vol. 29, 1527
- **J. CURSER.** Light Sensitive Systems
- **NIKKAN KOGYO SHIMBUNSHA.** Photopolymer Technology. 1988, 262